# EUROPEAN PATENT APPLICATION

(11) **EP 2 465 888 A1**
(43) Date of publication of application: **20.06.2012**
(21) Application number: 10808241.3
(22) Date of filing: 11.08.2010
(51) Int. Cl.: C08G 61/00, C08L 65/00, H01B 1/20, H01L 21/338, H01L 29/786, H01L 29/812, H01L 51/05, H01L 51/30, H01L 51/50

(54) **POLYMER COMPOUND AND METHOD FOR PRODUCING THE SAME**

(30) Priority: 13.08.2009 JP 2009187861
(71) Applicant: Sumitomo Chemical Company, Limited, Tokyo 104-8260 (JP)
(72) Inventor: FUKUSHIMA Daisuke, Ushiku-shi Ibaraki 300-1206 (JP); ISHII Yusuke, Toda-shi Saitama 335-0023 (JP); SETO Mari, Toyonaka-shi Osaka 5600021 (JP); OHUCHI Kazuei, Tsukuba-shi Ibaraki 305-0005 (JP)
(74) Representative: Duckworth, Timothy John
(86) International application number: PCT/JP2010/063653
(87) International publication number: WO 2011/019058

(57) **Abstract**

A polymer compound comprising a first constitutional unit represented by formula (1), a second constitutional unit represented by formula (2), and at least one constitutional unit selected from the group consisting of a third constitutional unit represented by formula (3) and a fourth constitutional unit represented by formula (4).

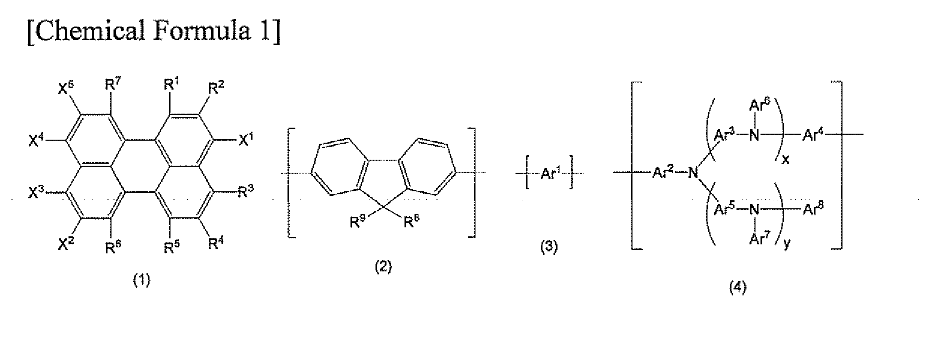

## Description

### Technical Field

The present invention relates to a polymer compound, to a method for producing it, to a polymer composition, solution, organic film, organic semiconductor device, organic light emitting device, surface light source and display device comprising it, and to a starting compound for the same.

### Background Art

Polymer compounds consisting of perylenediyl and fluorenediyl groups have been studied as light emitting materials for use in light emitting devices (for example, Non-patent document 1).

### Citation List

### Non Patent Literature

[Non-patent document 1] Synthetic Metals 102 (1999) 1087-1088

### Summary of Invention

### Technical Problem

However, light emitting devices employing conventional polymer compounds have not always been sufficient in terms of luminous efficiency.

It is therefore an object of the present invention to provide a polymer compound that is useful for production of a light emitting device with excellent luminous efficiency. It is another object of the invention to provide a polymer composition, solution, organic film, organic semiconductor device, organic light emitting device, surface light source and display device comprising the polymer compound. It is yet another object of the invention to provide a method for producing the polymer compound, and a compound that is useful for production of the polymer compound.

### Solution to Problem

Specifically, the invention provides a polymer compound comprising a first constitutional unit represented by the following formula (1), a second constitutional unit represented by the following formula (2), and at least one constitutional unit selected from the group consisting of a third constitutional unit represented by the following formula (3) and a fourth constitutional unit represented by the following formula (4), 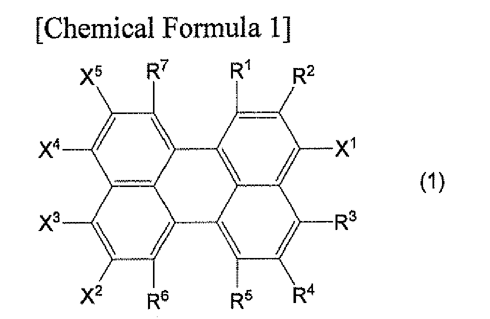 in formula (1), R¹, R², R³, R⁴, R⁵, R⁶ and R⁷ each independently represent a hydrogen atom, an alkyl group, an aryl group, a monovalent aromatic heterocyclic group or a group represented by -O-R^{A}, X¹ represents a binding site to a constitutional unit composing the polymer compound, and one of X², X³, X⁴ and X⁵ represents a binding site to a constitutional unit composing the polymer compound while the other three each independently represent a hydrogen atom, an alkyl group, an aryl group, a monovalent aromatic heterocyclic group or a group represented by -O-R^{A}; R^{A} is an alkyl group, an aryl group or a monovalent aromatic heterocyclic group, R¹, R², R³, R⁴, R⁵, R⁶, R⁷, X², X³, X⁴, X⁵ and R^{A} each may have a substituent, and when there are multiple R^{A}, the R^{A} groups may be the same or different; 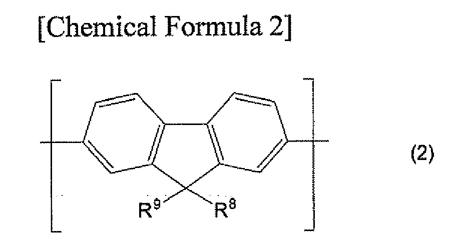 in formula (2), R⁸ and R⁹ each independently represent an alkyl group, an aryl group or a monovalent aromatic heterocyclic group, and these groups each may have a substituent; 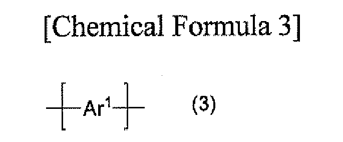 in formula (3), Ar¹ represents an arylene group, a divalent aromatic heterocyclic group, or a divalent group in which are linked two or more identical or different groups selected from the group consisting of arylene groups and divalent aromatic heterocyclic groups; Ar¹ may have one or more substituents selected from the group consisting of alkyl groups, aryl groups, monovalent aromatic heterocyclic groups, groups represented by -O-R^{A}, groups represented by -S-R^{A}, groups represented by -C(=O)-R^{A}_{,} groups represented by -C(=O)-O-R^{A}, groups represented by -N(R^{A})₂, a cyano group and a fluorine atom; R^{A} is as defined above, and when there are multiple R^{A} groups, the R^{A} groups may be the same or different; 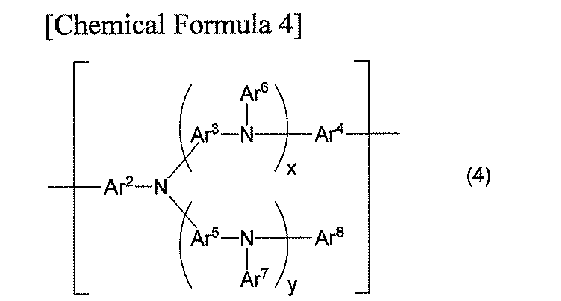 in formula (4), x and y each independently represent 0 or 1, Ar², Ar³, Ar⁴ and Ar⁵ each independently represent an arylene group, a divalent aromatic heterocyclic group, or a divalent group in which are linked two or more identical or different groups selected from the group consisting of arylene groups and divalent aromatic heterocyclic groups, Ar^{d}, Ar⁷ and Ar⁸ each independently represent an aryl group or a monovalent aromatic heterocyclic group and Ar², Ar³, Ar⁴, Ar⁵, Ar⁶, Ar⁷ and Ar⁸ each may have one or more substituents selected from the group consisting of alkyl groups, aryl groups, monovalent aromatic heterocyclic groups, groups represented by -O-R^{A}, groups represented by -S-R^{A}, groups represented by -C(=O)-R^{A}, groups represented by -C(=O)-O-R^{A}, groups represented by -N(R^{A})₂, a cyano group and a fluorine atom; of the groups represented by Ar², Ar³, Ar⁴, Ar⁵, Ar⁶, Ar⁷ and Ar⁸, groups bonded to the same nitrogen atom may be bonded by a single bond, or by a group represented by -O-, -S-, -C(=O)-, -C(=O)-O-, -N(R^{A})-, -C(=O)-N(R^{A}) or -C(R^{A})(R^{A})-; R^{A} is as defined above, and when there are multiple R^{A} groups, the R^{A} groups may be the same or different.

Due to this construction, a light emitting device obtained by using the polymer compound of the invention exhibits excellent luminous efficiency.

In the polymer compound of the invention, in the first constitutional unit, X³ or X⁴ is preferably the binding site to the constitutional unit composing the polymer compound. Such a polymer compound has excellent stability, and also results in more excellent luminous efficiency for the obtained light emitting device.

The polymer compound of the invention preferably comprises a constitutional sequence in which the first constitutional unit and the second constitutional unit are linked. Such a polymer compound will yield a light emitting device with more excellent luminous efficiency.

The content of the first constitutional unit in the polymer compound of the invention is preferably from 0.1 mol% to 20 mol%, based on the total content of the first constitutional unit, the second constitutional unit, the third constitutional unit and the fourth constitutional unit. If the content ratio of the first constitutional unit is within this range, the aforementioned effect will be exhibited even more prominently.

The total content of the first constitutional unit, the second constitutional unit, the third constitutional unit and the fourth constitutional unit in the polymer compound of the invention is preferably 80 mass% or greater, based on the total polymer compound. The effect of the polymer compound will thereby be exhibited even more prominently.

A polystyrene-equivalent number-average molecular weight of the polymer compound of the invention is preferably from 1 × 10³ to 1 × 10⁸. Such a polymer compound has excellent film formability, and the luminous efficiency of a light emitting device employing the polymer compound will be even more excellent.

The invention further provides a method for producing the aforementioned polymer compound, comprising polymerizing at least three kinds of different monomers including a first monomer represented by the following formula (M-1) and a second monomer represented by the following formula (M-2), 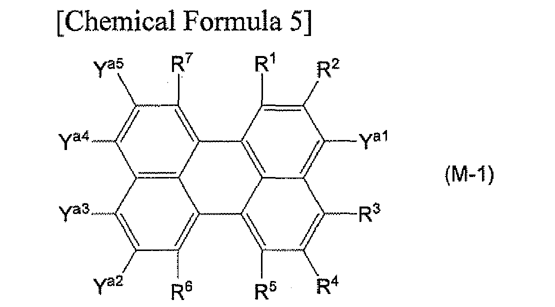 in formula (M-1), R¹, R², R³, R⁴, R⁵, R⁶ and R⁷ each independently represent a hydrogen atom, an alkyl group, an aryl group, a monovalent aromatic heterocyclic group or a group represented by -O-R^{A}, Y^{a1} represents a first polymerizable group which is a group selected from the group consisting of the following substituent group A and the following substituent group B, and one of Y^{a2}, Y^{a3}, Y^{a4} and Y^{a5} represents a second polymerizable group which is a group selected from the group consisting of the substituent group A and the substituent group B, while the other three each independently represent a hydrogen atom, an alkyl group, an aryl group, a monovalent aromatic heterocyclic group or a group represented by -O-R^{A}; R^{A} is an alkyl group, an aryl group or a monovalent aromatic heterocyclic group, R¹, R², R³, R⁴, R⁵, R⁶, R⁷, Y^{a2}, Y^{a3}, Y^{a4}, Y^{a5} and R^{A} each may have a substituent, and when there are multiple R^{A} groups, the R^{A} groups may be the same or different; 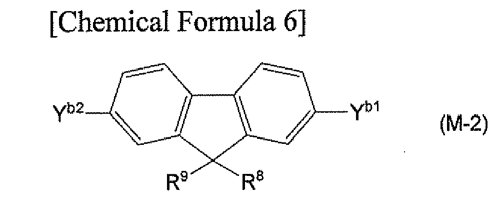 in formula (M-2), R⁸ and R⁹ each independently represent an alkyl group, an aryl group or a monovalent aromatic heterocyclic group, and these groups each may have a substituent, Y^{b1} and Y^{b2} each independently represent a group selected from the group consisting of the substituent group A and the substituent group B, when the first polymerizable group and the second polymerizable group in formula (M-1) above are both groups selected from the substituent group A, at least one of Y^{b1} and Y^{b2} is a group selected from the substituent group B, and when the first polymerizable group and the second polymerizable group are both groups selected from the substituent group B, at least one of Y^{b1} and Y^{b2} is a group selected from the substituent group A,
(substituent group A)
a chlorine atom, a bromine atom, an iodine atom and groups represented by -O-S(=O)₂R²⁰, wherein R²⁰ represents an alkyl group, or an aryl group optionally substituted with an alkyl group, an alkoxy group, a nitro group, a fluorine atom or a cyano group,
(substituent group B)
groups represented by -B(OR²¹)₂, wherein R²¹ represents a hydrogen atom or an alkyl group, and the two R²¹ groups may be the same or different and may be bonded together to form a ring, groups represented by -BF₄Q¹, wherein Q¹ represents a monovalent cation of lithium, sodium, potassium, rubidium or cesium, groups represented by -Sn(R²²)₃,wherein R²² represents hydrogen or an alkyl group, and the three R²² groups may be the same or different and may be bonded together to form a ring, groups represented by -MgY¹, wherein Y¹ represents a chlorine atom, a bromine atom or an iodine atom, and groups represented by -ZnY², wherein Y² represents a chlorine atom, a bromine atom or an iodine atom.

The invention further provides a method for producing the aforementioned polymer compound, comprising polymerizing at least two kinds of monomers including a monomer represented by the following formula (M-5), 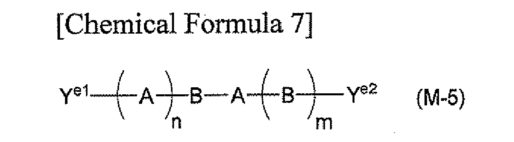 in formula (M-5), A represents a group represented by the following formula (m-1), B represents a group represented by the following formula (m-2), m and n each independently represent 0 or 1, and Y^{e1} and Y^{e2} each independently represent a group selected from the group consisting of the following substituent group A and the following substituent group B, 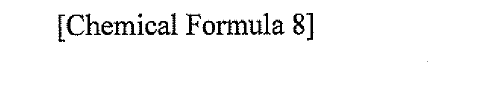 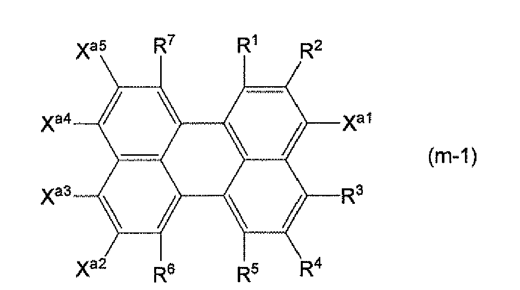 in formula (m-1), R¹, R², R³, R⁴, R⁵, R⁶ and R⁷ each independently represent a hydrogen atom, an alkyl group, an aryl group, a monovalent aromatic heterocyclic group or a group represented by -O-R^{A}, X^{a1} represents a binding site to Y^{e1} or Y^{e2}, and one of X^{a2}, X^{a3}, X^{a4} and X^{a5} represents a binding site to B, Y^{e1} or Y^{e2}, while the other three each independently represent a hydrogen atom, an alkyl group, an aryl group, a monovalent aromatic heterocyclic group or a group represented by -O-R^{A}, R^{A} is an alkyl group, an aryl group or a monovalent aromatic heterocyclic group, R¹, R², R³, R⁴, R⁵, R⁶, R⁷, X^{a2}, X^{a3}, X^{a4}, X^{a5} and R^{A} each may have a substituent, and when there are multiple R^{A} groups, the R^{A} groups may be the same or different; 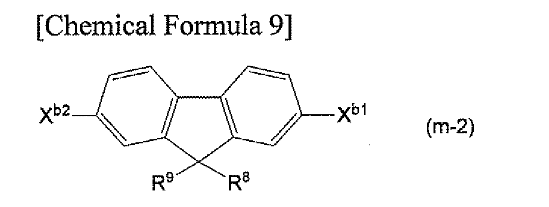 in formula (m-2), R⁸ and R⁹ each independently represent an alkyl group, an aryl group or a monovalent aromatic heterocyclic group, and these groups each may have a substituent, X^{b1} and X^{b2} each independently represent a binding site to A, Y^{e1} or Y^{e2},
(substituent group A)
a chlorine atom, a bromine atom, an iodine atom and groups represented by -O-S(=O)₂R²⁰, wherein R²⁰ represents an alkyl group, or an aryl group optionally substituted with an alkyl group, an alkoxy group, a nitro group, a fluorine atom or a cyano group,
(substituent group B)
groups represented by -B(OR²¹)₂, wherein R²¹ represents a hydrogen atom or an alkyl group, and the two R²¹ groups may be the same or different and may be bonded together to form a ring, groups represented by -BF₄Q¹, wherein Q¹ represents a monovalent cation of lithium, sodium, potassium, rubidium or cesium, groups represented by -Sn(R²²)₃, wherein R²² represents a hydrogen atom or an alkyl group, and the three R²² groups may be the same or different and may be bonded together to form a ring, groups represented by -MgY¹, wherein Y¹ represents chlorine, bromine or iodine, and groups represented by -ZnY², wherein Y² represents a chlorine atom, a bromine atom or an iodine atom.

The invention further provides a polymer composition comprising the aforementioned polymer compound and at least one material selected from the group consisting of hole transporting materials, electron transporting materials and light emitting materials. Such a polymer composition can be suitably used for production of a light emitting device, and the obtained light emitting device has excellent luminous efficiency.

The invention still further provides a solution comprising the aforementioned polymer compound, and a solution comprising the aforementioned polymer composition. Such solutions allow easy production of an organic film comprising the aforementioned polymer compound.

The invention still further provides an organic film comprising the aforementioned polymer compound, and an organic film comprising the aforementioned polymer composition. Such organic films are useful for production of light emitting devices with excellent luminous efficiency.

The invention still further provides an organic semiconductor device comprising the aforementioned organic film, and an organic light emitting device comprising the aforementioned organic film. A device produced using the polymer compound described above has excellent luminous efficiency. Preferred embodiments of these devices have excellent driving stability of luminescent brightness.

The invention still further provides a surface light source and a display device employing the aforementioned organic light emitting device with excellent luminous efficiency.

The invention still further provides compounds represented by the following formula (M-5). Such compounds are useful as starting compounds for production of the aforementioned polymer compound. 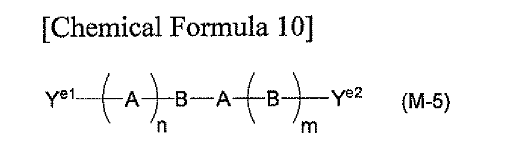 In formula (M-5), A represents a group represented by the following formula (m-1), B represents a group represented by the following formula (m-2), m and n each independently represent 0 or 1, and Y^{e1} and Y^{e2} each independently represent a group selected from the group consisting of the following substituent group A and the following substituent group B, 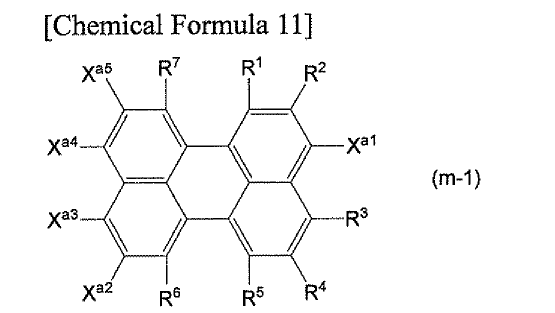 in formula (m-1), R¹, R², R³, R⁴, R⁵, R⁶ and R⁷ each independently represent a hydrogen atom, an alkyl group, an aryl group, a monovalent aromatic heterocyclic group or a group represented by -O-R^{A}, X^{a1} represents a binding site to Y^{e1} or Y^{e2}, and one of X^{a2}, X^{a3}, X^{a4} and X^{a5} represents a binding site to B, Y^{e1} or Y^{e2} while the other three each independently represent a hydrogen atom, an alkyl group, an aryl group, a monovalent aromatic heterocyclic group, or a group represented by -O-R^{A}, R^{A} is an alkyl group, an aryl group or a monovalent aromatic heterocyclic group, R¹, R², R³ R⁴ R⁵, R⁶ R⁷, X^{a2}, X^{a3}, X^{a4}, X^{a5} and R^{A} each may have a substituent, and when there are multiple R^{A} groups, the R^{A} groups may be the same or different, 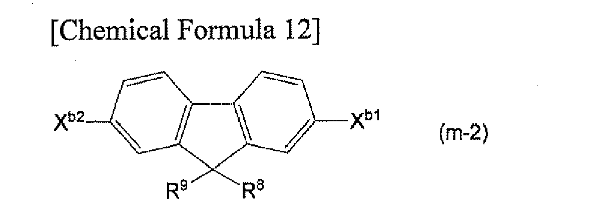 in formula (m-2), R⁸ and R⁹ each independently represent an alkyl group, an aryl group or a monovalent aromatic heterocyclic group, and these groups each may have a substituent, X^{b1} and X^{b2} each independently represent a binding site to A, Y^{e1} or Y^{e2},
(substituent group A)
a chlorine atom, a bromine atom, an iodine atom and groups represented by -O-S(=O)₂R²⁰, wherein R²⁰ represents an alkyl group, or an aryl group optionally substituted with an alkyl group, an alkoxy group, a nitro group, a fluorine atom or a cyano group,
(substituent group B)
groups represented by -B(OR²¹)₂, wherein R²¹ represents a hydrogen atom or an alkyl group, and the two R²¹ groups may be the same or different and may be bonded together to form a ring, groups represented by -BF₄Q¹, wherein Q¹ represents a monovalent cation of lithium, sodium, potassium, rubidium or cesium, groups represented by -Sn(R²²)₃, wherein R²² represents a hydrogen atom or an alkyl group, and the three R²² groups may be the same or different and may be bonded together to form a ring, groups represented by -MgY¹, wherein Y¹ represents a chlorine atom, a bromine atom or an iodine atom, and groups represented by -ZnY², wherein Y² represents a chlorine atom, a bromine atom or an iodine atom.

### Advantageous Effects of Invention

According to the invention, it is possible to provide a polymer compound that is useful for production of a light emitting device with excellent luminous efficiency. It is also possible to provide a polymer composition, solution, organic film, organic semiconductor device, organic light emitting device, surface light source and display device comprising the polymer compound. A light emitting device obtained using the polymer compound has excellent luminous efficiency. Preferred embodiments of such a light emitting device are light emitting devices with excellent driving stability of luminescent brightness, and a long usable life. Furthermore, according to the invention, it is possible to provide a method for producing the aforementioned polymer compound, and a compound that is useful for production of the polymer compound.

### Brief Description of Drawings

Fig. 1 shows a ¹H-NMR spectrum of the yellow crystals obtained in Synthesis Example 1.
Fig. 2 shows a ¹H-NMR spectrum of the solid obtained in Example 1.
Fig. 3 is a schematic cross-sectional view of an organic film transistor.
Fig. 4 is a schematic cross-sectional view of an organic film transistor.
Fig. 5 is a schematic cross-sectional view of a light emitting device (device structure p).
Fig. 6 is a schematic cross-sectional view of a light emitting device (device structure e).
Fig. 7 is a schematic cross-sectional view of a light emitting device (device structure h).
Fig. 8 is a schematic cross-sectional view of a surface light source.

### Description of Embodiments

Preferred embodiments of the invention will now be described in detail. Throughout the present specification, Me represents a methyl group, Et represents an ethyl group and Ph represents a phenyl group.

Also throughout the present specification, the term "constitutional unit" refers to a unit structure of which at least one is present in the polymer compound. The "constitutional unit" is preferably present in the polymer compound as a "repeating unit" (that is, a unit structure of which 2 or more are present in the polymer compound). The phrase "n-valent aromatic heterocyclic group" means an atomic group derived by removing n hydrogen atoms directly bonded to the aromatic ring of a heterocyclic compound having aromaticity, and it includes those having fused rings. The term "heterocyclic compound" includes organic compounds with a ring structure that contain heteroatoms such as oxygen atoms, sulfur atoms, nitrogen atoms, phosphorus atoms, boron atoms and silicon atoms, as atoms composing the ring in addition to carbon atoms. An "aromatic heterocyclic compound" is a heterocyclic compound containing a heteroatom, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole or dibenzophosphole, and it includes those wherein the heterocyclic ring itself is aromatic, and those wherein the heterocyclic ring itself containing a heteroatom is not aromatic but an aromatic ring is fused to the heterocyclic ring, such as phenoxazine, phenothiazine, dibenzoborole, dibenzosilol or benzopyran. An "n-valent fused aromatic heterocyclic group" is the aforementioned "n-valent aromatic heterocyclic group" having a fused ring.

### <Polymer compound>

### [First constitutional unit]

A polymer compound according to this embodiment comprises a constitutional unit represented by formula (1) (first constitutional unit).

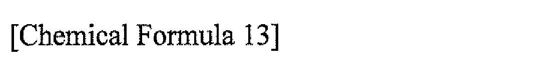

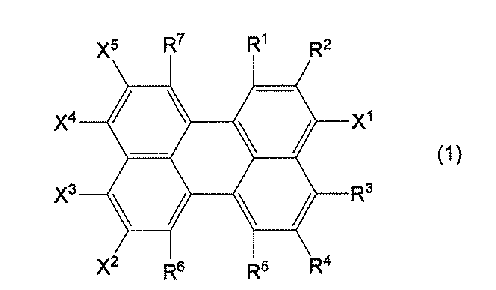

In formula (1), R¹, R², R³, R⁴, R⁵, R⁶ and R⁷ each independently represent a hydrogen atom, an alkyl group, an aryl group, a monovalent aromatic heterocyclic group or a group represented by -O-R^{A}, X¹ represents a binding site to a constitutional unit composing the polymer compound according to this embodiment, and one of X², X³, X⁴ and X⁵ represents a binding site to a constitutional unit composing the polymer compound while the remaining three each independently represent a hydrogen atom, an alkyl group, an aryl group, a monovalent aromatic heterocyclic group, or a group represented by -O-R^{A}. R^{A} is an alkyl group, an aryl group or a monovalent aromatic heterocyclic group, R¹, R², R³, R⁴, R⁵, R⁶, R⁷, X², X³, X⁴, X⁵ and R^{A} each may have a substituent, and when there are multiple R^{A} groups, the R^{A} groups may be the same or different.

In formula (1), the alkyl groups of R¹, R², R³, R⁴, R⁵, R⁶, R⁷, X² X³, X⁴ and X⁵ may be straight-chain, branched or cyclic, and usually have 1-20 carbon atoms. The number of carbon atoms of the substituents is not included in this number of carbon atoms. Examples of such alkyl groups include a methyl group, an ethyl group, a propyl group, an isopropyl group, a butyl group, an isobutyl group, a tert-butyl group, a pentyl group, an isoamyl group, a hexyl group, a cyclohexyl group, a heptyl group, an octyl group, a 2-ethylhexyl group, a nonyl group, a decyl group, a 3,7-dimethyloctyl group and a dodecyl group. All or some of the hydrogen atoms of the alkyl groups are optionally substituted with an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a cyano group or a fluorine atom. Examples of alkyl groups substituted with a fluorine atom include trifluoromethyl, pentafluoroethyl, perfluorobutyl, perfluorohexyl and perfluorooctyl.

In formula (1), the aryl groups of R¹, R², R³, R⁴, R⁵, R⁶, R⁷, X², X³, X⁴ and X⁵ are atomic groups derived by removing one hydrogen atom directly bonded to the aromatic ring of an aromatic hydrocarbon, and they include those with fused rings. The number of carbon atoms of the aryl group is usually 6-60, and is preferably 6-48, more preferably 6-20 and even more preferably 6-14. The number of carbon atoms of the substituents is not included in this number of carbon atoms. Such aryl groups include a phenyl group, a 1-naphthyl group, a 2-naphthyl group, a 1-anthracenyl group, a 2-anthracenyl group, a 9-anthracenyl group, a 1-tetracenyl group, a 2-tetracenyl group, a 5-tetracenyl group, a 1-pyrenyl group, a 2-pyrenyl group, a 4-pyrenyl group, a 2-perylenyl group, a 3-perylenyl group, a 2-fluorenyl group, a 3-fluorenyl group, a 4-fluorenyl group, a 1-biphenylyl group, a 2-biphenylyl group, a 2-phenanthrenyl group, a 9-phenanthrenyl group, a 6-chrysenyl group and a 1-coronenyl group. All or some of the hydrogen atoms of the aryl groups are optionally substituted with an alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a cyano group or a fluorine atom.

In formula (1), the monovalent aromatic heterocyclic groups in R¹, R², R³, R⁴, R⁵, R⁶, R⁷, X², X³, X⁴ and X⁵ usually have 3-60 and preferably 3-20 carbon atoms. The number of carbon atoms of the substituents are not included in this number of carbon atoms. Such monovalent aromatic heterocyclic groups include a 1,3,4-oxadiazol-2-yl group, a 1,3,4-thiadiazol-2-yl group, a 2-thiazolyl group, a 2-oxazolyl group, a 2-thienyl group, a 2-pyrrolyl group, a 2-furyl group, a 2-pyridyl group, a 3₋pyridyl group, a 4-pyridyl group, a 2-pyrazinyl group, a 2-pyrimidinyl group, a 2-triazinyl group, a 3-pyridazinyl group, a 5-quinolyl group, a 5-isoquinolyl group, a 2-carbazolyl group, a 3-carbazolyl group, a 2-phenoxazinyl group, a 3-phenoxazinyl group, a 2-phenothiazinyl group and a 3-phenothiazinyl group. All or some of the hydrogen atoms of the monovalent aromatic heterocyclic groups are optionally substituted with an alkyl group, an aryl group, a monovalent aromatic heterocyclic group, a group represented by -O-R^{A}, a group represented by -S-R^{A}, a group represented by -C(=O)-R^{A}, a group represented by -C(=O)-OR^{A}, a cyano group or a fluorine atom.

Examples of the alkyl group, the aryl group and the monovalent aromatic heterocyclic group for R^{A} are the same as the groups for R¹ mentioned above.

In formula (1), the groups represented by "-O-R^{A}" for R¹, R², R³, R⁴, R⁵, R⁶, R⁷, X², X³, X⁴ and X⁵, when R^{A} is an alkyl group, may be alkoxy groups with straight-chain, branched or cyclic alkyl groups. The alkoxy group generally has 1-20 carbon atoms. Such alkoxy groups include a methoxy group, an ethoxy group, a propyloxy group, an isopropyloxy group, a butoxy group, an isobutoxy group, a tert-butoxy group, a pentyloxy group, a hexyloxy group, a nonyloxy group, a decyloxy group, a 3,7-dimethyloctyloxy group, a dodecyloxy group, a trifluoromethoxy group, a pentafluoroethoxy group, a perfluorobutoxy group, a perfluorohexyloxy group, a perfluorooctyloxy group, a methoxymethyloxy group, a 2-methoxyethyloxy group and a 2-ethoxyethyloxy group.

In formula (1), the groups represented by "-O-R^{A}" for R¹, R², R³, R⁴, R⁵, R⁶, R⁷, X², X³, X⁴ and X⁵, when R^{A} is an aryl group, may be aryloxy groups with usually 6-60 carbon atoms. The aryl group portion may be any of the same aryl groups represented by R¹. More specifically, such aryloxy groups include a phenoxy group, a C₁-C₁₂ alkoxyphenoxy group ("C₁-C₁₂ alkoxy" means 1-12 carbon atoms in the alkoxy portion, same hereunder), a C₁-C₁₂ alkylphenoxy group ("C₁-C₁₂ alkyl" means 1-12 carbon atoms in the alkyl portion, same hereunder), a 1-naphthyloxy group, a 2-naphthyloxy group and a pentafluorophenyloxy group.

In formula (1), the groups represented by "-O-R^{A}" for R¹, R², R³, R⁴, R⁵, R⁶, R⁷, X², X³, X⁴ and X⁵, when R^{A} is a monovalent aromatic heterocyclic group, may be groups with usually 3-60 and preferably 3-20 carbon atoms. The monovalent aromatic heterocyclic groups may be any of the same as the monovalent aromatic heterocyclic groups for R¹ mentioned above.

In formula (1), R¹, R⁵, R⁶ and R⁷ are preferably hydrogen atoms. This will improve the stability of the polymer compound of this embodiment.

When X² in formula (1) represents a binding site to a constitutional unit composing the polymer compound of this embodiment, from the viewpoint of satisfactory stability of the polymer compound of this embodiment, and more satisfactory luminous efficiency of a light emitting device employing the polymer compound, R² and X³ preferably each independently are a hydrogen atom, an alkyl group or an aryl group, and more preferably a hydrogen atom. Also, R³ is preferably a hydrogen atom or an alkyl group, and more preferably a hydrogen atom. In addition, X⁴ and X⁵ each independently are preferably a hydrogen atom, an alkyl group or an aryl group, and more preferably a hydrogen atom or an alkyl group.

When X³ in formula (1) represents a binding site to a constitutional unit composing the polymer compound of this embodiment, from the viewpoint of satisfactory stability of the polymer compound of this embodiment, and more satisfactory luminous efficiency of a light emitting device employing the polymer compound, R² and X² preferably each independently are a hydrogen atom, an alkyl group or an aryl group, and more preferably a hydrogen atom. Also, R³ and X⁴ are each independently a hydrogen atom or an alkyl group, and more preferably a hydrogen atom. In addition, R⁴ and X⁵ each independently are preferably a hydrogen atom, an alkyl group or an aryl group, and more preferably a hydrogen atom or an alkyl group.

When X⁴ in formula (1) represents a binding site to a constitutional unit composing the polymer compound of this embodiment, from the viewpoint of satisfactory stability of the polymer compound of this embodiment, and more satisfactory luminous efficiency of a light emitting device employing the polymer compound, R² and X⁵ preferably each independently are a hydrogen atom, an alkyl group or an aryl group, and more preferably a hydrogen atom. Also, R³ and X³ are each independently a hydrogen atom or an alkyl group, and more preferably a hydrogen atom. In addition, R⁴ and X² each independently are preferably a hydrogen atom, an alkyl group or an aryl group, and more preferably a hydrogen atom or an alkyl group.

When X⁵ in formula (1) represents a binding site to a constitutional unit composing the polymer compound of this embodiment, from the viewpoint of satisfactory stability of the polymer compound of this embodiment, and more satisfactory luminous efficiency of a light emitting device employing the polymer compound, R² and X⁴ preferably each independently are a hydrogen atom, an alkyl group or an aryl group, and more preferably a hydrogen atom. Also, R³ is preferably a hydrogen atom or an alkyl group, and more preferably a hydrogen atom. In addition, X² and X³ each independently are preferably a hydrogen atom, an alkyl group or an aryl group, and more preferably a hydrogen atom or an alkyl group.

X³ and X⁴ in formula (1) are each preferably a binding site to a constitutional unit composing the polymer compound of this embodiment. A polymer compound with such a first constitutional unit results in more excellent luminous efficiency for a light emitting device employing the polymer compound.

Specifically, the first constitutional unit may be a constitutional unit represented by any of the following formulas (1-001)-(1-020), (1-101)-(1-120) or (1-201)-(1-212).

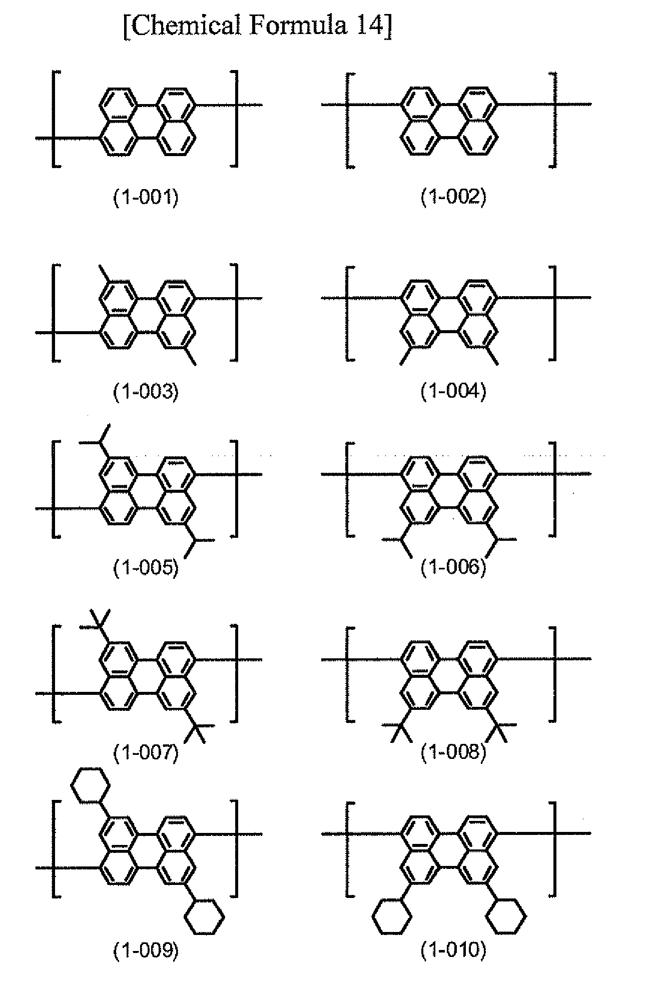

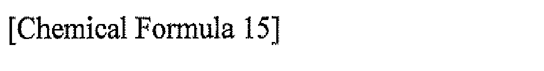

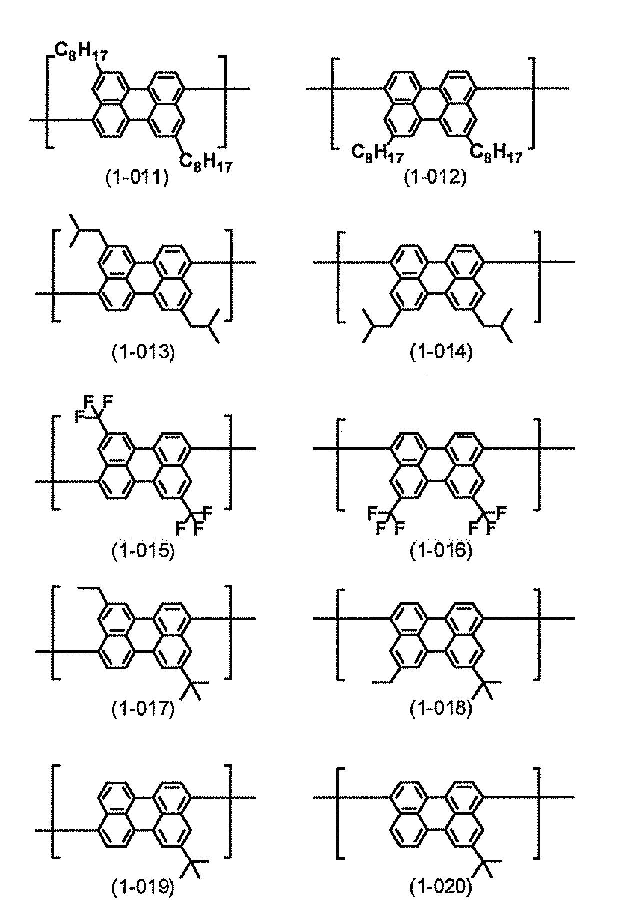

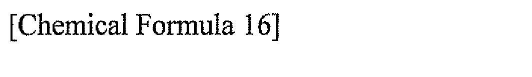

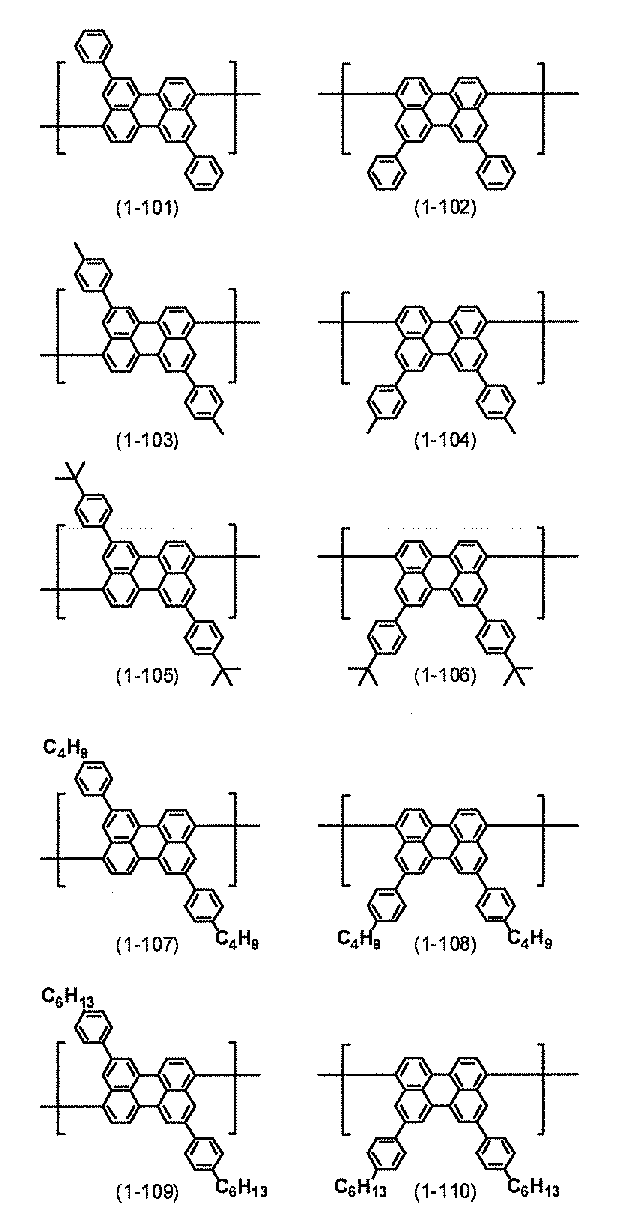

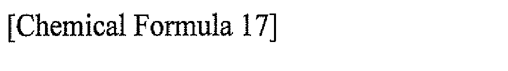

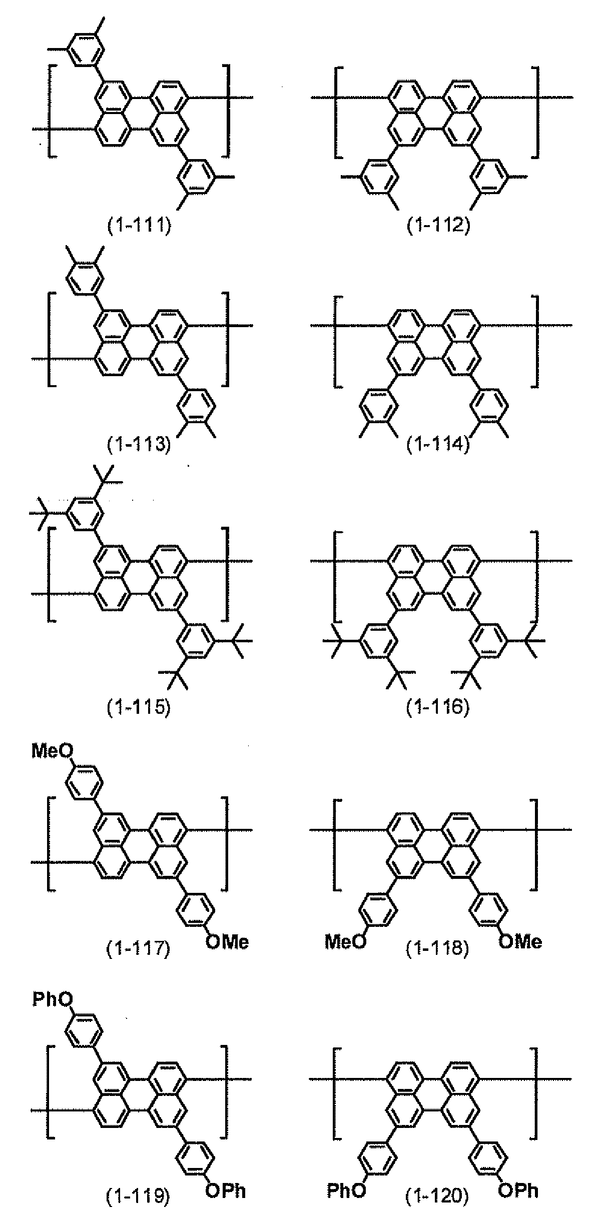

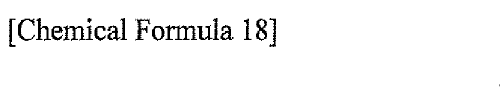

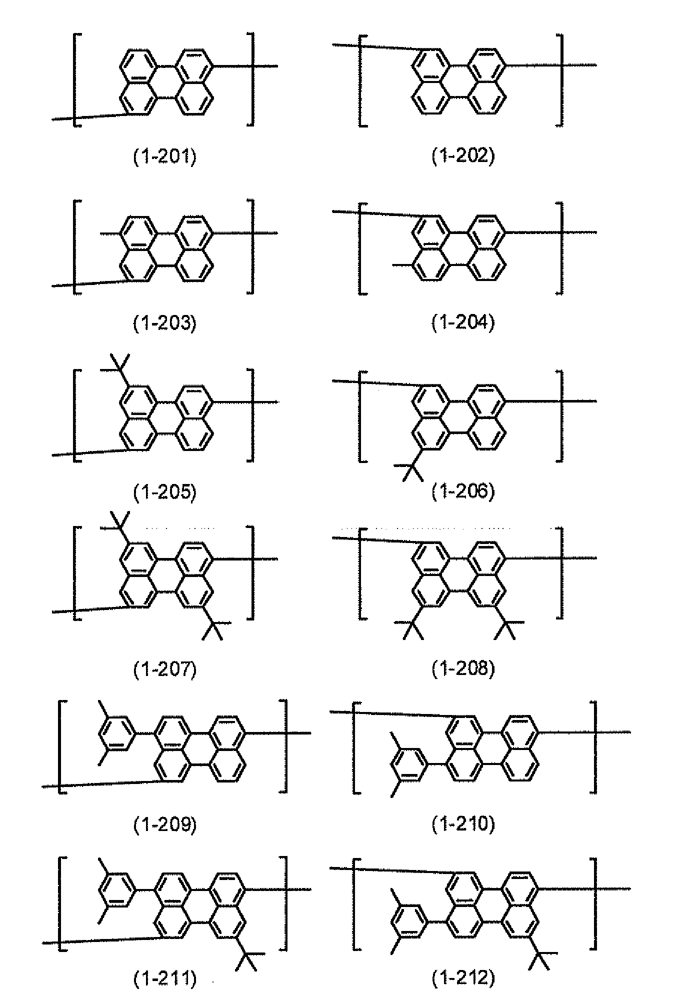

The constitutional unit represented by formula (1) may be a single type or two or more types in the polymer compound of this embodiment.

Among the constitutional units represented by formulas (1-001)-(1-020), (1-101)-(1-120) and (1-201)-(1-212) above, from the viewpoint of facilitating synthesis of the polymer compound of this embodiment and obtaining even more excellent luminous efficiency for a light emitting device employing the polymer compound, the constitutional unit represented by formula (1) is preferably a constitutional unit represented by (1-001)-(1-020) or (1-101)-(1-120), and more preferably a constitutional unit represented by (1-001) or (1-002).

### [Second constitutional unit]

A polymer compound according to this embodiment comprises a constitutional unit represented by formula (2) (second constitutional unit).

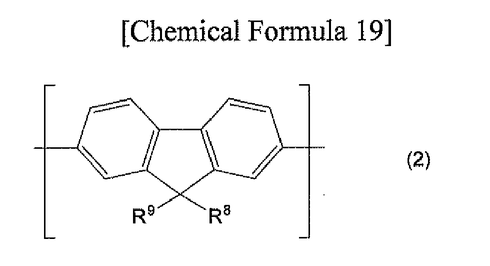

In formula (2), R⁸ and R⁹ each independently represent an alkyl group, an aryl group or a monovalent aromatic heterocyclic group, and these groups are optionally substituted.

Alkyl groups for R⁸ and R⁹ in formula (2) include a methyl group, an ethyl group, a propyl group, an isopropyl group, a butyl group, a sec-butyl group, an isobutyl group, a pentyl group, a 2-methylbutyl group, an isoamyl group, a hexyl group, a heptyl group, an octyl group, a 2-ethylhexyl group, a nonyl group, a decyl group, a 3,7-dimethyloctyl group and a dodecyl group. These groups may also have substituents.

Aryl groups for R⁸ and R⁹ in formula (2) include a phenyl group, a 1-naphthyl group and a 2-naphthyl group. These groups may also have substituents.

Monovalent aromatic heterocyclic groups for R⁸ and R⁹ in formula (2) include any of the same monovalent aromatic heterocyclic groups for R¹ mentioned above.

From the viewpoint of heat resistance and solubility of the polymer compound of this embodiment, the groups for R⁸ and R⁹ in formula (2) are preferably substituted or unsubstituted aryl group or substituted or unsubstituted alkyl group, more preferably an aryl group which is unsubstituted or substituted with an alkyl group, an alkoxy group, an aryl group or a substituted amino group, or an alkyl group which is unsubstituted or substituted with an alkyl group, an alkoxy group, an aryl group or a substituted amino group, and even more preferably a 4-tolyl group, a 4-butylphenyl group, a 4-tert-butylphenyl group, a 4-hexylphenyl group, a 4-octylphenyl group, a 4-(2-ethylhexyl)phenyl group, a 4-(3,7-dimethyloctyl)phenyl group, a 3-tolyl group, a 3-butylphenyl group, a 3-tert-butylphenyl group, a 3-hexylphenyl group, a 3-octylphenyl group, a 3-(2-ethylhexyl)phenyl group, a 3-(3,7-dimethyloctyl)phenyl group, a 3,5-dimethylphenyl group, a 3,5-di-(tert-butyl)phenyl group, a 3,5-dihexylphenyl group, a 3,5-dioctylphenyl group, a 3,4-dihexylphenyl group, a 3,4-dioctylphenyl group, a 4-hexyloxyphenyl group, a 4-octyloxyphenyl group, a 4-(2-ethoxy)ethoxyphenyl group, a 4-(4'-tert-butylbiphenylyl) group, a 9,9-dihexylfluoren-2-yl group, a 9,9-dioctylfluoren-2-yl group, a pentyl group, a hexyl group, a 2-ethylhexyl group, an octyl group or a 3,7-dimethyloctyl group.

The constitutional unit represented by formula (2) may be a single type or two or more types in the polymer compound of this embodiment.

### [Third constitutional unit]

The polymer compound of this embodiment comprises a constitutional unit represented by formula (3) (third constitutional unit) and/or a constitutional unit represented by formula (4) (fourth constitutional unit).

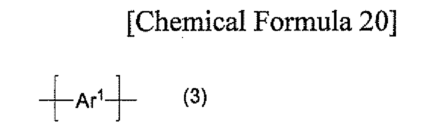

In formula (3), Ar¹ represents an arylene group, a divalent aromatic heterocyclic group, or a divalent group in which are linked two or more identical different groups selected from the group consisting of arylene groups and divalent aromatic heterocyclic groups (excluding groups represented by formula (1) or formula (2)). Ar¹ may have one or more substituents selected from the group consisting of alkyl groups, aryl groups, monovalent aromatic heterocyclic groups, groups represented by -O-R^{A}, groups represented by -S-R^{A}, groups represented by -C(=O)-R^{A}, groups represented by -C(=O)-O-R^{A}, groups represented by -N(R^{A})₂, a cyano group and a fluorine atom. R^{A} is as defined above, and when there are multiple R^{A} groups, the R^{A} groups may be the same or different.

The arylene group for Ar¹ in formula (3) has usually 6-60, preferably 6-48, more preferably 6-30 and even more preferably 6-14 carbon atoms. The number of carbon atoms of the substituents is not included in this number of carbon atoms. Arylene groups include phenylene groups such as a 1,4-phenylene group (formula 2-001), a 1,3-phenylene group (formula 2-002) and a 1,2-phenylene group (formula 2-003); naphthalenediyl groups such as a naphthalene-1,4-diyl group (formula 2-004), a naphthalene-1,5-diyl group (formula 2-005) and a naphthalene-2,6-diyl group (formula 2-006); dihydrophenanthrenediyl groups such as a 9,10-dihydrophenanthrene-2,7-diyl group (formula 2-007); a fluorene-3,6-diyl group (formula 2-008); benzofluorenediyl groups represented by (formula 2-010) to (formula 2-012), and anthracenediyl groups such as an anthracene-2,6-diyl group (formula 2-013) and an anthracene-9,10-diyl group (formula 2-014). Some or all of the hydrogen atoms in these arylene groups may be substituted with an alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a group represented by -N(R^{A})₂, a cyano group or a fluorine atom.

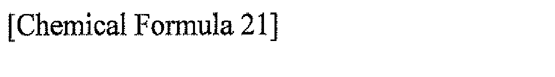

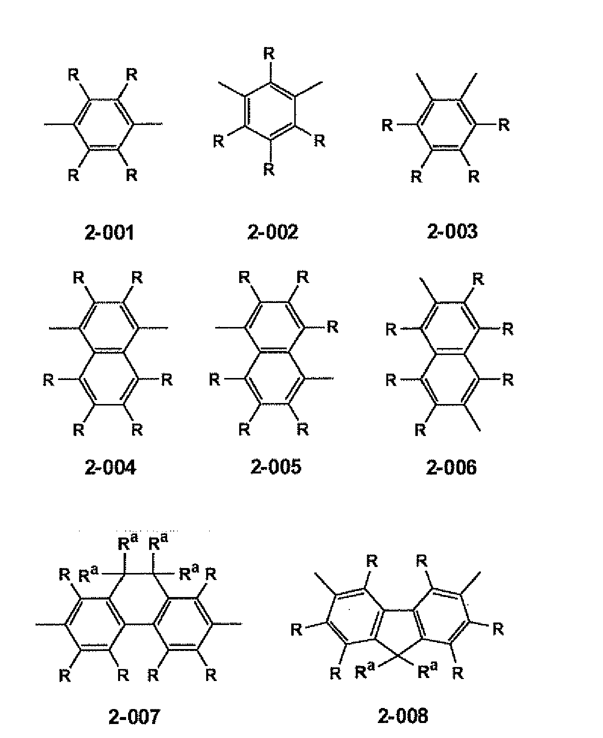

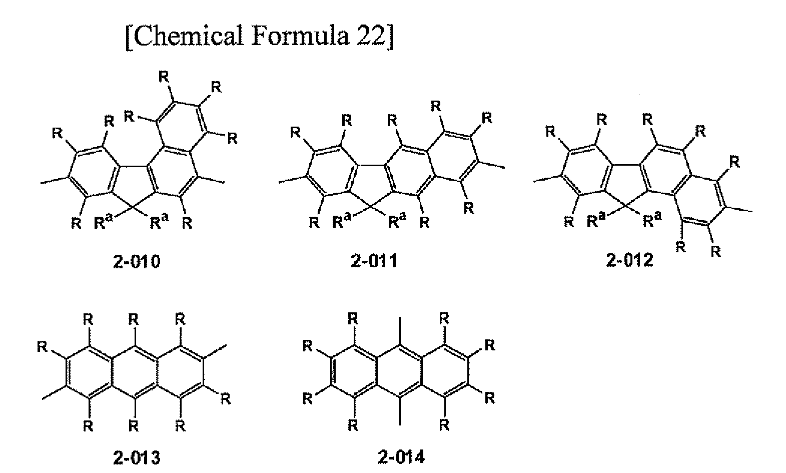

In the formulas, R represents a hydrogen atom, an alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a cyano group or a fluorine atom, R^{a} represents an alkyl group, an aryl group or a monovalent aromatic heterocyclic group, multiple R groups may be the same or different, and multiple R^{a} groups may be the same or different.

In formula (3), the divalent aromatic heterocyclic group in Ar¹ has usually 3-60 and preferably 3-20 carbon atoms. The number of carbon atoms of the substituents is not included in this number of carbon atoms. Some or all of the hydrogen atoms of the divalent aromatic heterocyclic groups are optionally substituted with an alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a cyano group or a fluorine atom.

In formula (3), the divalent aromatic heterocyclic group represented by Ar¹ is preferably a divalent fused aromatic heterocyclic group for satisfactory stability of the polymer compound of this embodiment. The divalent fused aromatic heterocyclic group has usually 8-60 and preferably 8-20 carbon atoms. The number of carbon atoms of the substituents is not included in this number of carbon atoms. Divalent fused aromatic heterocyclic groups include quinolinediyl groups such as a quinoline-2,6-diyl group (formula 2-107); isoquinolinediyl groups such as an isoquinoline-1,4-diyl group (formula 2-108); quinoxalinediyl groups such as a quinoxaline-5,8-diyl group (formula 2-109); carbazolediyl groups such as a carbazole-3,6-diyl group (formula 2-110) and a carbazole-2,7-diyl group (formula 2-111); dibenzofurandiyl groups such as a dibenzofuran-4,7-diyl group (formula 2-112) and a dibenzofuran-3,8-diyl group (formula 2-113); dibenzothiophenediyl groups such as a dibenzothiophene-4,7-diyl group (formula 2-114) and a dibenzothiophene-3,8-diyl group (formula 2-115); dibenzosiloldiyl groups such as a dibenzosilol-4,7-diyl group (formula 2-116) and a dibenzosilol-3,8-diyl group (formula 2-117); phenoxazinediyl groups such as a phenoxazine-3,7-diyl group (formula 2-118) and a phenoxazine-2,8-diyl group (formula 2-119); phenothiazinediyl groups such as a phenothiazine-3,7-diyl group (formula 2-120) and a phenothiazine-2,8-diyl group (formula 2-121); dihydroacridinediyl groups such as a dihydroacridine-2,7-diyl group (formula 2-123); and divalents groups represented by (formula 2-124). Some or all of the hydrogen atoms of these divalent fused aromatic heterocyclic groups are optionally substituted with an alkyl group, an aryl group, a monovalent aromatic heterocyclic group, a group represented by -O-R^{A}, a group represented by -S-R^{A}, a group represented by -C(=O)-R^{A}, a group represented by -C(=O)-O-R^{A}, a cyano group or a fluorine atom.

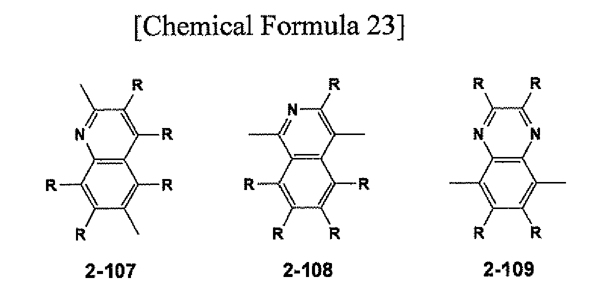

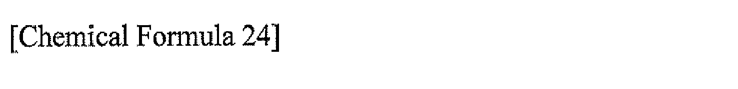

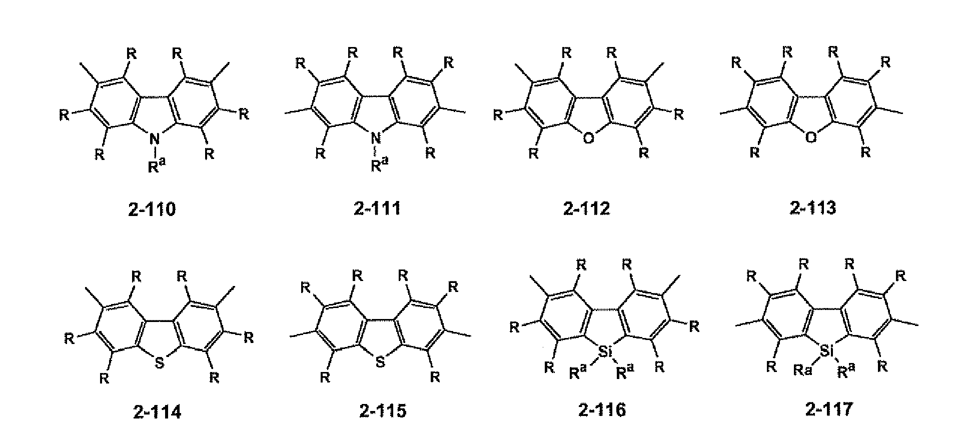

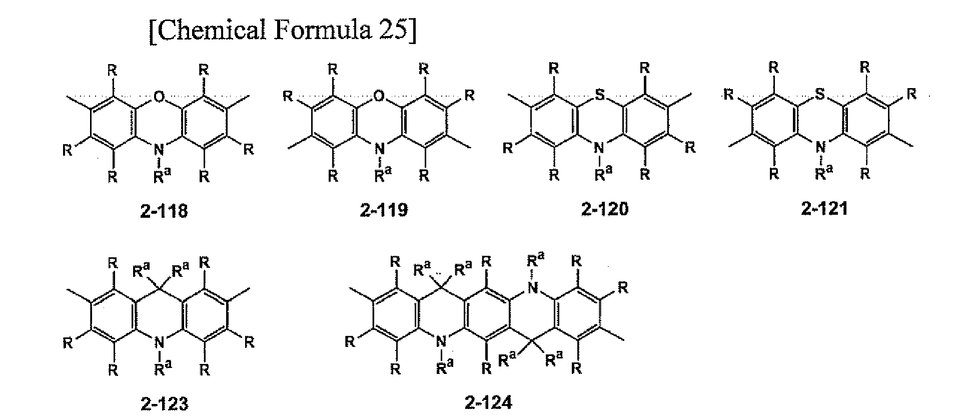

In formula (3), the "divalent group in which are linked two or more identical or different groups selected from the group consisting of arylene groups and divalent aromatic heterocyclic groups" for Ar¹ has usually 4-60 and preferably 12-60 carbon atoms. The number of carbon atoms of the substituents is not included in this number of carbon atoms. Such groups include groups represented by the following formulas 2-201 to 2-208.

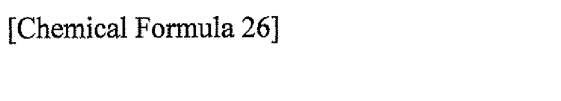

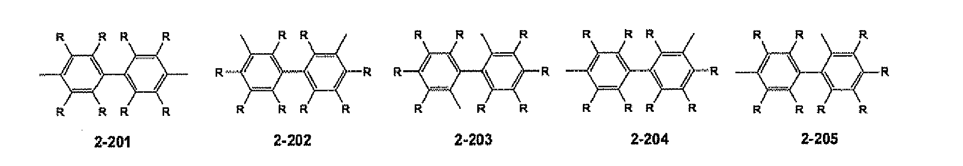

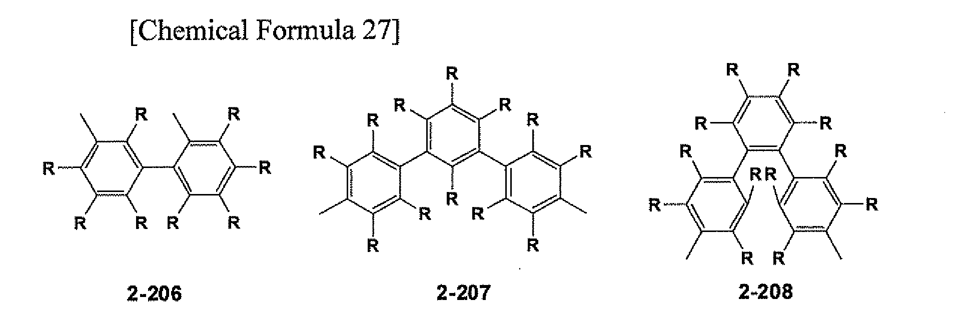

In the formulas, R has the same definition as above.

From the viewpoint of satisfactory stability of the polymer compound of this embodiment, and more satisfactory luminous efficiency for a light emitting device employing the polymer compound, Ar¹ is preferably a 1,4-phenylene group (formula 2-001), a 1,3-phenylene group (formula 2-002), a 9,10-dihydrophenanthrene-2,7-diyl group (formula 2-007), a fluorene-3,6-diyl group (formula 2-008), a divalent group represented by (formula 2-010), a divalent group represented by (formula 2-011), a divalent group represented by (formula 2-012), an anthracene-2,6-diyl group (formula 2-013), an anthracene-9,10-diyl group (formula 2-014), a carbazole-3,6-diyl group (formula 2-110), a carbazole-2,7-diyl group (formula 2-111), a dibenzofuran-4,7-diyl group (formula 2-112), a dibenzofuran-3,8-diyl group (formula 2-113), a dibenzothiophene-4,7-diyl group (formula 2-114), a dibenzothiophene-3,8-diyl group (formula 2-115), a dibenzosilol-4,7-diyl group (formula 2-116), a dibenzosilol-3,8-diyl group (formula 2-117), a phenoxazine-3,7-diyl group (formula 2-118), a phenothiazine-3,7-diyl group (formula 2-120), a dihydroacridine-2,7-diyl group (formula 2-123), a divalent group represented by (formula 2-124), a divalent group represented by (formula 2-201), a divalent group represented by (formula 2-202), or a divalent group represented by (formula 2-207).

From the viewpoint of satisfactory stability of the polymer compound of this embodiment and more satisfactory luminous efficiency of a light emitting device employing the polymer compound, Ar¹ is more preferably a group wherein R is a hydrogen atom, an alkyl group, an aryl group or a monovalent aromatic heterocyclic group, and more preferably R is a hydrogen atom or an alkyl group. Also, R^{a} is preferably an alkyl group or an aryl group.

The constitutional unit represented by formula (3) may be a single type or two or more types in the polymer compound of this embodiment.

### [Fourth constitutional unit]

From the viewpoint of even more satisfactory luminous efficiency of a light emitting device employing the polymer compound, and of increasing the heat resistance, the polymer compound of this embodiment preferably comprises a constitutional unit represented by formula (4) (fourth constitutional unit).

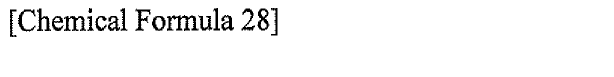

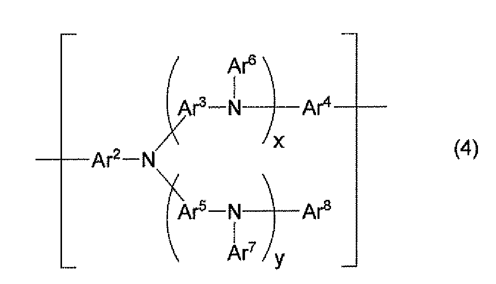

In formula (4), x and y each independently represent 0 or 1, Ar², Ar³, Ar⁴ and Ar⁵ each independently represent an arylene group, a divalent aromatic heterocyclic group, or a divalent group in which are linked two or more identical or different groups selected from the group consisting of arylene groups and divalent aromatic heterocyclic groups, Ar⁶, Ar⁷ and Ar⁸ each independently represent an aryl group or a monovalent aromatic heterocyclic group and Ar², Ar³, Ar⁴, Ar⁵, Ar⁶, Ar⁷ and Ar⁸ each may have one or more substituents selected from the group consisting of alkyl groups, aryl groups, monovalent aromatic heterocyclic groups, groups represented by -O-R^{A}, groups represented by -S-R^{A}, groups represented by -C(=O)-R^{A}, groups represented by -C(=C)-O-R^{A}, groups represented by -N(R^{A})₂, a cyano group and a fluorine atom. Of the groups represented by Ar², Ar³, Ar⁴, Ar⁵, Ar⁶, Ar⁷ and Ar⁸, groups bonded to the same nitrogen atom may be bonded by single bonds, or by groups represented by -O-, -S-, -C(=O)-, -C(=O)-O-, -N(R^{A})-, -C(=O)-N(R^{A}) or -C(R^{A})(R^{A})-. R^{A} is as defined above, and when there are multiple R^{A} groups, the R^{A} groups may be the same or different.

In formula (4), the arylene groups for Ar², Ar³, Ar⁴ and Ar⁵ may be groups represented by the following formula 2-009, or any of the same arylene groups for Ar¹ mentioned above. In formula 2-009, R and R^{a} have the same definitions as above.

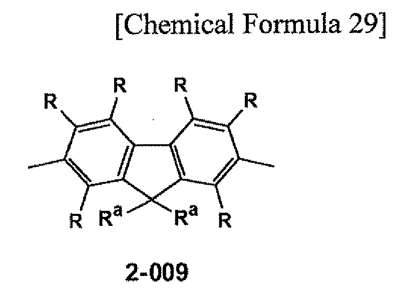

Divalent aromatic heterocyclic groups for Ar², Ar³, Ar⁴ and Ar⁵ in formula (4) include any of the same divalent aromatic heterocyclic groups for Ar¹ mentioned above.

Examples for the "divalent group in which are linked two or more identical or different groups selected from the group consisting of arylene groups and divalent aromatic heterocyclic groups" for Ar², Ar³, Ar⁴ and Ar⁵ in formula (4) include the same groups mentioned above. Ar², Ar³, Ar⁴ and Ar⁵ also include groups containing groups represented by formula (2-009).

From the viewpoint of satisfactory stability of the polymer compound of this embodiment and more satisfactory luminous efficiency for a light emitting device employing the polymer compound, Ar², Ar³, Ar⁴ and Ar⁵ are preferably groups wherein R is a hydrogen atom, an alkyl group, an aryl group or a monovalent aromatic heterocyclic group, and more preferably R is a hydrogen atom or an alkyl group. Also, R^{a} is preferably an alkyl group or an aryl group.

Aryl and monovalent aromatic heterocyclic groups for Ar⁶, Ar⁷ and Ar⁸ in formula (4) include any of the same respective aryl and monovalent aromatic heterocyclic groups for R¹ mentioned above.

Of the groups represented by Ar², Ar³, Ar⁴, Ar⁵, Ar⁶, Ar⁷ and Ar⁸ in formula (4), groups bonded to the same nitrogen atom may be bonded by single bonds, or by groups represented by -O- -S-, -C(=O)-, -C(=O)-O-, -N(R^{A})-, -C(=O)-N(R^{A}) or -C(R^{A})(R^{A})-. This normally forms 5- to 7-membered rings.

Preferred as constitutional units represented by formula (4) are constitutional units represented by the following formulas 3-001 to 3-005. In the formulas, R and R^{a} have the same definitions as above.

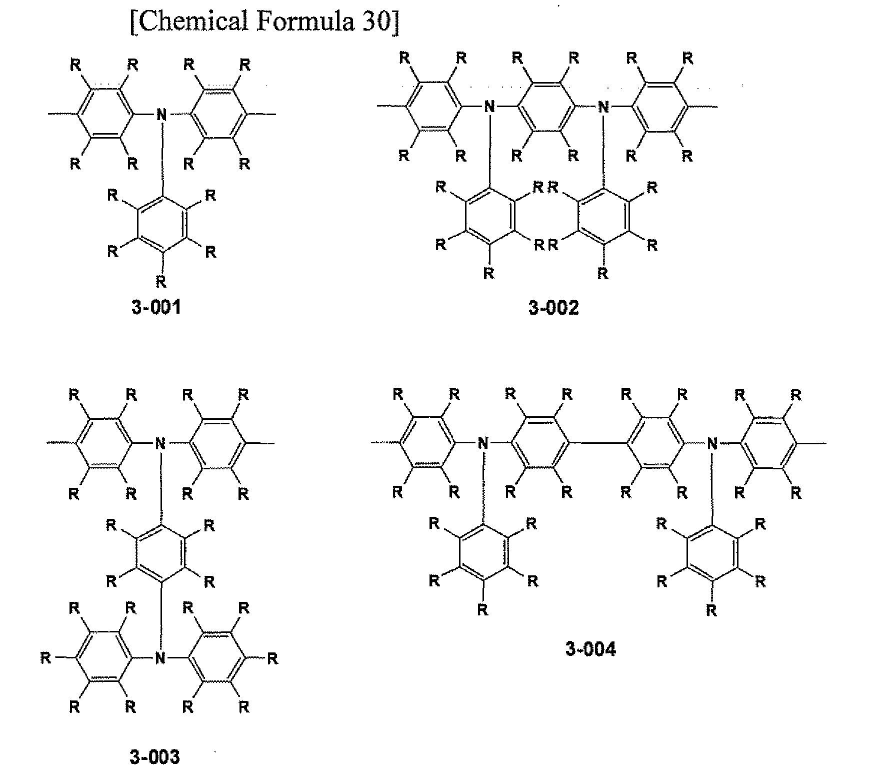

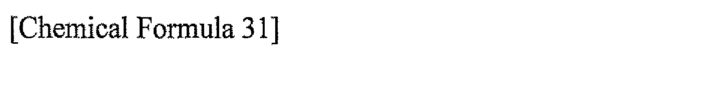

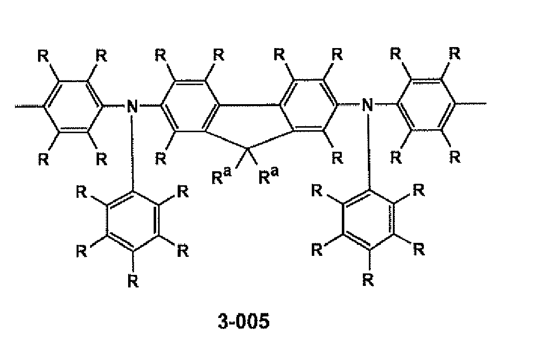

From the viewpoint of satisfactory stability of the polymer compound of this embodiment and even more satisfactory luminous efficiency for a light emitting device employing the polymer compound, the constitutional unit represented by formula (4) is preferably a group wherein R in formulas 3-001 to 3-005 above is a hydrogen atom, an alkyl group, an aryl group or a monovalent aromatic heterocyclic group, and more preferably one wherein R is a hydrogen atom or an alkyl group. R^{a} in formulas 3-001 to 3-005 is preferably an alkyl group or an aryl group.

The constitutional unit represented by formula (4) is also preferably a constitutional unit represented by any of the following formulas 3-101 to 3-105, from the viewpoint of stability of the polymer compound of this embodiment, and luminous efficiency for a light emitting device employing the polymer compound. In the formula, R and R^{a} have the same definitions as above, R' represents an alkyl group, an aryl group or a monovalent aromatic heterocyclic group, and multiple R' groups may be the same or different.

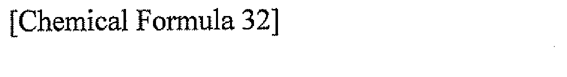

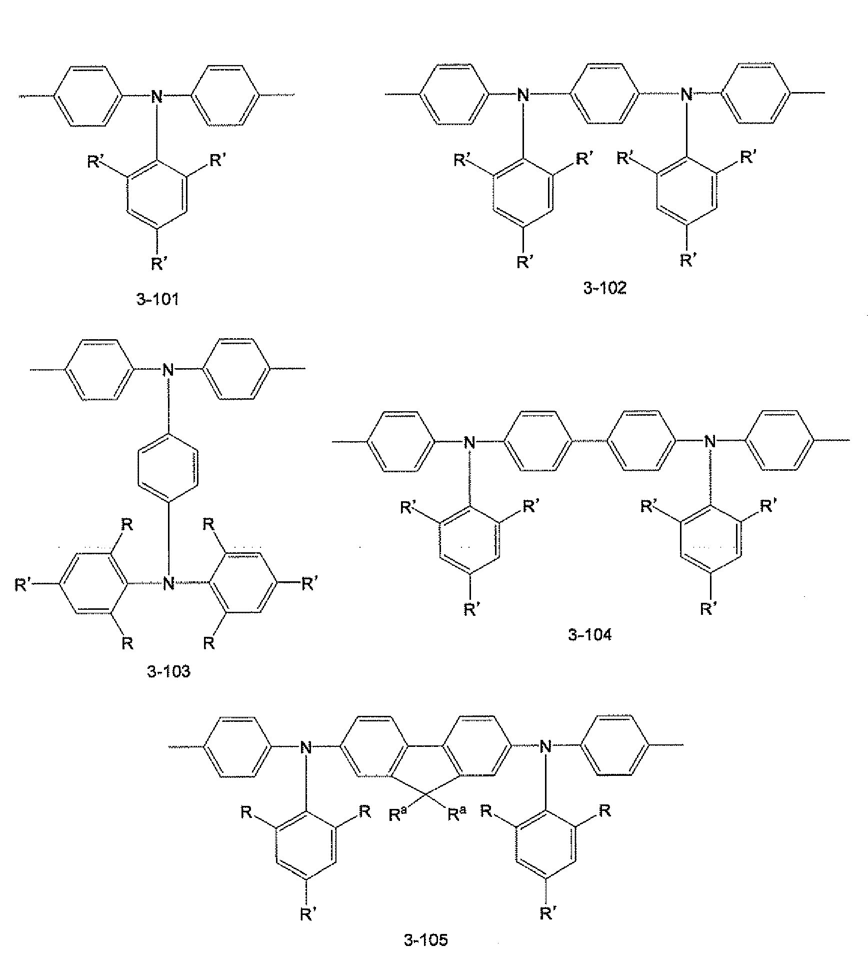

Also, from the viewpoint of stability of the polymer compound of this embodiment and luminous efficiency for a light emitting device employing the polymer compound, the constitutional unit represented by formula (4) is preferably one in which R in formulas 3-103 and 3-105 is a hydrogen atom or an alkyl group, preferably R' in formulas 3-101 to 3-105 is an alkyl group, and preferably R^{a} in formula 3-105 is an alkyl group or an aryl group. Of the constitutional units represented by formulas 3-101 to -105, the constitutional unit represented by formula 3-102, 3-104 or 3-105 is more preferably a constitutional unit represented by formula 3-102.

The constitutional unit represented by formula (4) may be a single type or two or more types in the polymer compound of this embodiment.

### [Substituents]

The group represented by -S-R^{A} may be straight-chain, branched or cyclic, and may be an alkylthio group of usually 1-20 carbon atoms or an arylthio group of usually 6₋60 carbon atoms.

The group represented by -C(=O)-R^{A} may be straight-chain, branched or cyclic, and may be an alkylcarbonyl group of usually 1-20 carbon atoms or an arylcarbonyl group of usually 6-60 carbon atoms.

The group represented by -C(=O)-O-R^{A} may be straight-chain, branched or cyclic, and may be an alkyloxycarbonyl group of usually 1-20 carbon atoms or an aryloxycarbonyl group of usually 6-60 carbon atoms.

The group represented by -N(R^{A})₂ may be an amino group substituted with 2 groups selected from the group consisting of alkyl groups with usually 1-20 carbon atoms and aryl groups with usually 6-60 carbon atoms.

### [Constitutional sequence of polymer compound of this embodiment]

From the viewpoint of more satisfactory luminous efficiency for a light emitting device employing the polymer compound, the polymer compound of this embodiment preferably comprises a constitutional sequence in which a constitutional unit represented by formula (1) and a constitutional unit represented by formula (2) are directly bonded. Such a constitutional sequence is preferably a constitutional sequence represented by the following formula (1-2) or (1-3).

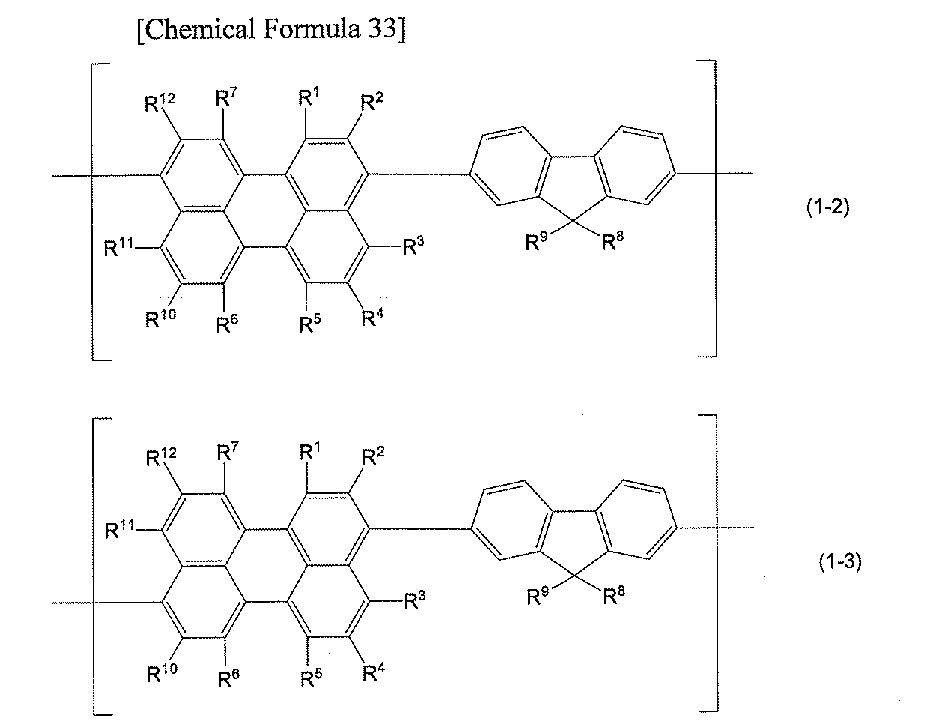

In the formulas, R¹, R², R³, R⁴, R⁵, R⁶, R⁷, R⁸ and R⁹ have the same definitions as above, and R¹⁰, R¹¹ and R¹² have the same definition as R¹ above.

From the viewpoint of more satisfactory luminous efficiency for light emitting devices, the polymer compound of this embodiment more preferably comprises a constitutional sequence represented by any of the following formulas (1-4), (1-5), (1-6), (1-7) and (1-8), and it even more preferably comprises a constitutional sequence represented by any one of formulas (1-6), (1-7) and (1-8).

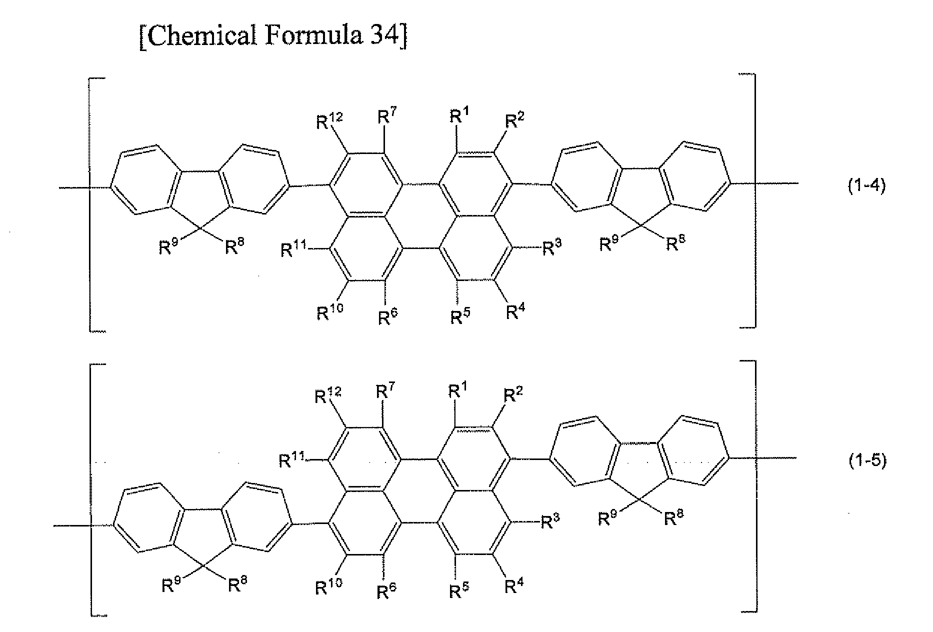

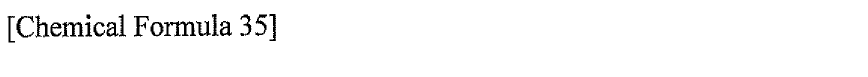

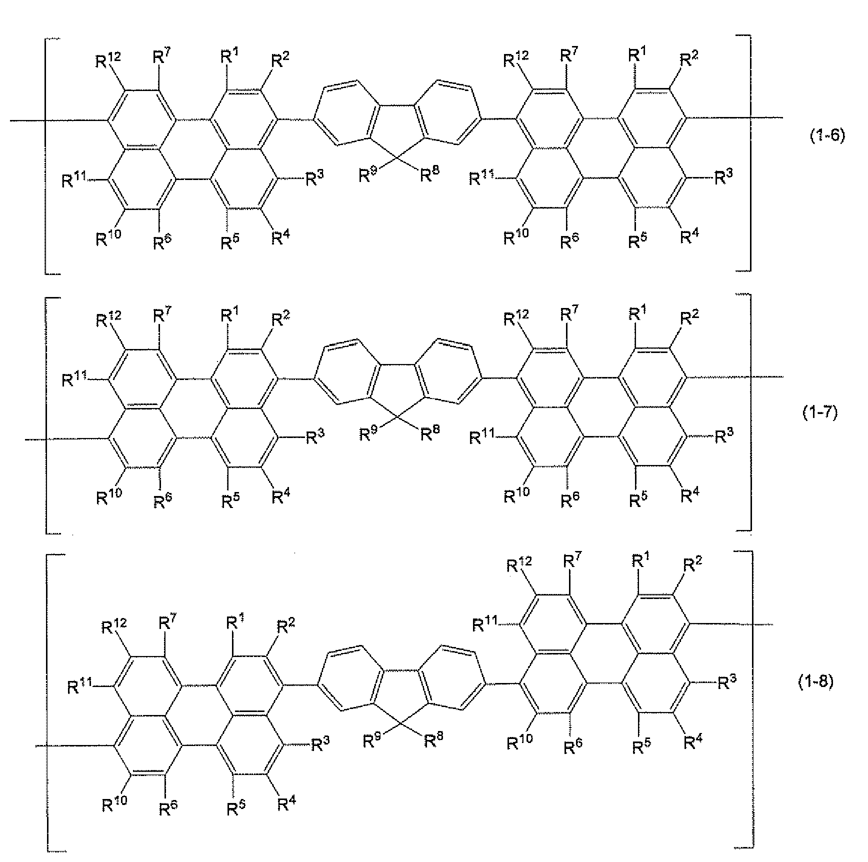

In the formulas, R¹, R², R³, R⁴, R⁵, R⁶, R⁷, R⁸ and R⁹ have the same definitions as above, and R¹⁰, R¹¹ and R¹² have the same definition as R¹ above. Multiple R¹, R², R³, R⁴, R⁵, R⁶, R⁷, R⁸, R⁹, R¹⁰, R¹¹ and R¹² groups may be the same or different.

From the viewpoint of more satisfactory luminous efficiency for light emitting devices obtained using the polymer compound, the polymer compound of this embodiment preferably has a content ratio of constitutional units represented by formula (1) that is at least 0.1 mol% and more preferably at least 0.5 mol%, based on the total content of constitutional units represented by formula (1), constitutional units represented by formula (2), constitutional units represented by formula (3) and constitutional units represented by formula (4). From the viewpoint of solubility of the polymer compound and luminous efficiency of light emitting devices obtained using the polymer compound, the aforementioned content ratio is preferably no greater than 20 mol%, more preferably no greater than 10 mol% and even more preferably no greater than 3 mol%.

The polymer compound of this embodiment preferably has a total content ratio of constitutional units represented by formula (1), constitutional units represented by formula (2), constitutional units represented by formula (3) and constitutional units represented by formula (4), that is 80 mass% or greater and more preferably 90 mass% or greater, based on the total weight of the polymer compound.

When the polymer compound of this embodiment comprises a constitutional unit represented by formula (4), the content ratio of constitutional units represented by formula (4) is preferably at least 0.5 mol% and more preferably at least 1 mol%, based on the total constitutional units represented by formula (1), constitutional units represented by formula (2), constitutional units represented by formula (3) and constitutional units represented by formula (4). Also, the content ratio is preferably no greater than 20 mol% and more preferably no greater than 10 mol%.

The polymer compound of this embodiment is preferably a polymer compound BP1, EP2 or EP3, comprising a constitutional unit represented by formula (1) (first constitutional unit), a constitutional unit represented by formula (2) (second constitutional unit), a constitutional unit represented by formula (3) (third constitutional unit), a constitutional unit represented by formula (4) (fourth constitutional unit) and another constitutional unit, in the proportions (mol%) listed in Table 1 below. In the "other constitutional unit" referred to here, one constitutional unit is one atomic group linking two constitutional units selected from the group consisting of the first constitutional unit, the second constitutional unit, the third constitutional unit and the fourth constitutional unit. The content ratio (mol%) of each constitutional unit is selected within the range in the table, for a total of 100 mol%.

**[Table 1]**

| | Constitutional units and ratios (mol%) | | | | |
|---|---|---|---|---|---|
| | Formula (1) | Formula (2) | Formula (3) | Formula (4) | Other |
| EP1 | 0.1-20 | 0.1-99.8 | 0.1-99.8 | 0 | 0-20 |
| EP2 | 0.1-20 | 40-99.4 | 0 | 0.5-20 | 0-20 |
| EP3 | 0,1-20 | 0.1-99.3 | 0.1-99.3 | 0.5-20 | 0-20 |

The polymer compound of this embodiment is preferably polymer compound EP4, EP5 or EP6 comprising each constitutional unit in the proportion listed in Table 2 below.

**[Table 2]**

| | Constitutional units and ratios (mol%) | | | | |
|---|---|---|---|---|---|
| | Formula (1) | Formula (2) | Formula (3) | Formula (4) | Other |
| EP4 | 0.5-10 | 0.5-99.4 | 0.1-99 | 0 | 0-10 |
| EP5 | 0.5-10 | 70-98.5 | 0 | 1-10 | 0-10 |
| EP6 | 0.5-10 | 0.5-98.4 | 0.1-98 | 1-10 | 0-10 |

The polymer compound of this embodiment is more preferably polymer compound EP7, EP8 or EP9 comprising each constitutional unit in the proportion listed in Table 3 below.

**[Table 3]**

| | Constitutional units and ratios (mol%) | | | | |
|---|---|---|---|---|---|
| | Formula (1) | Formula | Formula (3) | Formula (4) | Other |
| EP7 | 0.5-3 | (2) 0.5-99.4 | 0.1-99 | 0 | 0 |
| EP8 | 0.5-3 | 87-98.5 | 0 | 1-10 | 0 |
| EP9 | 0.5-3 | 0.5-98.4 | 0.1-98 | 1-10 | 0 |

Preferred examples of polymer compounds EP7, EP8 and EP9 are the following. The examples of polymer compounds indicate the constitutional units composing them, and the proportion (mol%) of each constitutional unit. Preferred examples for polymer compound EP7 are the following.

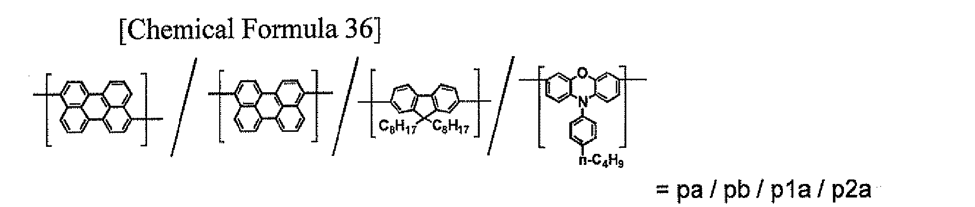

[In the formula, pa and pb are each 0-3 mol%, pa+pb is 0.5-3 mol%, p1a is 0.5-99.4 mol%, p2a is 0.1-99 mol% and pa+pb+pla+p2a is 100 mol%.]

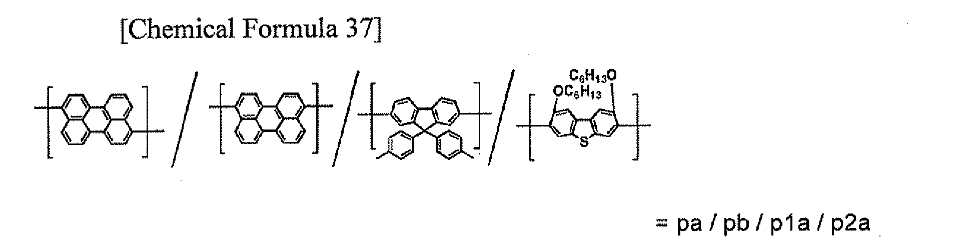

[In the formula, pa and pb are each 0-3 mol%, pa+pb is 0.5-3 mol%, p1a is 0.5-99.4 mol%, p2a is 0.1-99 mol% and pa+pb+p1a+p2a is 100 mol%.]

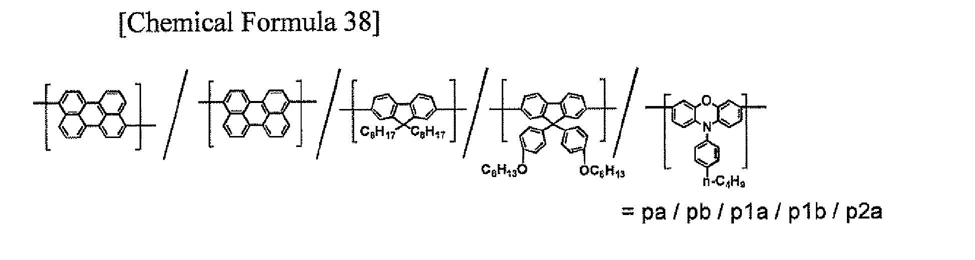

[In the formula, pa and pb are each 0-3 mol%, pa+pb is 0.5-3 mol%, p1a and p1b are each 0-99.4 mol%, p1a+p1b is 0.5-99.4 mol%, p2a is 0.1-99 mol% and pa+pb+p1a+p1b+p2a is 100 mol%.]

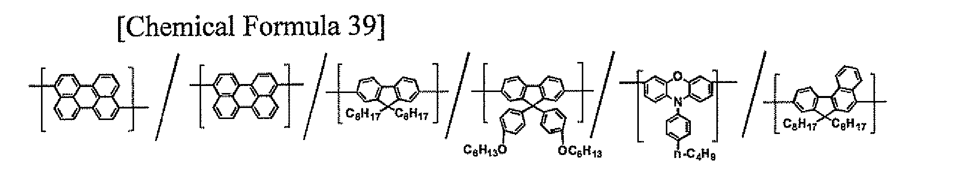

= pa/pb/p1a/p1b/p2a/p2b [In the formula, pa and pb are each 0-3 mol%, pa+pb is 0.5-3 mol%, p1a and p1b are each 0-99,4 mol%, p1a+p1b is 0.5-99.4 mol%, p2a and p2b are each 0-99 mol%, p2a+p2b is 0.1-99 mol% and pa+pb+p1a+p1b+p2a is 100 mol%.]

Preferred examples for polymer compound EP8 are the following.

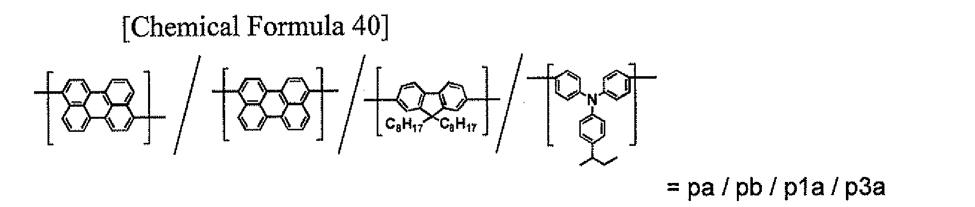

[In the formula, pa and pb are each 0-3 mol%, pa+pb is 0.5-3 mol%, p1a is 87-98.5 mol%, p3a is 1-10 mol% and pa+pb+p1a+p3a is 100 mol%.]

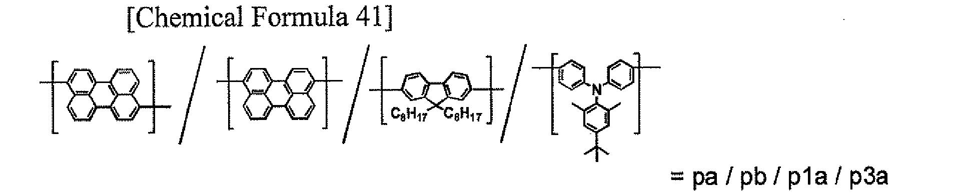

[In the formula, pa and pb are each 0-3 mol%, pa+pb is 0.5-3 mol%, p1a is 87-98.5 mol%, p3a is 1-10 mol% and pa+pb+p1a+p3a is 100 mol%.]

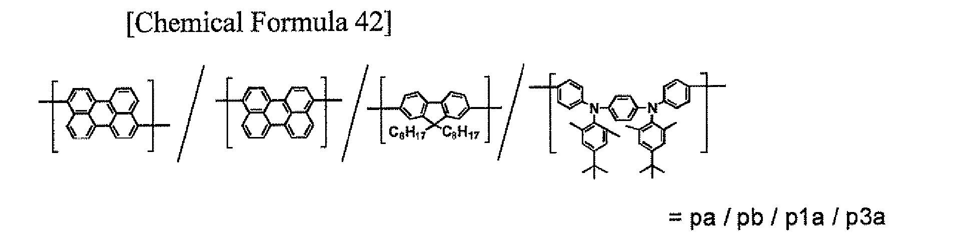

[In the formula, pa and pb are each 0-3 mol%, pa+pb is 0.5-3 mol%, p1a is 87-98.5 mol%, p3a is 1-10 mol% and pa+pb+p1a+p3a is 100 mol%.]

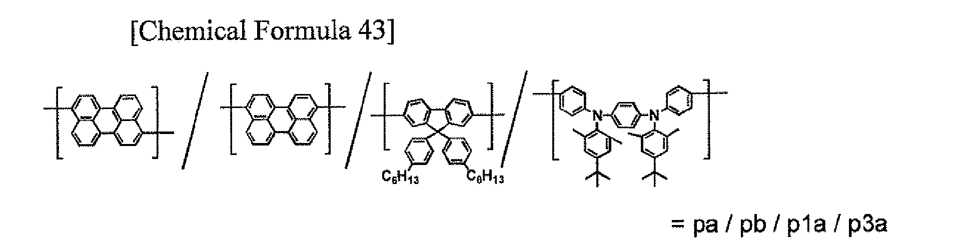

[In the formula, pa and pb are each 0-3 mol%, pa+pb is 0.5-3 mol%, p1a is 87-98.5 mol%, p3a is 1-10 mol% and pa+pb+p1a+p3a is 100 mol%.]

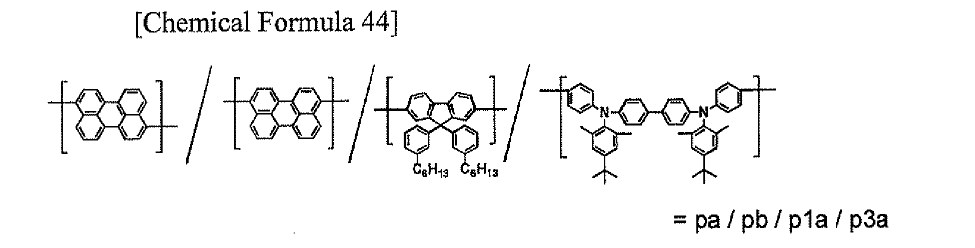

[In the formula, pa and pb are each 0-3 mol%, pa+pb is 0.5-3 mol%, p1a is 87-98.5 mol%, p3a is 1-10 mol% and pa+pb+p1a+p3a is 100 mol%.]

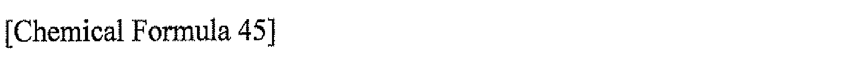

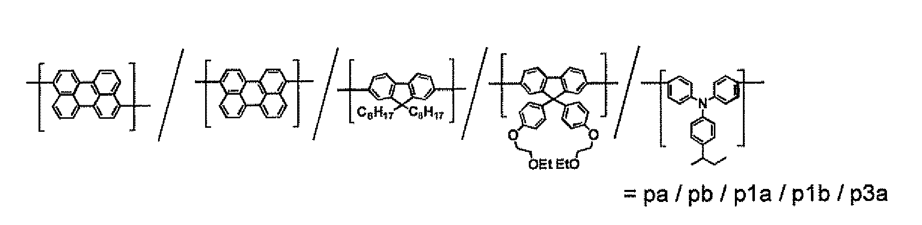

[In the formula, pa and pb are each 0-3 mol%, pa+pb is 0.5-3 mol%, p1a and p1b are each 0-98.5 mol%, p1a+p1b is 87-98.5 mol%, p3a is 1-10 mol% and pa+pb+p1a+p1b+p3a is 100 mol%.]

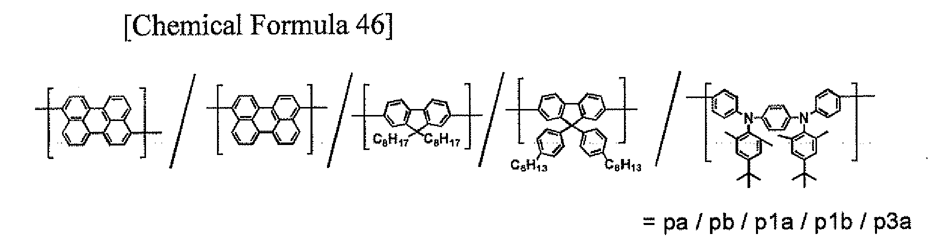

[In the formula, pa and pb are each 0-3 mol%, pa+pb is 0.5-3 mol%, p1a and p1b are each 0-98.5 mol%, p1a+p1b is 87-98.5 mol%, p3a is 1-10 mol% and pa+pb+pla+plb+p3a is 100 mol%.]

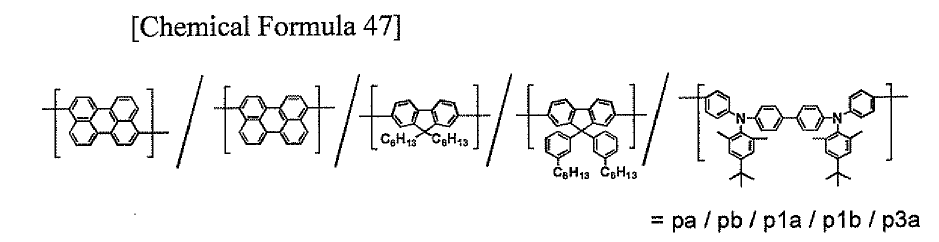

[In the formula, pa and pb are each 0-3 mol%, pa+pb is 0.5-3 mol%, p1a and p1b are each 0-98.5 mol%, p1a+p1b is 87-98.5 mol%, p3a is 1-10 mol% and pa+pb+p1a+p1b+p3a is 100 mol%.]

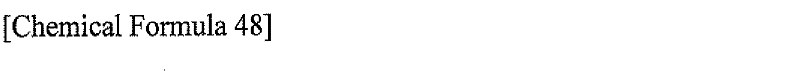

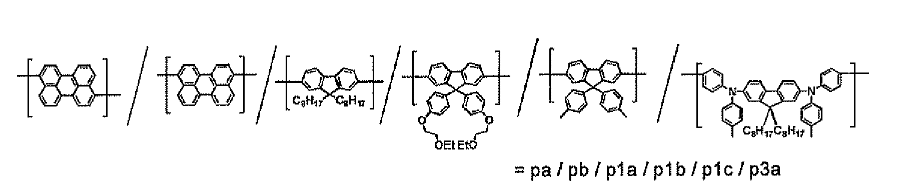

[In the formula, pa and pb are each 0-3 mol%, pa+pb is 0.5-3 mol%, p1a, p1b and p1c are each 0-98.5 mol%, p1a+p1b+p1c is 87-98.5 mol%, p3a is 1-10 mol% and pa+pb+p1a+p1b+p1c+p3a is 100 mol%.]

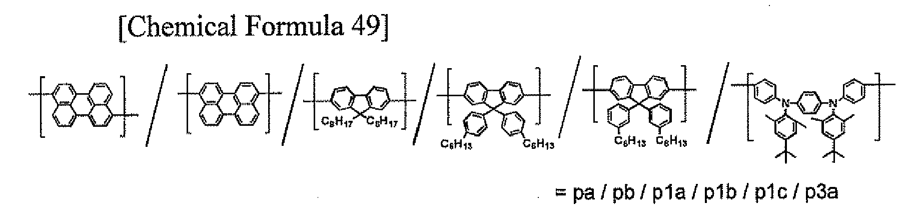

[In the formula, pa and pb are each 0-3 mol%, pa+pb is 0.5-3 mol%, p1a, p1b and p1c are each 0-98.5 mol%, p1a+p1b+p1c is 87-98.5 mol%, p3a is 1-10 mol% and pa+pb+p1a+p1b+p1c+p3a is 100 mol%.]

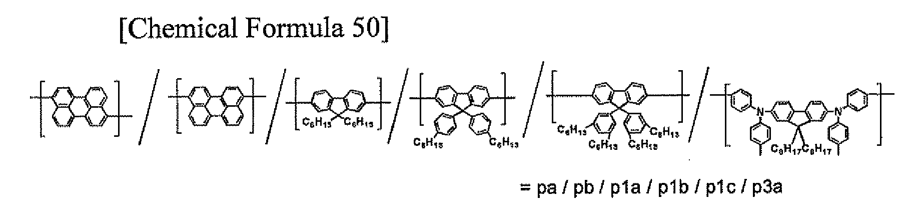

[In the formula, pa and pb are each 0-3 mol%, pa+pb is 0.5-3 mol%, p1a, p1b and p1c are each 0-98.5 mol%, p1a+p1b+p1c is 87-98.5 mol%, p3a is 1-10 mol% and pa+pb+p1a+p1b+p1c+p3a is 100 mol%.]

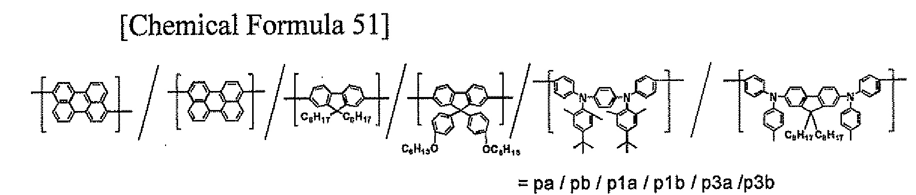

[In the formula, pa and pb are each 0-3 mol%, pa+pb is 0.5-3 mol%, p1a and p1b are each 0-98.5 mol%, p1a+p1b is 87-98.5 mol%, p3a and p3b are each 0-10 mol%, p3a+p3b is 1-10 mol% and pa+pb+p1a+p1b+p3a+p3b is 100 mol%.]

Preferred examples for polymer compound EP9 are the following.

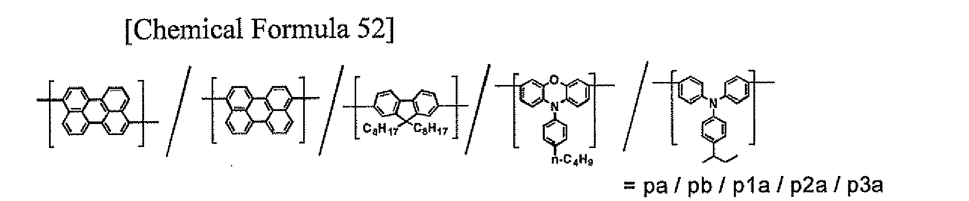

[In the formula, pa and pb are each 0-3 mol%, pa+pb is 0.5-3 mol%, p1a is 0.5-98.4 mol%, p2a is 0.1-98 mol%, p3a is 1-10 mol% and pa+pb+p1a+p2a+p3a is 100 mol%.]

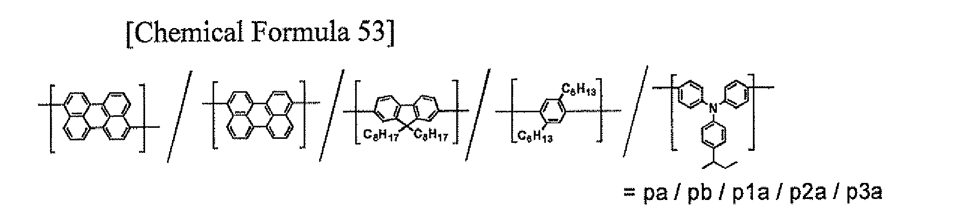

[In the formula, pa and pb are each 0-3 mol%, pa+pb is 0.5-3 mol%, p1a is 0.5-98.4 mol%, p2a is 0.1-98 mol%, p3a is 1-10 mol% and pa+pb+p1a+p2a+p3a is 100 mol%.]

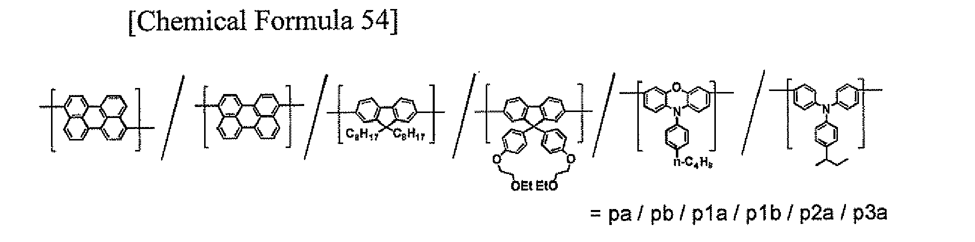

[In the formula, pa and pb are each 0-3 mol%, pa+pb is 0.5-3 mol%, p1a and p1b are each 0-98.4 mol%, p1a+p1b is 0.5-98.4 mol%, p2a is 0.1-98 mol%, p3a is 1-10 mol% and pa+pb+p1a+p1b+p2a+p3a is 100 mol%.]

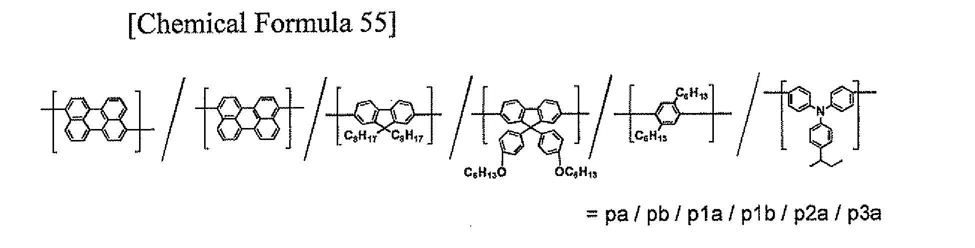

[In the formula, pa and pb are each 0-3 mol%, pa+pb is 0.5-3 mol%, p1a and p1b are each 0-98.4 mol%, p1a+p1b is 0.5-98.4 mol%, p2a is 0.1-98 mol%, p3a is 1-10 mol% and pa+pb+p1a+p1b+p2a+p3a is 100 mol%.]

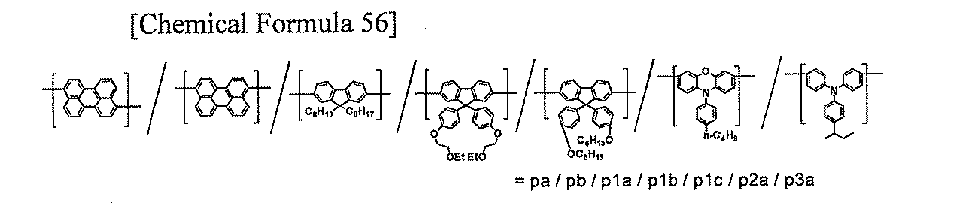

[In the formula, pa and pb are each 0-3 mol%, pa+pb is 0.5-3 mol%, p1a, p1b and p1c are each 4-98.4 mol%, p1a+p1b+p1c is 0.5-98.4 mol%, p2a is 0.1-98 mol%, p3a is 1-10 mol% and pa+pb+p1a+p1b+p1c+p2a+p3a is 100 mol%.]

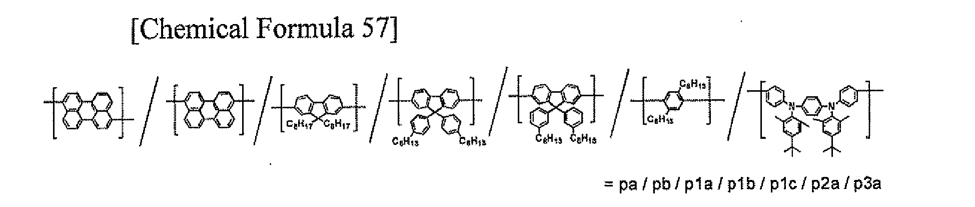

[In the formula, pa and pb are each 0-3 mol%, pa+pb is 0.5-3 mol%, p1a, p1b and p1c are each 0-98.4 mol%, p1a+p1b+p1c is 0.5-98.4 mol%, p2a is 0.1-98 mol%, p3a is 1-10 mol% and pa+pb+p1a+p1b+p1c+p2a+p3a is 100 mol%.]

When polymerizing active groups remain on the end groups in the polymer compound of this embodiment, the luminescence property and usable life of the light emitting device may potentially be reduced when the polymer compound is used. The end groups are therefore preferably stable groups (for example, aryl groups or monovalent aromatic heterocyclic groups).

The polymer compound of this embodiment may have any desired form, such as a linear polymer, branched polymer, hyperbranched polymer, cyclic polymer, comb polymer, star polymer, network polymer or the like. The polymer may also have any desired composition or regularity, such as that of a homopolymer, alternating copolymer, periodic copolymer, random copolymer, block copolymer or graft copolymer, in different forms.

The polymer compound of this embodiment is useful as a light emitting material, charge transporting material or the like, and when used it may be used in combination with other compounds as the polymer composition described below.

The number-average molecular weight (Mn) of the polymer compound of this embodiment based on polystyrene, as measured by gel permeation chromatography (hereinafter, "GPC") is usually 1 × 10³ to 1 × 10⁸ and is preferably 1 × 10⁴ to 1 × 10⁶. The weight-average molecular weight (Mw) of the polymer compound of this embodiment based on polystyrene is usually 1 × 10³ to 1 × 10⁸, and from the viewpoint of satisfactory film formability and more satisfactory luminous efficiency of light emitting devices obtained from the polymer compound, it is preferably 1 × 10⁴ to 5 × 10⁶, more preferably 3 × 10⁴ to 1 × 10⁶ and even more preferably 5 × 10⁴ to 5 × 10⁵.

From the viewpoint of durability in various processes for fabrication of light emitting devices and the like, and more satisfactory stability and heat resistance against heat release during operation of light emitting devices, the glass transition temperature of the polymer compound of this embodiment is usually about 70°C or higher, and is preferably 100°C or higher. Throughout the present specification, the glass transition temperature will sometimes be abbreviated as "Tg".

The polymer compound of this embodiment normally emits fluorescence or phosphorescence in a solid state, and it is useful as a material for a light emitting device. A light emitting device employing such a polymer compound is a high-performance light emitting device capable of driving with high luminous efficiency. Consequently, the light emitting device is useful for a display device, such as a liquid crystal display backlight, curved or flat light source for illumination, segment type display device, dot matrix flat panel display, or the like. In addition, the polymer compound of this embodiment may be used as a laser pigment, an organic solar cell material, an organic semiconductor for an organic transistor, a material for a conductive film such as an electric conductive film or organic semiconductor film, or a luminescent film material that emits fluorescence or phosphorescence.

### <Method for producing polymer compound>

The polymer compound of this embodiment may be synthesized, for example, by dissolving a compound represented by the following formula (M-1) (first monomer), a compound represented by the following formula (M-2) (second monomer), a compound represented by the following formula (M-3) (third monomer) and/or a compound represented by the following formula (M-4) (fourth monomer), in an organic solvent as necessary, accomplishing copolymerization by a polymerization method such as known aryl-aryl coupling using an alkali or a suitable catalyst and ligand.

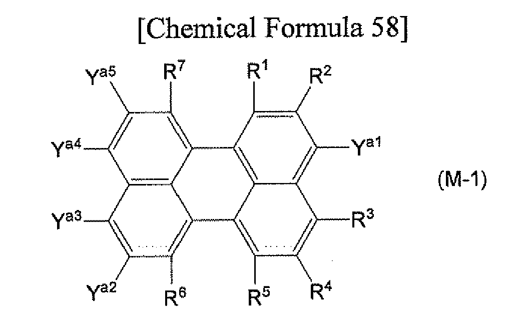

In formula (M-1), R¹, R²*,* R³, R⁴, R⁵, R⁶ and R⁷ each independently represent a hydrogen atom, an alkyl group, an aryl group, a monovalent aromatic heterocyclic group or a group represented by -O-R^{A}, Y^{a1} represents a first polymerizable group which is a group selected from the group consisting of the following substituent group A and the following substituent group B, and any one of Y^{a2}, Y^{a3}, Y^{a4} and Y^{a5} represents a second polymerizable group which is a group selected from the group consisting of the following substituent group A and the following substituent group B, while the remaining three each independently represent a hydrogen atom, an alkyl group, an aryl group, a monovalent aromatic heterocyclic group or a group represented by -O-R^{A}. R^{A} is an alkyl group, an aryl group or a monovalent aromatic heterocyclic group, R¹ R², R³, R⁴, R⁵, R⁶, R⁷, Y^{a2}, Y^{a3}, Y^{a4}, Y^{a5} and R^{A} each may have a substituent, and when there are multiple R^{A} groups, the R^{A} groups may be the same or different.

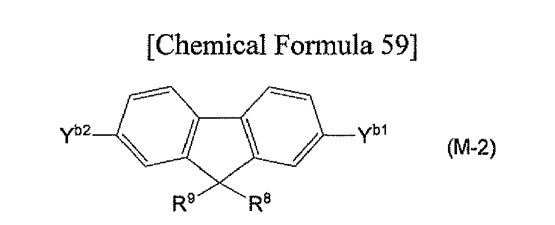

In formula (M-2), R⁸ and R⁹ each independently represent an alkyl group, an aryl group or a monovalent aromatic heterocyclic group, and these groups each may have substituent. Y^{b1} and Y^{b2} each independently represent a group selected from the group consisting of the substituent group A and the substituent group B. Preferably, when the first polymerizable group and the second polymerizable group in formula (M-1) above are both groups selected from the substituent group A, at least one of Y^{b1} and Y^{b2} is a group selected from the substituent group B, and when the first polymerizable group and the second polymerizable group are both groups selected from the substituent group B, at least one of Y^{b1} and Y^{b2} is a group selected from the substituent group A.

[Chemical Formula 60] Y^{c2}-Ar¹-Y^{c1} (M-3)

In formula (M-3), Ar¹ has the same definition as Ar¹ in formula (3), and Y^{c1} and Y^{c2} each independently represent a group selected from the group consisting of the substituent group A and the substituent group B.

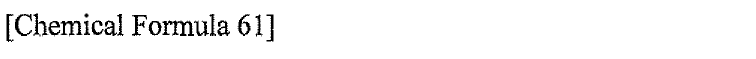

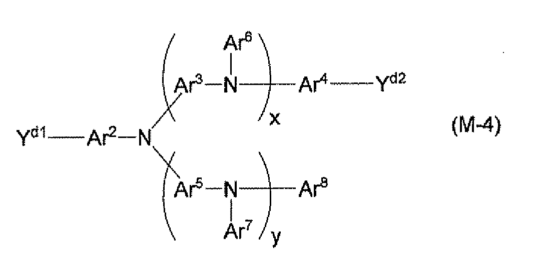

In formula (M-4), x and y each independently represent 0 or 1, Ar², Ar³, Ar⁴, Ar⁵, Ar⁶, Ar⁷ and Ar⁸ have the same respective definitions as Ar², Ar³, Ar⁴, Ar⁵, Ar⁶, Ar⁷ and Ar⁸ in formula (4), and Y^{d1} and Y^{d2} each independently represent a group selected from the group consisting of the substituent group A and the substituent group B below.
(Substituent group A)

A chlorine atom, a bromine atom, an iodine atom and groups represented by -O-S(=O)₂R²⁰, wherein R²⁰ represents an alkyl group, or an aryl group optionally substituted with an alkyl group, an alkoxy group, a nitro group, a fluorine atom or a cyano group.

### (Substituent group B)

Groups represented by -B(OR²¹)₂, wherein R²¹ represents a hydrogen atom or an alkyl group, and the two R²¹ groups may be the same or different and may be bonded together to form a ring, groups represented by -BF₄Q¹ wherein Q¹ represents a monovalent cation of lithium, sodium, potassium, rubidium or cesium, groups represented by -Sn(R²²)₃, wherein R²² represents a hydrogen atom or an alkyl group, and the three R²² groups may be the same or different and may be bonded together to form a ring, groups represented by -MgY¹, wherein Y¹ represents a chlorine atom, a bromine atom or an iodine atom and groups represented by -ZnY², wherein Y² represents a chlorine atom, a bromine atom or an iodine atom.

In the method for producing a polymer compound according to this embodiment, the compound represented by formula (M-1) may be a mixture of 2 or more selected from the group consisting of compounds wherein Y^{a2} is a second polymerizable group, compounds wherein Y^{a3} is a second polymerizable group, compounds wherein Y^{a4} is a second polymerizable group and compounds wherein Y^{a5} is a second polymerizable group.

The compound represented by formula (M-1) is preferably a compound wherein Y^{a3} or Y^{a4} is a second polymerizable group. With a polymer compound obtained in this manner, it is possible to produce a light emitting device with more excellent luminous efficiency.

Examples of alkyl groups for R²⁰, R²¹ and R²² include the same alkyl groups for R¹ in formula (1). The number of carbon atoms of each of the alkyl groups is usually 1-20, preferably 1-15 and more preferably 1-10.

Examples of aryl groups for R²⁰ include the same aryl groups for R¹ in formula (1), but from the viewpoint of ease of synthesizing the polymer compound and high reactivity during polymerization, a phenyl group, a 4-tolyl group, a 4-methoxyphenyl group, a 4-nitrophenyl group, a 3-nitrophenyl group, a 2-nitrophenyl group and a 4-trifluoromethylphenyl group are preferred.

Groups represented by -O-S(=O)₂R²⁰ include a methanesulfonyloxy group, a trifluoromethanesulfonyloxy group, a phenylsulfonyloxy group, a 4-methylphenylsulfonyloxy group and a 4-trifluoromethylphenylsulfonyloxy group.

Groups represented by -B(OR²¹)₂ include groups represented by the following formula.

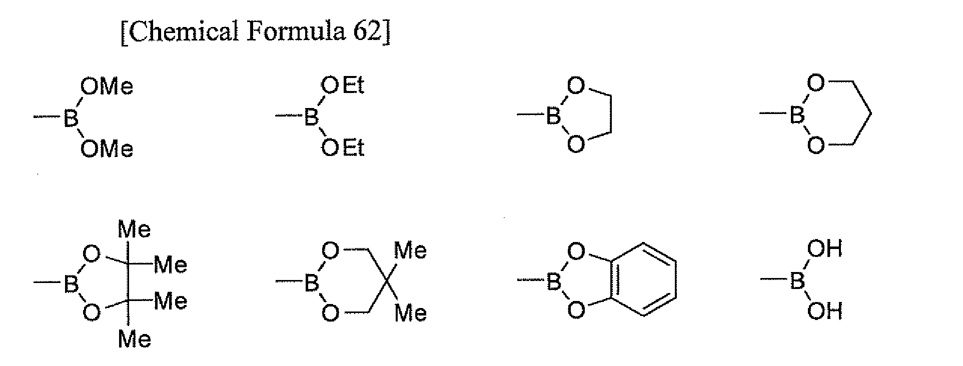

Groups represented by -BF₄Q¹ include groups represented by -BF₄⁻K⁺, for example.

Groups represented by -Sn(R²²)₃ include a trimethylstannyl group, a triethylstannyl group and a tributylstannyl group.

The first monomer, second monomer, third monomer and fourth monomer may be previously synthesized and isolated, or they may be synthesized in the reaction system and used directly. When the obtained polymer compound is to be used in a light emitting device, its purity will affect the performance of the light emitting device. Therefore, these monomers are preferably purified by a method such as distillation, sublimation purification or recrystallization.

The polymerization method may be a method of polymerization by Suzuki coupling reaction (Chem. Rev. Vol.95, p.2457-2483(1995)), a method of polymerization by Grignard reaction (Bull. Chem. Soc. Jpn., Vol.51, p.2091(1978)), a method of polymerization with a Ni(0) catalyst (Progress in Polymer Science, Vol.17, p.1153-1205, 1992), or a method of polymerization by Stille coupling reaction (European Polymer Journal Vo1.41, p.2923-2933(2005)). Of these methods, polymerization by Suzuki coupling reaction and polymerization with a Ni(0) catalyst are preferred from the viewpoint of ease of starting material synthesis and convenience of the polymerization reaction procedure, while from the viewpoint of easier control of the polymer compound structure, methods of polymerization by aryl-aryl cross-coupling reaction such as Suzuki coupling reaction, Grignard reaction or Stille coupling reaction are preferred, and polymerization reaction by Suzuki coupling reaction is especially preferred.

The group selected from the group consisting of substituent group A and substituent group B may be selected as an appropriate group for the type of polymerization reaction, and when a method of polymerization by Suzuki coupling reaction is employed, the group selected from the substituent group A is preferably a chlorine atom, a bromine atom or an iodine atom, and more preferably a bromine atom, and the group selected from the substituent group B is preferably a group represented by -B(OR²¹)₂, from the viewpoint of convenience of synthesis and ease of handling the compounds.

The polymerization method may be a method of reacting the first monomer, the second monomer, and the third monomer and/or fourth monomer, with an appropriate catalyst or base as necessary. When a method of polymerization by Suzuki coupling reaction is selected, the ratio of the total number of moles of the group selected from the substituent group A (for example, chlorine, iodine or bromine), and the total number of moles of the group selected from the substituent group B (for example, -B(OR²¹)₂) in the first monomer, second monomer, third monomer and fourth monomer is preferably adjusted to obtain a polymer compound with the desired molecular weight. For most purposes, the ratio of the number of moles of the latter with respect to the number of moles of the former is preferably 0.95-1.05, more preferably 0.98-1.02 and even more preferably 0.99-1.01.

In the method for producing a polymer compound according to this embodiment, the charging ratio of the compound represented by formula (M-1) with respect to the total monomers is preferably 0.1 mol% or greater and no greater than 20 mol%. This will allow easy production of a polymer compound in which the proportion of the constitutional unit represented by formula (1) with respect to the total constitutional units is between 0.1 mol% and 20 mol%.

For production of the polymer compound, the weight ratio of the first monomer, second monomer, third monomer and fourth monomer with respect to the total monomers, excluding substituents participating in polymerization, is preferably 80 mass% or greater. This will allow easy synthesis of a polymer compound in which the total of each of the content ratios of the first constitutional unit, second constitutional unit, third constitutional unit and fourth constitutional unit with respect to the total constitutional units composing the polymer compound is 80 mass% or greater.

The method for producing a "polymer compound comprising a constitutional sequence in which the first constitutional unit and second constitutional unit are linked", as a preferred embodiment of the polymer compound of the invention, is polymerization by aryl-aryl cross-coupling reaction, and synthesis may be accomplished by selecting the polymerizable groups of the corresponding monomers (first monomer and second monomer) so as to allow direct bonding between the first constitutional unit and second constitutional unit.

Specifically, for polymerization by Suzuki coupling reaction, the first monomer is a compound in which the first polymerizable group and second polymerizable group are groups represented by -B(OR²¹)₂ or groups represented by -BF₄Q¹, and the second monomer is a compound in which Y^{b1} and Y^{b2} are chlorine atoms, bromine atoms or iodine atoms. Also preferred is for the first monomer to be a compound in which the first polymerizable group and second polymerizable group are chlorine atoms, bromine atoms or iodine atoms and for the second monomer to be a compound in which Y^{b1} and Y^{b2} are groups represented by -B(OR²¹)₂ or groups represented by -BF₄Q¹. Using such monomers will result in direct bonding between the first constitutional unit and second constitutional unit since the Suzuki coupling reaction will be a cross-coupling reaction.

When the first polymerizable group and second polymerizable group are groups represented by -B(OR²¹)₂ or groups represented by -BF₄Q¹ and Y^{b1} and Y^{b2} are chlorine atoms, bromine atoms or iodine atoms, in production of the polymer compound, the charging ratio of the second monomer is preferably at least 50 mol%, more preferably at least 80 mol% and even more preferably 100 mol%, with respect to 100 mol% as the total charging amount of monomers with chlorine atoms, bromine atoms or iodine atoms as polymerizable groups, among the total monomers.

Similarly, when the first polymerizable group and second polymerizable group are chlorine atoms, bromine atoms or iodine atoms and Y^{b1} and Y^{b2} are groups represented by -B(OR²¹)₂ or groups represented by -BF₄Q¹, in production of the polymer compound, the charging ratio of the second monomer is preferably at least 50 mol%, more preferably at least 80 mol% and even more preferably 100 mol%, with respect to 100 mol% as the total charging amount of monomers with groups represented by -B(OR²¹)₂ or groups represented by -BF₄Q¹ as polymerizable groups, among the total monomers.

The method for producing a "polymer compound comprising a constitutional sequence in which the first constitutional unit and second constitutional unit are linked", as a preferred embodiment of the polymer compound of the invention, may alternatively be a method of polymerization of 2 or more different monomers including a monomer having a constitutional sequence in which the first constitutional unit and second constitutional unit are directly bonded, and at least one type of monomer selected from the group consisting of the third monomer and fourth monomer. Monomers having a constitutional sequence in which the first constitutional unit and second constitutional unit are directly bonded include compounds represented by the following formula (M-5) (hereunder also referred to as "fifth monomer").

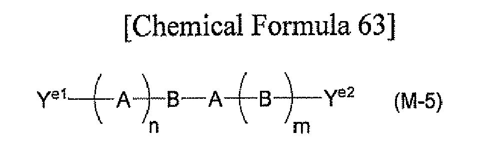

In formula (M-5), A represents a group represented by the following formula (m-1), B represents a group represented by the following formula (m-2), m and n each independently represent 0 or 1, and Y^{e1} and Y^{e2} each independently represent a group selected from the group consisting of substituent group A and substituent group B. For m and n, from the viewpoint of luminous efficiency, preferably m = 0 and n = 0 or 1, and from the viewpoint of luminous efficiency and ease of monomer synthesis, preferably m = 0 and n = 1.

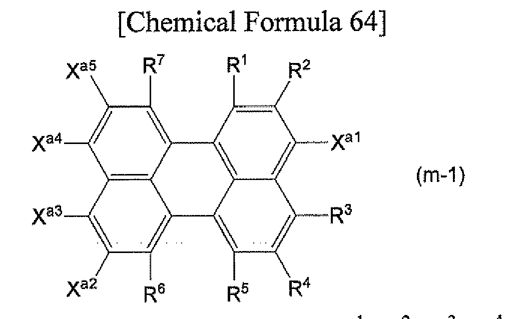

In formula (m-1), R¹, R², R³, R⁴, R⁵, R⁶ and R⁷ have the same definitions as R¹, R², R³, R⁴, R⁵, R⁶ and R⁷ above, X^{a1} represents a binding site to B, Y^{e1} or Y^{e2} above, and one of X^{a2}, X^{a3}, X^{a4} and X^{a5} represents a binding site to B, Y^{e1} or Y^{e2} while the remaining three each independently represent a hydrogen atom, or the same alkyl, aryl, monovalent aromatic heterocyclic or -O-R^{A} groups in X², X³, X⁴ and X⁵ above. R^{A} has the same definition as R^{A} mentioned above, and when there are multiple R^{A} groups, the R^{A} groups may be the same or different.

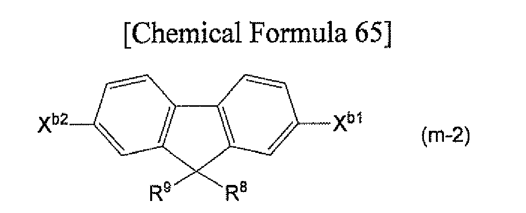

In formula (m-2), R⁸ and R⁹ have the same respective definitions as R⁸ and R⁹ above, and X^{b1} and X^{b2} each independently represent a binding site to A, Y^{e1} or Y^{e2} above.

The fifth monomer is preferably a compound represented by any of the following formulas (M-a) to (M-g), and from the viewpoint of luminous efficiency of a light emitting device employing a polymer compound synthesized using the monomer, it is more preferably a compound represented by formula (M-e), (M-f) or (M-g).

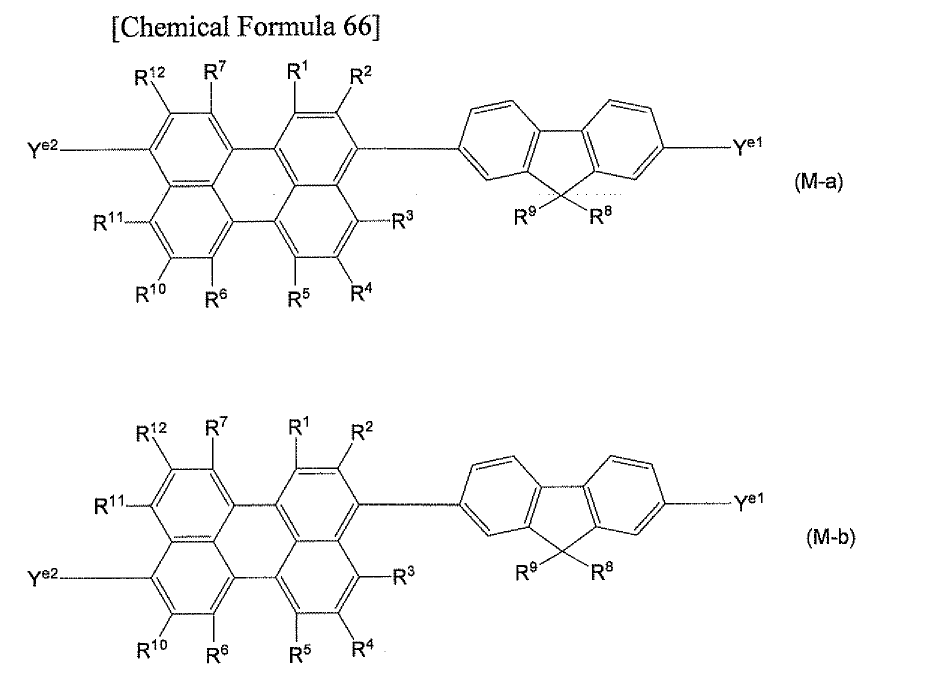

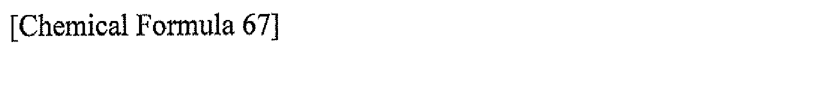

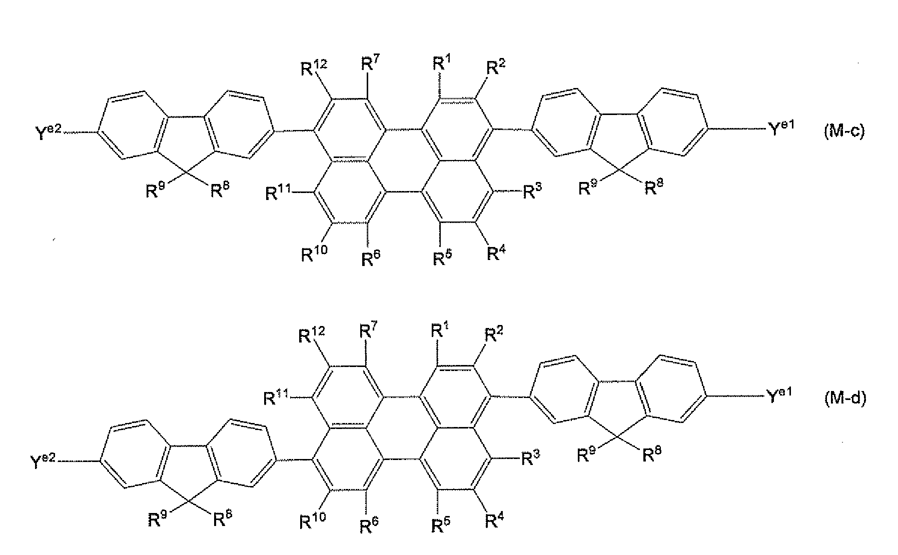

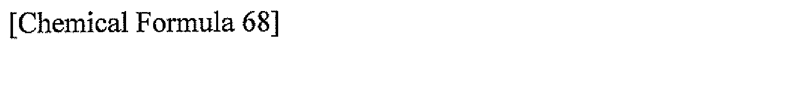

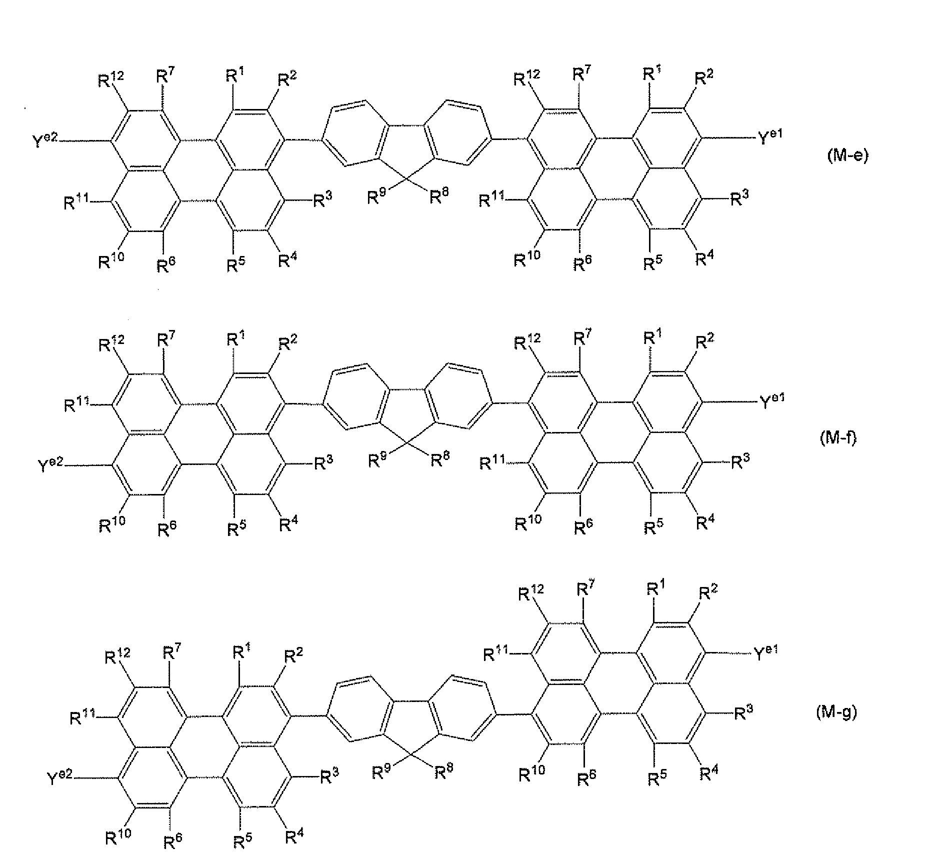

In the formulas, R¹, R² R³ R⁴ R⁵ R⁶ R⁷ R⁸ R⁹ Y^{e1} and Y^{e2} have the same definitions as above, and R¹⁰, R¹¹ and R¹² have the same definitions as R², R³ and R⁴ above, respectively. Multiple R¹, R², R³, R⁴, R⁵, R⁶, R⁷, R⁸, R⁹, R¹⁰, R¹¹ and R¹² groups may be the same or different.

In the method for producing a polymer compound according to this embodiment, the monomers are preferably polymerized in the presence of a catalyst. For polymerization by Suzuki coupling reaction, the catalyst may be a transition metal complex, for example a palladium complex such as palladium [tetrakis(triphenylphosphine)], [tris(dibenzylideneacetone)]dipalladium, palladium acetate or dichlorobistriphenylphosphinepalladium, or a complex in which a ligand such as triphenylphosphine, tri-tert-butylphosphine or tricyclohexylphosphine is coordinated with these transition metal complexes.

For polymerization with a Ni(0) catalyst, the Ni(0) catalyst may be a transition metal complex, for example a nickel complex such as nickel [tetrakis(triphenylphosphine)], [1,3-bis(diphenylphosphino)propane]dichloronickel or [bis(1,4-cyclooctadiene)]nickel, or a complex in which a ligand such as triphenylphosphine, tri-tert-butylphosphine, tricyclohexylphosphine, diphenylphosphinopropane or bipyridyl is coordinated with these transition metal complexes.

The catalyst may be synthesized beforehand or prepared in the reaction system and used directly. These catalysts may be used alone or in combinations of two or more.

The amount of catalyst used may be an amount that is effective as a catalyst, and for example, it is usually 0.0001-300 mol%, preferably 0.001-50 mol% and more preferably 0.01-20 mol%, in terms of the number of moles of the transition metal with respect to 100 mol% as the total of all of the monomers in the polymerization reaction.

For polymerization by Suzuki coupling reaction it is preferred to use a base, with bases including inorganic bases such as sodium carbonate, potassium carbonate, cesium carbonate, potassium fluoride, cesium fluoride and tripotassium phosphate, and organic bases such as tetrabutylammonium fluoride, tetrabutylammonium chloride, tetrabutylammonium bromide, tetraethylammonium hydroxide and tetrabutylammonium hydroxide.

The amount of base used is usually 50-2000 mol% and preferably 100-1000 mol% with respect to 100 mol% as the total of all of the monomers in the polymerization reaction.

The polymerization reaction may be carried out in the absence of a solvent or in the presence of a solvent, but it is usually carried out in the presence of an organic solvent. The organic solvent may be toluene, xylene, mesitylene, tetrahydrofuran, 1,4-dioxane, dimethoxyethane, N,N-dimethylacetamide, N,N-dimethylformamide or the like. In order to minimize secondary reactions, the solvent is generally preferred to be one that has been subjected to deoxidizing treatment. Such organic solvents may be used alone or in combinations of two or more.

The amount of organic solvent used is preferably an amount for a total concentration of 0.1-90 weight%, more preferably 1-50 weight% and even more preferably 2-30 weight% for the total monomers in the polymerization reaction.

The reaction temperature for the polymerization reaction is preferably between -100 and 200°C, more preferably between -80 and 150°C and even more preferably between 0 and 120°C. The reaction time is usually at least 1 hour, and is preferably 2-500 hours.

When a monomer with a group represented by -MgY¹ as a polymerizable group is used in the method for producing a polymer compound according to this embodiment, the polymerization reaction is preferably carried out under dehydrating conditions. On the other hand, when the polymerization reaction is a Suzuki coupling reaction, the base may be used as an aqueous solution, and water may be used as the solvent in addition to the aforementioned organic solvent.

In order to avoid polymerizing active groups remaining at the ends of the polymer compound of this embodiment in the polymerization reaction, a compound represented by the following formula (F) may be used as a chain terminator. This will allow a polymer compound to be obtained in which the ends are aryl or monovalent aromatic heterocyclic groups.

[Chemical Formula 69] X^{f}-Ar⁹ (F)

In the formula, Ar⁹ represents an aryl group or a monovalent aromatic heterocyclic group, and X^{f} represents a group selected from the group consisting of substituent group A and substituent group B. The aryl and monovalent aromatic heterocyclic groups of Ar⁹ may be any of the same as the aryl groups and the monovalent aromatic heterocyclic groups mentioned above.

Post-treatment after polymerization reaction may be carried out by a known method, such as adding the reaction mixture obtained by polymerization reaction to a lower alcohol such as methanol and filtering and drying the deposited precipitate.

When the purity of the polymer compound of this embodiment is low, it may be purified by a common method such as recrystallization, continuous extraction with a Soxhlet extractor or column chromatography, but when the polymer compound of this embodiment is to be used in a light emitting device, the purity will affect the performance of the device, including its luminescence property, and therefore the condensation polymerization is preferably followed by purification treatment, such as reprecipitating purification or fractionation by chromatography.

### <Polymer composition>

The polymer composition of this embodiment comprises a polymer compound, and at least one material selected from the group consisting of hole transporting materials, electron transporting materials and light emitting materials.

Examples of hole transporting materials include polyvinylcarbazole and its derivatives, polysilane and its derivatives, polysiloxane derivatives having aromatic amines on side chains or the main chain, pyrazoline derivatives, arylamine derivatives, stilbene derivatives, polyaniline and its derivatives, polythiophene and its derivatives, polypyrrole and its derivatives, poly(p-phenylenevinylene) and its derivatives and poly(2,5-thienylenevinylene) and its derivatives. Additional ones include those mentioned in Japanese Unexamined Patent Application Publication SHO No. 63-70257, Japanese Unexamined Patent Application Publication SHO No. 63-175860, Japanese Unexamined Patent Application Publication HEI No. 2-135359, Japanese Unexamined Patent Application Publication HEI No. 2-135361, Japanese Unexamined Patent Application Publication HEI No. 2-209988, Japanese Unexamined Patent Application Publication HEI No. 3-37992 and Japanese Unexamined Patent Application Publication HEI No. 3-152184.

The content of a hole transporting material is preferably 1-500 parts by weight and more preferably 5-200 parts by weight with respect to 100 parts by weight of the polymer compound in the polymer composition.

Electron transporting materials include oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives and polyfluorene and its derivatives. Additional ones include those mentioned in Japanese Unexamined Patent Application Publication SHO No. 63-70257, Japanese Unexamined Patent Application Publication SHO No. 63-175860, Japanese Unexamined Patent Application Publication HEI No. 2-135359, Japanese Unexamined Patent Application Publication HEI No. 2-135361, Japanese Unexamined Patent Application Publication HEI No. 2-209988, Japanese Unexamined Patent Application Publication HEI No. 3-37992 and Japanese Unexamined Patent Application Publication HEI No. 3-152184.

The content of an electron transporting material is preferably 1-500 parts by weight and more preferably 5-200 parts by weight with respect to 100 parts by weight of the polymer compound in the polymer composition.

The light emitting material may be a low molecular fluorescent material, a phosphorescent material, or the like. Specific examples include naphthalene derivatives, anthracene and its derivatives, perylene and its derivatives, pigments such as polymethine-based pigments, xanthene-based pigments, coumarin-based pigments and cyanine-based pigments, metal complexes with 8-hydroxyquinoline as a ligand, metal complexes with 8-hydroxyquinoline derivatives as ligands, other fluorescent metal complexes, aromatic amines, tetraphenylcyclopentadiene and its derivatives, tetraphenylbutadiene and its derivatives, low molecular compound fluorescent materials such as stilbene-based, silicon-containing aromatic, oxazole-based, furoxan-based, thiazole-based, tetraarylmethane-based, thiadiazole-based, pyrazole-based, metacyclophane-based and acetylene-based compounds, metal complexes such as iridium complexes and platinum complexes, triplet emitting complexes, and the like. They also include the compounds mentioned in Japanese Unexamined Patent Application Publication SHO No. 57-51781 and Japanese Unexamined Patent Application Publication SHO No. 59-194393.

The content of a light emitting material is preferably 1-500 parts by weight and more preferably 5-200 parts by weight with respect to 100 parts by weight of the polymer compound in the polymer composition.

### <Solution>

The polymer compound of this embodiment may be dissolved or dispersed in an organic solvent to form a solution or dispersion (hereunder referred to simply as "solution"). Such a solution or dispersion is called an ink or liquid composition. The solution may comprise a polymer compound and at least one material selected from the group consisting of hole transporting materials, electron transporting materials and light emitting materials.

The organic solvent may be a chlorine-based solvent such as chloroform, methylene chloride, 1,2-dichloroethane, 1,1,2-trichloroethane, chlorobenzene or o-dichlorobenzene; an ether-based solvent such as tetrahydrofuran or dioxane; an aromatic hydrocarbon-based solvent such as toluene, xylene, trimethylbenzene or mesitylene; an aliphatic hydrocarbon-based solvent such as cyclohexane, methylcyclohexane, n-pentane, n-hexane, n-heptane, n-octane, n-nonane or n-decane; a ketone-based solvent such as acetone, methyl ethyl ketone or cyclohexanone; an ester-based solvent such as ethyl acetate, butyl acetate, methyl benzoate or ethyl cellosolve acetate; a polyhydric alcohol such as ethylene glycol, ethyleneglycol monobutyl ether, ethyleneglycol monoethyl ether, ethyleneglycol monomethyl ether, dimethoxyethane, propylene glycol, diethoxymethane, triethyleneglycol monoethyl ether, glycerin or 1,2-hexanediol, or a derivative thereof; an alcohol-based solvent such as methanol, ethanol, propanol, isopropanol or cyclohexanol; a sulfoxide-based solvent such as dimethyl sulfoxide; or an amide-based solvent such as N-methyl-2-pyrrolidone or N,N-dimethylformamide. These organic solvents may be used alone or in combinations of two or more. Preferred among these organic solvents, from the viewpoint of viscosity and film formability, are those including organic solvents with a benzene ring-containing structure, having a melting point of no higher than 0°C and a boiling point of 100°C or higher.

Such solutions allow easy production of an organic film comprising a polymer compound of this embodiment. Specifically, the solution may be applied onto a substrate and heated, and subjected to pressure reduction and the like to remove the organic solvent, thereby obtaining an organic film comprising a polymer compound of this embodiment. The organic solvent may be removed by heating at about 50-150°C and pressure reduction at about 10⁻³ Pa, varying the conditions as appropriate for the organic solvent used.

The coating may be accomplished using a coating method such as a spin coating method, a casting method, a microgravure method, a gravure coating method, a bar coating method, a roll coating method, a wire bar coating method, a dip coating method, a slit coating method, a capillary coating method, a spray coating method, a screen printing method, a flexographic printing method, an offset printing method, an ink jet printing method, a nozzle coating method or the like.

The preferred viscosity for the solution will differ depending on the printing method, but it is preferably 0.5-500 mPa· s at 25°C. When the solution is to be passed through a discharge device such as in ink jet printing, the viscosity at 25°C is preferably 0.5-20 mPa· s to prevent clogging or curving trajectory during discharge.

### <Organic film>

The organic film of this embodiment comprises a polymer compound of this embodiment. The organic film may comprise a polymer compound and at least one material selected from the group consisting of hole transporting materials, electron transporting materials and light emitting materials. The organic film of this embodiment can be easily produced from the aforementioned solution, as described above.

The organic film of this embodiment can be suitably used as a light emitting layer for an organic light emitting device, described hereunder. It can also be suitably used in an organic semiconductor device. Because the organic film of this embodiment comprises the aforementioned polymer compound, when it is used as a light emitting layer for a light emitting device, the light emitting device has very excellent luminous efficiency.

### <Organic semiconductor device>

The organic semiconductor device of this embodiment comprises the aforementioned organic film. Such organic semiconductor devices include organic film solar cells and organic film transistors, and a polymer compound and organic film of the invention can be suitably used for their production. Specifically, a field-effect organic transistor can be fabricated by, for example, forming the organic film on a Si board comprising an insulating film made of SiO₂ or the like and a gate electrode, and then forming a source electrode and drain electrode of Au or the like.

An organic film transistor comprises a source electrode and drain electrode, an organic semiconductor layer (active layer) made of an organic film which acts as a current channel between them, and a gate electrode that controls the level of current flowing through the current channel, and the transistor may be a field-effect type or static induction type, for example.

An organic film field-effect transistor may have a structure comprising a source electrode and drain electrode, an organic semiconductor layer (active layer) which acts as a current channel between them, a gate electrode that controls the level of current flowing through the current channel, and an insulating layer situated between the organic semiconductor layer and the gate electrode. Preferably, the source electrode and drain electrode are provided in contact with the organic semiconductor layer (active layer) containing the polymer of the invention, and the gate electrode is provided sandwiching the insulating layer which is also in contact with the organic semiconductor layer.

A static induction-type organic film transistor has a structure comprising a source electrode and drain electrode, an organic semiconductor layer (active layer) which acts as a current channel between them, and a gate electrode that controls the level of current flowing through the current channel, preferably with the gate electrode in the organic semiconductor layer. Most preferably, the source electrode, the drain electrode and the gate electrode formed in the organic semiconductor layer are provided in contact with the organic semiconductor layer. The structure of the gate electrode may be any one that forms a current channel for flow from the source electrode to the drain electrode, and that allows the level of current flowing through the current channel to be controlled by the voltage applied to the gate electrode; an example of such a structure is a combshaped electrode.

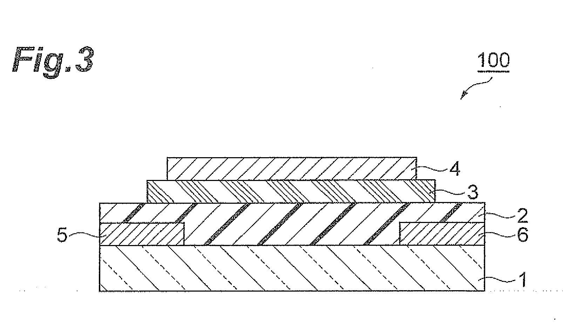

Fig. 3 is a schematic cross-sectional view showing an embodiment of an organic film transistor (organic film field-effect transistor). The organic film transistor 100 shown in Fig. 3 comprises a substrate 1, a source electrode 5 and drain electrode 6 formed at a fixed spacing on the substrate 1, an organic semiconductor layer 2 formed on the substrate 1 covering the source electrode 5 and drain electrode 6, an insulating layer 3 formed on the organic semiconductor layer 2, and a gate electrode 4 formed on the insulating layer 3 covering the region of the insulating layer 3 between the source electrode 5 and drain electrode 6.

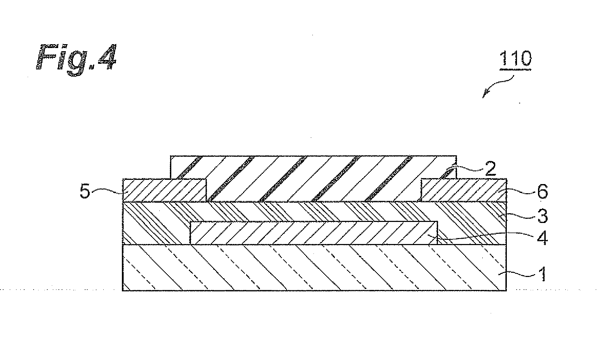

Fig. 4 is a schematic cross-sectional view showing another embodiment of an organic film transistor (organic film field-effect transistor). The organic film transistor 110 shown in Fig. 4 comprises a substrate 1, a gate electrode 4 formed on the substrate 1, an insulating layer 3 formed on the substrate 1 covering the gate electrode 4, a source electrode 5 and drain electrode 6 formed at a prescribed spacing on the insulating layer 3 covering portions of the region of the insulating layer 3 under which the gate electrode 4 is formed, and an organic semiconductor layer 2 formed on the insulating layer 3 covering portions of the source electrode 5 and drain electrode 6.

In these organic film transistors, the organic semiconductor layer 2 is constructed from an organic film containing the polymer compound described above, and it forms a current channel between the source electrode 5 and drain electrode 6. The gate electrode 4 controls the current flowing through the current channel of the organic semiconductor layer 2 by application of voltage.

Among such organic film transistors, this type of organic film field-effect transistor can be manufactured by a publicly known method, such as the method described in Japanese Unexamined Patent Application Publication HEI No. 5-110069, for example. A static induction-type organic film transistor can also be manufactured by a publicly known method, such as the method described in Japanese Unexamined Patent Application Publication No. 2004-006476, for example.

### <Organic light emitting device>

An organic light emitting device of this embodiment comprises the organic film described above.

Specifically, the organic light emitting device of this embodiment comprises an anode, a cathode, and a layer containing the aforementioned polymer compound between the anode and cathode. The layer containing the polymer compound is preferably a layer composed of the aforementioned organic film, and the layer preferably functions as a light emitting layer. When the layer containing the polymer compound is to function as a light emitting layer, the following are preferred embodiments thereof.

The light emitting device of this embodiment may have any of the following structures (a)-(d). The "/" separator indicates lamination of the previous and subsequent layers in an adjacent manner. (For example, "anode/light emitting layer" indicates that the anode and light emitting layer are laminated adjacently.)
(a) Anode/light emitting layer/cathode
(b) Anode/hole transporting layer/light emitting layer/cathode
(c) Anode/light emitting layer/electron transporting layer/cathode
(d) Anode/hole transporting layer/light emitting layer/electron transporting layer/cathode

A light emitting layer is a layer having a luminescent function, a hole transporting layer is a layer having a function of transporting holes, and an electron transporting layer is a layer having a function of transporting electrons. The hole transporting layer and electron transporting layer may collectively be referred to as "charge transporting layers". Also, the hole transporting layer adjacent to the light emitting layer may be referred to as "interlayer".

The lamination and film formation for each layer may be accomplished using a solution comprising the constituent components for each layer. The lamination and film formation from the solution may be accomplished using a coating method such as spin coating, casting, a microgravure coating method, gravure coating, bar coating, roll coating, wire bar coating, dip coating, slit coating, capillary coating, spray coating, screen printing, flexographic printing, offset printing, ink jet printing, nozzle coating or the like.

The film thickness of the light emitting layer may be selected for suitable values of the driving voltage and luminous efficiency, but for most cases it is 1 nm-1 µm, preferably 2-500 nm and more preferably 5-200 nm.

The hole transporting layer preferably comprises the aforementioned hole transporting material. Film formation of the hole transporting layer may be accomplished by any method, but when the hole transporting material is a polymer compound, the film formation is preferably from a solution containing the hole transporting material, and when the hole transporting material is a low molecular compound, the film formation is preferably from a mixed solution comprising a macromolecular binder and the hole transporting material. The film-forming method employed may be the same method as the coating method described above.

The macromolecular binder is preferably one that produces minimal interference with charge transport, and one with weak absorption for visible light. Macromolecular binders include polycarbonates, polyacrylates, polymethyl acrylate, polymethyl methacrylate, polystyrene, polyvinyl chloride, polysiloxanes and the like.

The film thickness of the hole transporting layer may be selected for suitable values of the driving voltage and luminous efficiency, but the thickness must be sufficient to avoid generation of pinholes, while an excessive thickness is not preferred as it will increase the driving voltage of the device. The film thickness of the hole transporting layer is therefore usually 1 nm-1 µm, preferably 2-500 nm and more preferably 5-200 nm.

The electron transporting layer preferably comprises the aforementioned electron transporting material. Film formation of the electron transporting layer may be accomplished by any method, but when the electron transporting material is a polymer compound, it is preferred to use a method of film formation from a solution comprising the electron transporting material, or a method of film formation by melting of the electron transporting material. When the electron transporting material is a low molecular compound, it is preferred to use a method of film formation by vacuum vapor deposition using a powder of the electron transporting material, a method of film formation from a solution comprising the electron transporting material, or a method of film formation by melting of the electron transporting material. An example of a method of film formation from a solution comprising the electron transporting material is the same method as the coating method described above. The solution may also contain a macromolecular binder.

The macromolecular binder is preferably one that produces minimal interference with charge transport, and one with weak absorption for visible light. Macromolecular binders include poly(N-vinylcarbazole), polyaniline and its derivatives, polythiophene and its derivatives, poly(p-phenylenevinylene) and its derivatives, poly(2,5-thienylenevinylene) and its derivatives, polycarbonates, polyacrylates, polymethyl acrylates, polymethyl methacrylates, polystyrenes, polyvinyl chlorides, polysiloxanes and the like.

The film thickness of the electron transporting layer may be selected for suitable values of the driving voltage and luminous efficiency, but the thickness must be sufficient to avoid generation of pinholes, while an excessive thickness is not preferred as it will increase the driving voltage of the device. The film thickness of the electron transporting layer is therefore usually 1 nm-1 µm, preferably 2-500 nm and more preferably 5-200 nm.

Of the charge transporting layers formed adjacent to the electrodes, those having the function of improving the charge injection efficiency from the electrodes and having an effect of lowering the driving voltage of the light emitting device, are often referred to particularly as charge injection layers (hole injection layer, electron injection layer). In order to increase adhesiveness with the electrodes and improve charge injection from the electrodes, there may be provided adjacent to the electrodes a charge injection layer or insulating layer, while a thin buffer layer may be inserted at the interface with the charge transporting layer or light emitting layer to improve the interfacial adhesiveness and prevent intermixture. The order and number of the laminated layers and the thickness of each layer may be appropriately selected in consideration of the desired luminous efficiency and device lifespan.

Light emitting devices with charge injection layers include those having the following structures (e)-(p).
(e) Anode/charge injection layer/light emitting layer/cathode
(f) Anode/light emitting layer/charge injection layer/cathode
(g) Anode/charge injection layer/light emitting layer/charge injection layer/cathode
(h) Anode/charge injection layer/hole transporting layer/light emitting layer/cathode
(i) Anode/hole transporting layer/light emitting layer/charge injection layer/cathode
(j) Anode/charge injection layer/hole transporting layer/light emitting layer/charge injection layer/cathode
(k) Anode/charge injection layer/light emitting layer/charge transporting layer/cathode
(1) Anode/light emitting layer/electron transporting layer/charge injection layer/cathode
(m) Anode/charge injection layer/light emitting layer/electron transporting layer/charge injection layer/cathode
(n) Anode/charge injection layer/hole transporting layer/light emitting layer/charge transporting layer/cathode
(o) Anode/hole transporting layer/light emitting layer/electron transporting layer/charge injection layer/cathode
(p) Anode/charge injection layer/hole transporting layer/light emitting layer/electron transporting layer/charge injection layer/cathode

The charge injection layer may be (I) a layer comprising a conductive polymer, (II) a layer provided between the anode and hole transporting layer, which comprises a material having an ionization potential between that of the anode material in the anode and the hole transporting material in the hole transporting layer, or (III) a layer provided between the cathode and electron transporting layer, which comprises a material having an electron affinity between that of the cathode material in the cathode and the electron transporting material in the electron transporting layer.

When the charge injection layer is (I) a layer comprising a conductive polymer, the electric conductivity of the conductive polymer is preferably 10⁻⁵ S/cm-10³ S/cm, and for reduced leak current between luminescent picture devices, it is more preferably 10⁻⁵ S/cm-10² S/cm and most preferably 10⁻⁵ S/cm-10¹ S/cm. The conductive polymer may be doped with an appropriate amount of ion so that this range is satisfied.

The type of ion used for doping may be an anion for the hole injection layer or a cation for the electron injection layer. Anions include polystyrenesulfonate ion, alkylbenzenesulfonate ion and camphorsulfonate ion, and cations include lithium ion, sodium ion, potassium ion and tetrabutylammonium ion.

The film thickness of the charge injection layer is preferably 1-100 nm and more preferably 2-50 nm.

The conductive polymer may be appropriately selected in consideration of the relationship between the electrode and the material in the adjacent layer, and examples include conductive polymers, such as polyaniline and its derivatives, polythiophene and its derivatives, polypyrrole and its derivatives, polyphenylenevinylene and its derivatives, polythienylenevinylene and its derivatives, polyquinoline and its derivatives and polyquinoxaline and its derivatives, and polymers comprising an aromatic amine structure on the main chain or a side chain. The charge injection layer may also be a layer comprising a metal phthalocyanine (copper phthalocyanine or the like), or carbon.

The insulating layer have the function of facilitating charge injection. The film thickness of the insulating layer is usually 0.1-20 nm, preferably 0.5-10 nm and more preferably 1-5 nm. The material used for the insulating layer may be a metal fluoride, metal oxide, organic insulating material, or the like.

Light emitting devices with insulating layers include those having the following structures (q)-(ab).
(q) Anode/insulating layer/light emitting layer/cathode
(r) Anode/light emitting layer/insulating layer/cathode
(s) Anode/insulating layer/light emitting layer/insulating layer/cathode
(t) Anode/insulating layer/hole transporting layer/light emitting layer/cathode
(u) Anode/hole transporting layer/light emitting layer/insulating layer/cathode
(v) Anode/insulating layer/hole transporting layer/light emitting layer/insulating layer/cathode
(w) Anode/insulating layer/light emitting layer/electron transporting layer/cathode
(x) Anode/light emitting layer/electron transporting layer/insulating layer/cathode
(y) Anode/insulating layer/light emitting layer/electron transporting layer/insulating layer/cathode
(z) Anode/insulating layer/hole transporting layer/light emitting layer/electron transporting layer/cathode
(aa) Anode/hole transporting layer/light emitting layer/electron transporting layer/insulating layer/cathode
(ab) Anode/insulating layer/hole transporting layer/light emitting layer/electron transporting layer/insulating layer/cathode

The light emitting device of this embodiment preferably comprises a substrate adjacent to the anode or cathode. The substrate is preferably one with that does not undergo alteration in shape or properties during formation of the electrode and each of the layers, and examples include substrates of glass, plastic, polymer film, silicon and the like. In the case of an opaque substrate, the electrode opposite the electrode in contact with the substrate is preferably transparent or semi-transparent.

In a light emitting device of this embodiment, normally either or both the electrodes composed of the anode and cathode will be transparent or semi-transparent, and preferably the anode is transparent or semi-transparent.

The material of the anode may be a conductive metal oxide film or a semi-transparent metal film. Specifically, there may be used a film (NESA or the like) formed using a conductive inorganic compound, such as indium oxide, zinc oxide, tin oxide a complex oxide composed of indium tin oxide (ITO), or a complex oxide composed of indium zinc oxide, or gold, platinum, silver, copper or the like may be used. The anode used may be an organic transparent conductive film made of polyaniline or its derivative or polythiophene or its derivative. In order to facilitate charge injection, there may be provided on the anode a layer composed of a phthalocyanine derivative, conductive polymer, carbon or the like, or a layer composed of a metal oxide, metal fluoride, organic insulating material or the like.

The method of forming the anode may be vacuum vapor deposition, sputtering, ion plating, plating or the like.

The film thickness of the anode may be appropriately selected in consideration of light permeability and electric conductivity, and it is usually 10 nm-10 µm, preferably 20 nm-1 µm and more preferably 50-500 nm.

The material for the cathode is preferably one with a low work function, e.g. a metal such as lithium, sodium, potassium, rubidium, cesium, beryllium, magnesium, calcium, strontium, barium, aluminum, scandium, vanadium, zinc, yttrium, indium, cerium, samarium, europium, terbium or ytterbium, or an alloy comprising two or more of these metals, or an alloy comprising one or more of these metals with one or more of gold, silver, platinum, copper, manganese, titanium, cobalt, nickel, tungsten or tin, or graphite or a graphite interlaminar compound.

The method used to form the cathode may be vacuum vapor deposition, sputtering, or a laminating method involving thermocompression bonding of a metal film.

The film thickness of the cathode may be appropriately selected in consideration of electric conductivity and durability, and it is usually 10 m-10 µm, preferably 20 nm-1 µm and more preferably 50-500 nm.

Also, between the cathode and the light emitting layer or between the cathode and the electron transporting layer, there may be provided a layer composed of a conductive polymer, or a layer composed of a metal oxide, metal fluoride or organic insulating material, and a protective layer for protection of the light emitting device may also be placed after formation of the cathode. For prolonged stable use of the light emitting device, a protective layer and/or protective cover is preferably situated to protect the device from the external environment.

Such a protective layer may be a resin, a metal oxide, metal fluoride, metal boride, or the like. The protective cover may be a glass plate, or a plastic sheet that has been subjected to low-permeability treatment on the surface, and the protective cover may be hermetically attached to the device board with a thermosetting resin or photocuring resin. A spacer may be used to maintain spacing, thus helping to prevent damage to the device. By filling an inert gas such as nitrogen or argon into the spacing, it is possible to prevent oxidation of the cathode, and setting a desiccant such as barium oxide in the space will help to prevent damage to the device by moisture adsorbed in the production steps.

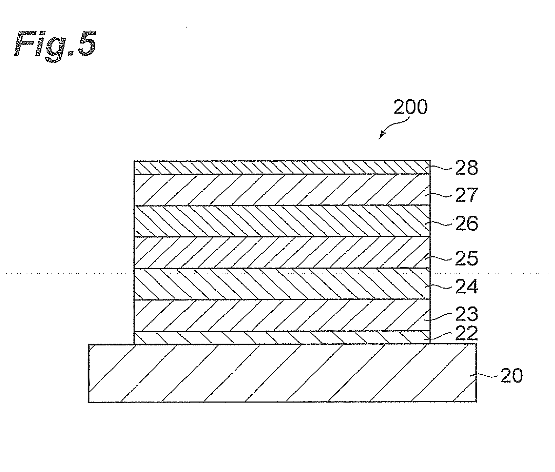

Fig. 5 is a schematic cross-sectional view of a light emitting device of this embodiment (a light emitting device having construction (p) above). The light emitting device 200 shown in Fig. 5 comprises a substrate 20, and an anode 22, a charge injection layer 23, a hole transporting layer 24, a light emitting layer 25 composed of an organic film comprising the polymer compound, an electron transporting layer 26, a charge injection layer 27 and a cathode 28, formed on the substrate 20. The anode 22 is provided on the substrate 20 in contact with the substrate 20, and on the side of the anode 22 opposite the substrate 20, the charge injection layer 23, hole transporting layer 24, light emitting layer 25, electron transporting layer 26, charge injection layer 27 and cathode 28 are laminated in that order.

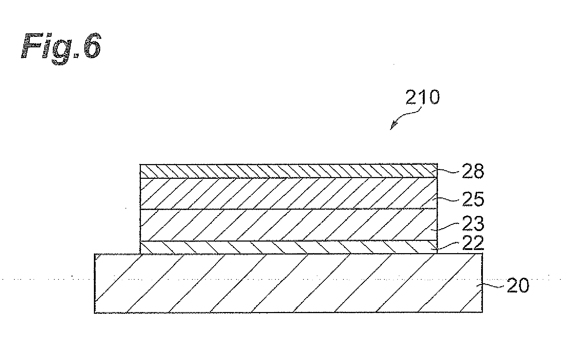

Fig. 6 is a schematic cross-sectional view of a light emitting device of this embodiment (a light emitting device having construction (e) above). The light emitting device 210 shown in Fig. 6 comprises a substrate 20, and an anode 22, a charge injection layer 23, a light emitting layer 25 composed of an organic film comprising a polymer compound, and a cathode 28, formed on the substrate 20. The anode 22 is provided on the substrate 20 in contact with the substrate 20, while the charge injection layer 23, light emitting layer 25 and cathode 28 are laminated in that order on the side of the anode 22 opposite the substrate 20 side.

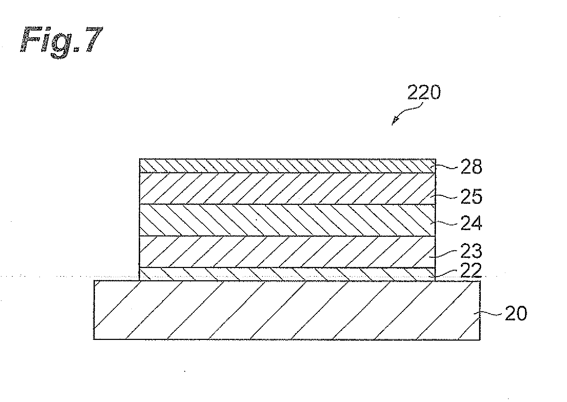

Fig. 7 is a schematic cross-sectional view of a light emitting device of this embodiment (a light emitting device having construction (h) above). The light emitting device 220 shown in Fig. 7 comprises a substrate 20, and an anode 22, a charge injection layer 23, a hole transporting layer 24, a light emitting layer 25 composed of an organic film comprising the polymer compound, and a cathode 28, formed on the substrate 20. The anode 22 is provided on the substrate 20 in contact with the substrate, while the charge injection layer 23, hole transporting layer 24, light emitting layer 25 and cathode 28 are laminated in that order on the side of the anode 22 opposite the substrate 20 side.

The polymer compound of this embodiment, and a light emitting device comprising the polymer composition of this embodiment, are useful for a surface light source such as a curved light source or flat light source (for example, illumination); or for display devices such as segment display devices (for example, segment-type display devices), dot matrix display devices (for example, dot matrix flat displays), and liquid crystal display devices (for example, liquid crystal display devices, liquid crystal display backlights and the like). In addition to being suitable as a material for use in such fabrication, the polymer compound of this embodiment is also useful as a laser pigment, an organic solar cell material, an organic transistor organic semiconductor, a conductive film material for a conductive film or an organic semiconductor film, a luminescent film material that emits fluorescence, or a material for a polymer field-effect transistor.

A planar anode and cathode may be stacked together in order to obtain planar luminescence using the light emitting device of this embodiment. Also, luminescence in a pattern can be obtained by a method in which a mask with a patterned window is set on the front side of the surface light emitting device, or a method in which an anode or cathode, or both electrodes, are formed in a pattern shape. By forming a pattern by any of these methods, and configuring some electrodes to be independently ON/OFF switchable, it is possible to obtain a segment type display device allowing display of numerals, letters or simple symbols. Furthermore, for a dot matrix device, the anode and cathode may both be formed as stripes and configured in a crossing manner. A partial color display or multicolor display can also be formed by a method in which different types of polymer compounds with different luminescent colors are coated or a method using a color filter or fluorescence conversion filter. The dot matrix device may be passively driven or actively driven in combination with a TFT or the like. These display devices may be used as display devices for computers, televisions, portable terminals, cellular phones, car navigation systems, video camera viewfinders, and the like.

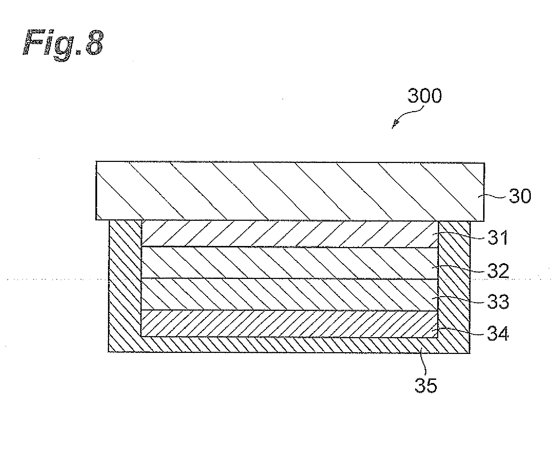

Fig. 8 is a schematic cross-sectional view of a surface light source according to this embodiment. The surface light source 300 shown in Fig. 8 comprises a substrate 30 an anode 31, a charge injection layer 32, a light emitting layer 33 composed of an organic film containing a polymer compound, a cathode 34, and a protective layer 35. The anode 31 is provided on the substrate 30 in contact with the substrate 30, and the charge injection layer 32, light emitting layer 33 and cathode 34 are laminated in that order on the side of the anode 31 opposite the substrate 30 side. The protective layer 35 is formed so as to cover the anode 31, charge injection layer 32, light emitting layer 33 and cathode 34 that are formed on the substrate 30, and so as to contact the substrate 30 at the ends.

The surface light source 300 shown in Fig. 8 comprises light emitting layers in addition to the light emitting layer 33, and a red light emitting material, blue light emitting material and green light emitting material are used in each light emitting layer, with driving of each light emitting layer being controlled to obtain a color display device.

### Examples

The invention will now be described in greater detail by examples, with the understanding that the invention is not limited thereto.

The number-average molecular weight and weight-average molecular weight of the polymer compound in terms of polystyrene were determined under the following measuring conditions using size-exclusion chromatography (SEC) (LC-10Avp, product of Shimadzu Corp.).

### [Measuring conditions]

The polymer compound to be measured was dissolved in tetrahydrofuran to a concentration of about 0.05 wt% and 10 µL thereof was injected into the SEC apparatus. The SEC mobile phase was tetrahydrofuran, and the flow rate was 2.0 mL/min. The column used was a PLgel MIXED-B (product of Polymer Laboratories, Ltd.). A UV-VIS detector (SPD-10Avp by Shimadzu Corp.) was used as the detector.

### <Synthesis Example 1>

A mixture of 3,9-dibromoperylene and 3,10-dibromoperylene was synthesized.

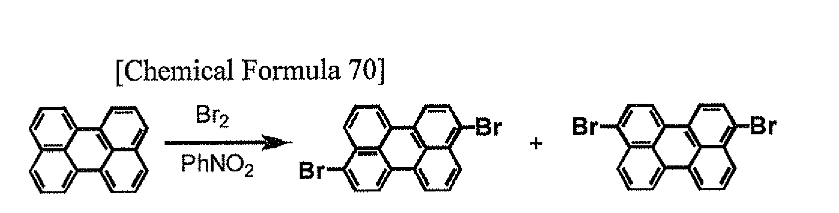

After mixing perylene (product of Aldrich, sublimation purification grade, >99.5%) (25.23 g, 100 mmol) and nitrobenzene (800 ml) in a 1000 ml flask under a nitrogen gas atmosphere, the mixture was heated to 125°C for dissolution of the total amount of perylene in the nitrobenzene, and then a solution of bromine (32.9 g, 206 mmol) diluted with nitrobenzene (85 ml) was added dropwise over a period of one hour while shielded from light. Upon completion of the dropwise addition, stirring was continued at the same temperature for 5 hours and the mixture was cooled to room temperature.

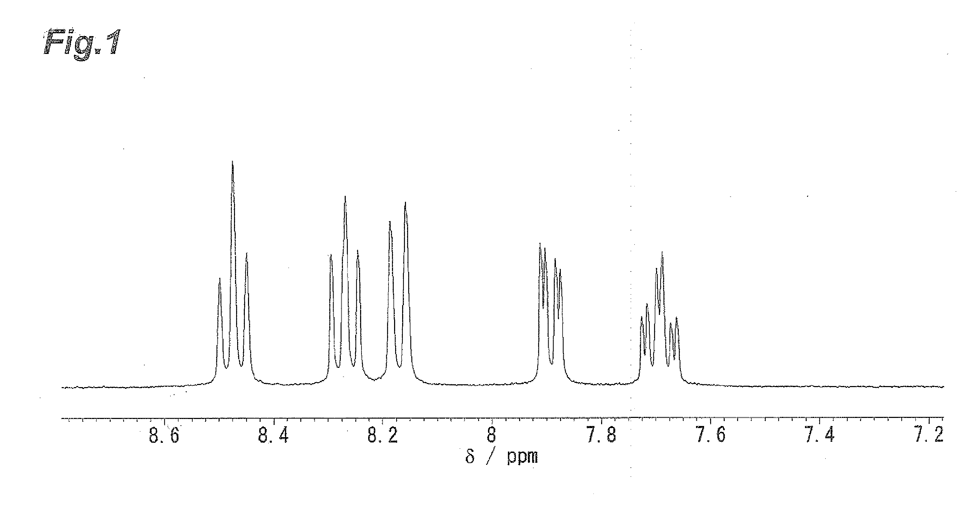

The contents (deposited solid and solution) were transferred to a separately prepared 2000 ml flask, methanol (500 ml) was added while stirring, and the mixture was filtered under reduced pressure, rinsed with methanol (1000 ml) and dried under reduced pressure to obtain yellow crystals (37.9 g). Xylene (1350 ml) was added, and the mixture was stirred for 5 hours while heating to reflux. It was then cooled to room temperature, filtered under reduced pressure, rinsed with methanol (4 times with 100 ml) and dried under reduced pressure to obtain yellow crystals (30.2 g). Xylene (1000 ml) was further added, and the mixture was stirred for 5 hours while heating to reflux. It was then cooled to room temperature, filtered under reduced pressure, rinsed with methanol (4 times with 100 ml) and dried under reduced pressure to obtain yellow crystals (24.6 g). The purity was 99.82% based on the HPLC area percentage value. Analysis by ¹H-NMR confirmed the presence of 3,9-dibromoperylene and 3,10-dibromoperylene in a proportion of 50/50. Fig. 1 shows a ¹H-NMR spectrum (300 MHz, THF-d8) of the yellow crystals obtained in Synthesis Example 1 .

### <Synthesis Example 2>

The following compound MB was synthesized.

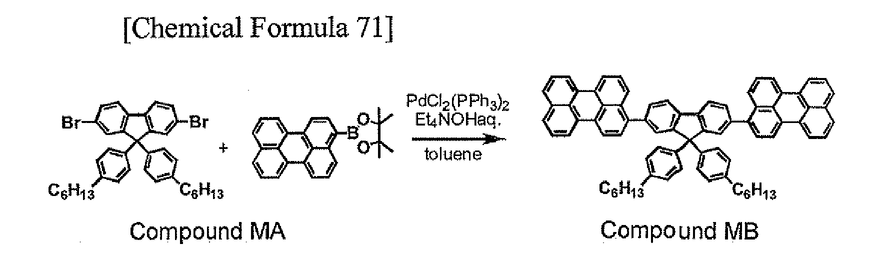

After mixing compound MA (0.645 g, 1.00 mmol), 4,4,5,5-tetramethyl-2-(3-perylenyl)-1,3,2-dioxaborolane (0.774 g, 2.05 mmol, synthesized based on description in Journal of Organic Chemistry (2007), 72(26), 10243-10246) and toluene (20 ml) in a 50 ml flask under an argon gas atmosphere, bis(triphenylphosphine)dichloropalladium (II) (7 mg, 0.01 mmol) and aqueous tetraethylammonium hydroxide (20 wt%, 3.7 g, 5 mmol) were added, and the mixture was heated and stirred for 3 hours while refluxing. After cooling to room temperature, it was diluted with (30 ml) of toluene and rinsed twice with ion-exchanged water, and then active white clay (1.5 g) was added to the obtained organic layer, and the mixture was stirred and filtered. The filtrate was concentrated, 50 ml of hexane was added and the mixture was stirred at 80°C for 1 hour, after which it was cooled to room temperature and the solid was filtered and dried under reduced pressure to obtain 0.94 g of a solid. This was heated and dissolved in toluene (12 g), hexane (50 ml) was added and the mixture was stirred at 80°C for 1 hour, after which it was cooled to room temperature and the solid was filtered and dried under reduced pressure to obtain 0.87 g of a solid. This was heated and dissolved in toluene (30 g), hexane (150 ml) was added and the mixture was stirred at 80°C for 1 hour, after which it was cooled to room temperature and the solid was filtered and dried under reduced pressure to obtain 0.80 g of a solid. Yield: 81%. ¹H-NMR analysis confirmed that the solid was compound MB. The obtained ¹H-NNR spectral data were as follows.
¹H-NMR (300 MHz, THF-d⁸)δ8.30 (m, 8H), 8.06 (d, 2H), 7.80 (d, 2H), 7.70 (m, 6H), 7.61 (d, 2H), 7.48 (m, 6H), 7.38 (t, 2H), 7.29 (d, 4H), 7.09 (d, 4H), 2.57 (t, 4H), 1.60 (m, 4H), 1.30 (m, 12H), 0.87 (t, 6H).

### <Example 1>

The following compound MC (three-component mixture) was synthesized.

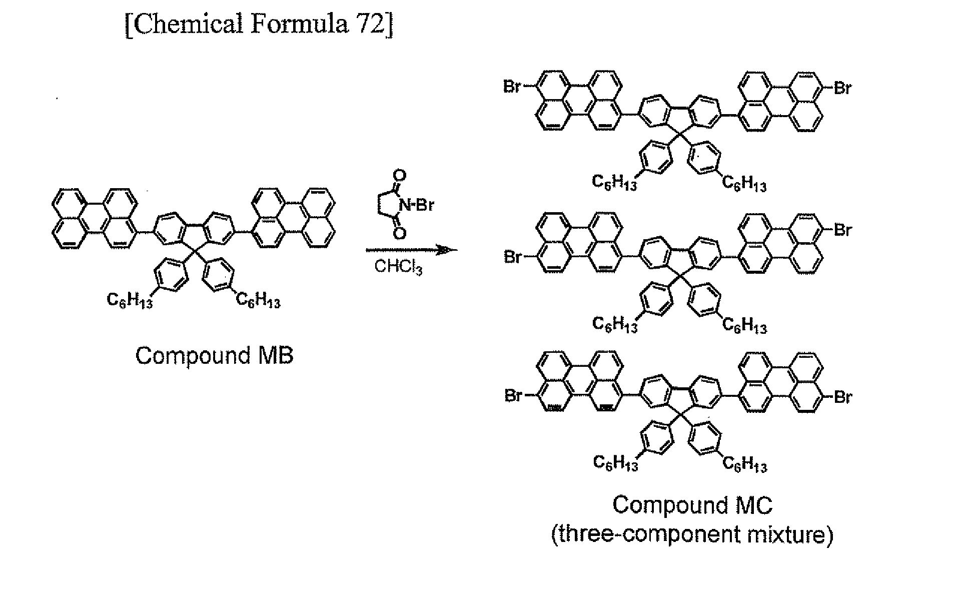

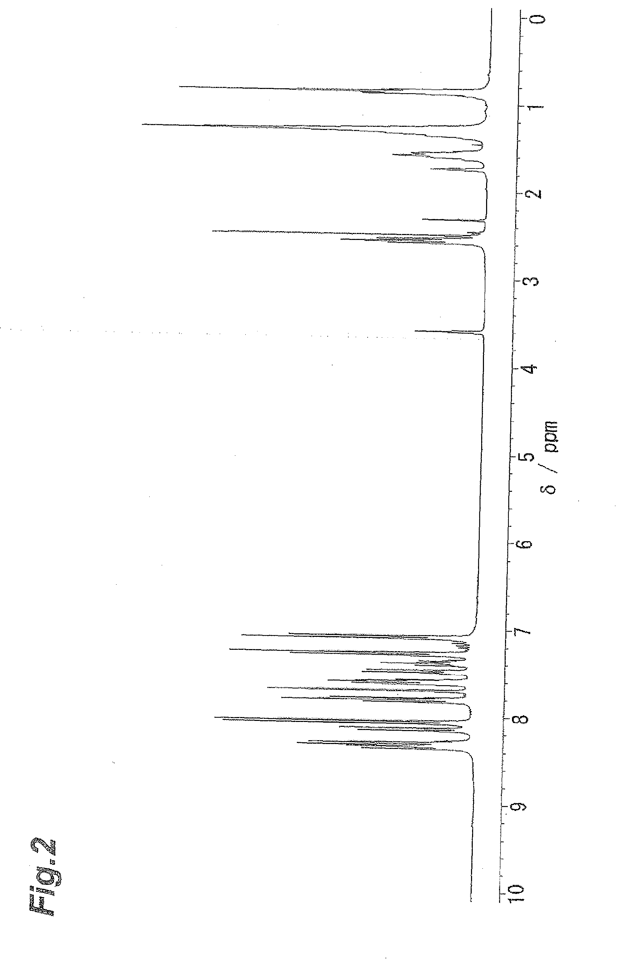

After mixing compound MB (0.691 g, 0.70 mmol) and chloroform (35 ml) in a 50 ml flask under an argon gas atmosphere to complete dissolution of the solid, N-bromosuccinimide (0.249 g, 1.40 mmol) was added as a solid and the mixture was stirred at room temperature for 8 hours, after which the reaction mixture was slowly added to methanol (200 ml), and the precipitated solid was filtered out and dried under reduced pressure to obtain an orange solid (0.82 g). A solution of the obtained solid in toluene (24 g) was slowly added to hexane (150 ml), the solid was allowed to precipitate, and after stirring at 40°C for 1 hour, the mixture was cooled to room temperature and the solid was filtered and dried under reduced pressure to obtain an orange solid. The obtained solid was heated to 80°C in toluene (2 g) for dissolution, aniline (10 g) was slowly added at 80°C, and the mixture was slowly cooled for crystallization, and then filtered, rinsed with methanol and dried under reduced pressure to obtain an orange solid (0.43 g). Hexane was added to the filtrate, and the precipitated solid was filtered out to obtain a solid (0.20 g). The obtained solids were combined, heated and dissolved in aniline (2.5 g), and cooled for crystallization, to obtain an orange solid (0.54 g). The obtained solid was purified by medium pressure column chromatography (120 g-SiO₂, toluene) to obtain 0.14 g of an orange solid. Yield: 17%. ¹H-NMR analysis confirmed that the solid was compound MC (three-component mixture). Fig. 2 shows the ¹H-NMR (300 MHz, THF-d8) for the solid obtained in Example 1. The obtained ¹H-NMR spectral data were as follows.
¹H-NMR (300 MHz, THF-d8)δ8.34 (m, 6H), 8.15 (d, 2H), 8.07 (d, 4H), 7.81 (t, 4H), 7.70 (s, 2H), 7.61 (m, 4H), 7.49 (m, 2H), 7.38 (m, 2H), 7.29 (d, 4H), 7.09 (d, 4H), 2.57 (t, 4H), 1.59 (m, 4H), 1.30 (m, 12H), 0.87 (t, 6H).

### <Synthesis Example 3>

An alternating copolymer (polymer compound A) comprising a constitutional unit represented by the following formula (A-1) and a constitutional unit represented by the following formula (A-2) in a molar ratio of 50:50 was synthesized.

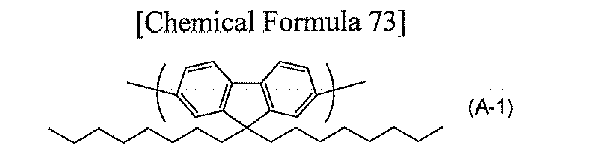

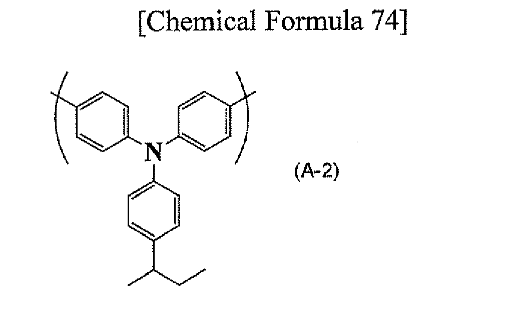

After mixing 5.20 g of 2,7-bis(1,3,2-dioxaborolan-2-yl)-9,9-dioctylfluorene, 4.50 g of N,N-bis(4-bromophenyl)-N-(4-sec-butylphenyl)-amine, 2.2 mg of palladium acetate, 15.1 mg of tris(2-methylphenyl)phosphine, 0.91 g of trioctylmethylammonium chloride (trade name: Aliquat^{R} 336, product of Aldrich Co.) and 70 ml of toluene under a nitrogen atmosphere, the mixture was heated to 105°C. To the obtained solution there was added dropwise 19 ml of 2 M aqueous sodium carbonate, and the mixture was circulated for 4 hours. Next, 121 mg of phenylboric acid was added and circulation was continued for another 3 hours. Next, a sodium diethyldithiacarbaminate aqueous solution was added and the mixture was stirred at 80°C for 4 hours. After cooling, the mixture was rinsed 3 times with 60 ml of water, 3 times with 60 ml of a 3 wt% acetic acid aqueous solution and 3 times with 60 ml of water, and was purified by passing through an alumina column and a silica gel column in that order. The obtained toluene solution was dropped into 3 L of methanol and stirred for 3 hours, and the obtained solid was removed out and dried. The yield of the solid (polymer compound A) was 5.25 g. Also, the number-average molecular weight of polymer compound A based on polystyrene was 8.1 × 10⁴, and the weight-average molecular weight based on polystyrene was 3.4 × 10⁵.

### <Example 2>

A polymer (polymer compound C) comprising a constitutional unit represented by the following formula (A-1), a constitutional unit represented by the following formula (A-2), a constitutional unit represented by the following formula (A-3) (the abundance ratio (molar ratio) of the 2 different constitutional units being approximately 50:50), and a constitutional unit represented by the following formula (A-4) in a molar ratio of 50:10:20:20 was synthesized.

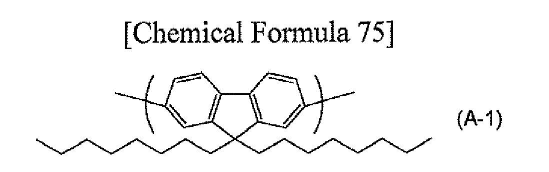

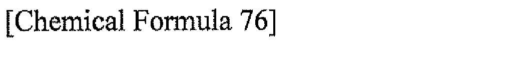

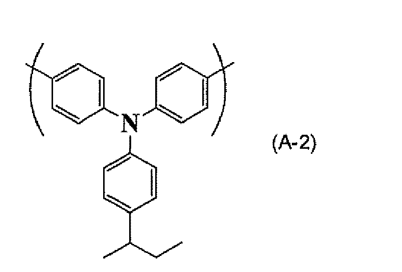

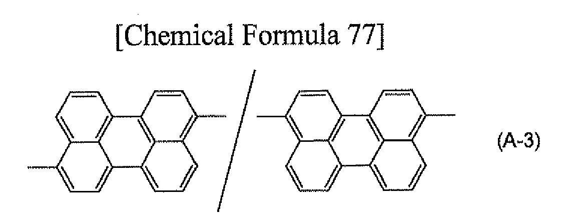

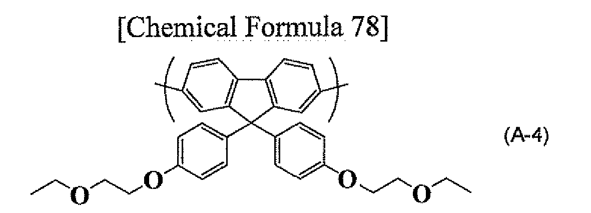

To a 200 mL separable flask there were added 1.994 g (3.75 mmol) of 2,7-bis(1,3,2-dioxaborolan-2-yl)-9,9-dioctylfluorene, 0.985 g (1.50 mmol) of 9,9-bis(4-(2-ethoxy)ethoxyphenyl)-2,7-dibromofluorene, 0.347 g (0.75 mmol) of N,N-bis(4-bromophenyl)-N-(4-sec-butylphenyl)-amine, 0.617 g (1.50 mmol) of dibromoperylene as the isomer mixture synthesized in Synthesis Example 1, 0.55 g of methyltrioctylammonium chloride (trade name: Aliquat^{R} 336, product of Aldrich Co.) and 64 mL of toluene. After heating to 100°C under a nitrogen atmosphere, 2.6 mg of bistriphenylphosphinepalladium dichloride was added. After then adding 10.36 g of 17.5 wt% aqueous sodium carbonate dropwise to the solution, the mixture was stirred for 3 hours. Next, 0.046 g of phenylboric acid, 1.3 mg of bistriphenylphosphinepalladium dichloride and 10.33 g of 17.5 wt% aqueous sodium carbonate were added, and the mixture was stirred at 100°C for 16 hours.

After removing the aqueous layer, 2.09 g of sodium N,N-diethyldithiocarbamate trihydrate and 43 mL of ion-exchanged water were added, and the mixture was stirred at 85°C for 2 hours. After separating the organic layer from the aqueous layer, the organic layer was rinsed with ion-exchanged water (3 times), 3 wt% aqueous acetic acid (3 times) and ion-exchanged water (3 times) in that order.

The organic layer was dropped into 600 mL of methanol to precipitate a polymer, and the precipitate was filtered and then dried to obtain a solid. The solid was dissolved in 120 mL of toluene, and the solution was passed through a silica gel/alumina column that had been previously passed through with toluene, the eluate was dropped into 700 mL of methanol to precipitate a polymer, and the precipitate was filtered and then dried. The yield of the precipitate (polymer compound C) was 2.16 g. The number-average molecular weight and weight-average molecular weight of polymer compound C based on polystyrene were Mn = 1.0 × 10⁵, Mw = 2.2 × 10⁵ respectively, and the glass transition temperature Tg of polymer compound C was 147°C.

### <Example 3>

A polymer (polymer compound D) comprising a constitutional unit represented by formula (A-1), a constitutional unit represented by formula (A-2) and a constitutional unit represented by formula (A-3) (the abundance ratio (molar ratio) of the 2 different constitutional units being approximately 50:50) and a constitutional unit represented by formula (A-4) in a molar ratio of 50:5:20:25 was synthesized.

To a 200 mL separable flask there were added 1.944 g (3.66 mmol) of 2,7-bis(1,3,2-dioxaborolan-2-yl)-9,9-dioctylfluorene, 1.200 g (1.83 mmol) of 9,9-bis(4-(2-ethoxy)ethoxyphenyl)-2,7-dibromofluorene, 0.169 g (0.37 mmol) of N,N-bis(4-bromophenyl)-N-(4-sec-butylphenyl)-amine, 0.602 g (1.46 mmol) of dibromoperylene as the isomer mixture synthesized in Synthesis Example 1, 0.54 g of methyltrioctylammonium chloride (trade name: Aliquat^{R} 336, product of Aldrich Co.) and 64 mL of toluene. After heating to 100°C under a nitrogen atmosphere, 2.6 mg of bistriphenylphosphinepalladium dichloride was added. After then adding 10.16 g of 17.5 wt% aqueous sodium carbonate dropwise to the solution, the mixture was stirred for 3 hours. Next, 0.045 g of phenylboric acid, 1.3 mg of bistriphenylphosphinepalladium dichloride and 10.01 g of 17.5 wt% aqueous sodium carbonate were added, and the mixture was stirred at 100°C for 17 hours.

After removing the aqueous layer, 2.04 g of sodium N,N-diethyldithiocarbamate trihydrate and 41 mL of ion-exchanged water were added, and the mixture was stirred at 85°C for 4 hours. After separating the organic layer from the aqueous layer, the organic layer was rinsed with ion-exchanged water (3 times), 3 wt% aqueous acetic acid (3 times) and ion-exchanged water (3 times) in that order.

The organic layer was dropped into 600 mL of methanol to precipitate a polymer, and the precipitate was filtered and then dried to obtain a solid. The solid was dissolved in 110 mL of toluene, and the solution was passed through a silica gel/alumina column that had been previously passed through with toluene, the eluate was dropped into 600 mL of methanol to precipitate a polymer, and the precipitate was filtered and then dried. The yield of the precipitate (polymer compound D) was 1.99 g. The number-average molecular weight and weight-average molecular weight of polymer compound D based on polystyrene were Mn = 1.5 × 10⁵ and Mw = 3.5 × 10⁵ respectively, and the glass transition temperature Tg of polymer compound D was 146°C.

### <Example 4>

A polymer (polymer compound E) comprising a constitutional unit represented by formula (A-1), a constitutional unit represented by formula (A-2), a constitutional unit represented by formula (A-3) (the abundance ratio (molar ratio) of the 2 different constitutional units being approximately 50:50) and a constitutional unit represented by formula (A-4) in a molar ratio of 50:5:1:44 was synthesized.

To a 200 mL separable flask there were added 1.983 g (3.73 mmol) of 2,7-bis(1,3,2-dioxaborolan-2-yl)-9,9-dioctylfluorene, 2.155 g (3.29 mmol) of 9,9-bis(4-(2-ethoxy)ethoxyphenyl)-2,7-dibromofluorene, 0.172 g (0.37 mmol) of N,N-bis(4-bromophenyl)-N-(4-sec-butylphenyl)-amine, 0.031 g (0.07 mmol) of dibromoperylene as the isomer mixture synthesized in Synthesis Example 1, 0.55 g of methyltrioctylammonium chloride (trade name: Aliquat^{R} 336, product of Aldrich Co.) and 75 mL of toluene. After heating to 100°C under a nitrogen atmosphere, 2.6 mg of bistriphenylphosphinepalladium dichloride was added. After then adding 10.30 g of 17.5 wt% aqueous sodium carbonate dropwise to the solution, the mixture was stirred for 3 hours. Next, 0.046 g of phenylboric acid, 1.3 mg of bistriphenylphosphinepalladium dichloride and 10.21 g of 17.5 wt% aqueous sodium carbonate were added, and the mixture was stirred at 100°C for 16.5 hours.

After removing the aqueous layer, 2.07 g of sodium N,N-diethyldithiocarbamate trihydrate and 42 mL of ion-exchanged water were added, and the mixture was stirred at 85°C for 3 hours. After separating the organic layer from the aqueous layer, the organic layer was rinsed with ion-exchanged water (2 times), 3 wt% aqueous acetic acid (2 times) and ion-exchanged water (2 times) in that order.

The organic layer was dropped into 700 mL of methanol to precipitate a polymer, and the precipitate was filtered and then dried to obtain a solid. The solid was dissolved in 120 mL of toluene, and the solution was passed through a silica gel/alumina column that had been previously passed through with toluene, the eluate that passed through was dropped into 700 mL of methanol to precipitate a polymer, and the precipitate was filtered and then dried. The yield of the precipitate (polymer compound E) was 2.16 g. The number-average molecular weight and weight-average molecular weight of polymer compound E based on polystyrene were Mn = 1.2 × 10⁵ and Mw = 2.7 × 10⁵ respectively, and the glass transition temperature Tg of polymer compound E was 123°C.

### <Example 5>

### [Fabrication of light emitting device with polymer compound C (device structure (h))]

A solution of poly(ethylenedioxythiophene)/polystyrenesulfonic acid (CLEVIOS P by H.C. Starck) was used for film formation by spin coating to approximately 65 nm on a glass panel which had an ITO film with a thickness of 45 nm formed thereon by sputtering, and the film was dried for 10 minutes at 200°C on a hot plate. The polymer compound A was dissolved in xylene (electronic industry (EL grade), by Kanto Kagaku Co., Ltd.) to a concentration of 0.7 wt%. The obtained xylene solution was used for film formation of polymer compound A to a thickness of 20 nm on the aforementioned film by spin coating, and then the film was dried at 180°C for 60 minutes under a nitrogen atmosphere with an oxygen concentration and moisture concentration of no greater than 10 ppm (by weight). A 1.5 wt% xylene solution of polymer compound C was then prepared. The xylene solution was used for film formation on polymer compound A film to a thickness of about 80 nm by spin coating, and then the film was dried at 130°C for 10 minutes under a nitrogen atmosphere with an oxygen concentration and moisture concentration of no greater than 10 ppm (by weight), to form a light emitting layer. After pressure reduction to below 1.0 × 10⁻⁴ Pa, vapor deposition was conducted with barium to approximately 5 nm on the light emitting layer and then aluminum to approximately 720 nm on the barium layer, as a cathode. After vapor deposition, it was sealed with a glass panel to produce an organic light emitting device. When a voltage of between 0 V and 12 V was applied to the obtained organic light emitting device using an OLED TEST SYSTEM by Tokyo Systems Development Co., Ltd. to induce luminescence of the device, and the brightness, luminous efficiency and chromaticity were measured, the brightness was 5000 cd/m² and the luminous efficiency was 3.16 cd/A with an applied voltage of 6 V The CIE chromaticity coordinates at a brightness of 1000 cd/m² were (0.373, 0.593), and yellow-green luminescence was displayed.

### <Example 6>

### [Fabrication of light emitting device with polymer compound D (device structure. (h))]

An organic light emitting device was fabricated in the same manner as Example 5, except that a 1.4 wt% xylene solution of polymer compound D was used instead of the 1.5 wt% xylene solution of polymer compound C. When the brightness, luminous efficiency and chromaticity of the obtained organic light emitting device were measured in the same manner as Example 5, the brightness was 5900 cd/m² and the luminous efficiency was 4.25 cd/A at an applied voltage of 6 V. The CIE chromaticity coordinates at a brightness of 1000 cd/m² were (0.358, 0.603), and yellow-green luminescence was displayed.

### <Example 7>

### [Fabrication of light emitting device with polymer compound E (device structure (h))]

An organic light emitting device was fabricated in the same manner as Example 5, except that a 1.5 wt% xylene solution of polymer compound E was used instead of the 1.5 wt% xylene solution of polymer compound C. When the brightness, luminous efficiency and chromaticity of the obtained organic light emitting device were measured in the same manner as Example 5, the brightness was 940 cd/m² and the luminous efficiency was 8.23 cd/A at an applied voltage of 6 V. The CIE chromaticity coordinates at a brightness of 1000 cd/M² were (0.247, 0.619), and yellow-green luminescence was displayed.

### <Comparative Example 1>

A polymer (polymer compound B) comprising a constitutional unit represented by formula (A-1) above and a constitutional unit represented by formula (A-3) above (the abundance ratio (molar ratio) of the 2 different constitutional units being approximately 50:50) in a molar ratio of 80:20 was synthesized.

To a 200 mL separable flask there were added 2.354 g (4.43 mmol) of 2,7-bis(1,3,2-dioxaborolan-2-yl)-9,9-dioctylfluorene, 1.505 g (2.66 mmol) of 9,9-dioctyl-2,7-dibromofluoxene, 0.729 g (1.77 mmol) of dibromoperylene as the isomer mixture synthesized in Synthesis Example 1, 0.65 g of methyltrioctylammonium chloride (trade name: Aliquat^{R} 336, product of Aldrich Co.) and 72 mL of toluene. After heating to 100°C under a nitrogen atmosphere, 3.1 mg of bistriphenylphosphinepalladium dichloride was added. After then adding 12.14 g of 17.5 wt% aqueous sodium carbonate dropwise to the solution, the mixture was stirred for 2 hours. Next, 0.055 g of phenylboric acid, 1.7 mg of bistriphenylphosphinepalladium dichloride and 12.15 g of 17.5 wt% aqueous sodium carbonate were added, and the mixture was stirred at 100°C for 17.5 hours.

After removing the aqueous layer, 2.46 g of sodium N,N-diethyldithiocarbamate trihydrate and 51 mL of ion-exchanged water were added, and the mixture was stirred at 85°C for 2 hours. After separating the organic layer from the aqueous layer, the organic layer was rinsed with ion-exchanged water (3 times), 3 wt% aqueous acetic acid (3 times) and ion-exchanged water (3 times) in that order.

The organic layer was dropped into 600 mL of methanol to precipitate a polymer, and the precipitate was filtered and then dried to obtain a solid. The solid was dissolved in 300 mL of toluene, and the solution was passed through a silica gel/alumina column that had been previously passed through with toluene, the eluate that passed through was dropped into 1500 mL of methanol to precipitate a polymer, and the precipitate was filtered and then dried. The yield of the precipitate (polymer compound B) was 2.73 g. The number-average molecular weight and weight-average molecular weight of polymer compound B based on polystyrene were Mn = 2.1 × 10⁵ and Mw = 5.8 × 10⁵, respectively. The glass transition temperature Tg of polymer compound B was 95°C.

### <Comparative Example 2>

A polymer (polymer compound F) comprising a constitutional unit represented by formula (A-1) above and a constitutional unit represented by formula (A-3) above (the abundance ratio (molar ratio) of the 2 different constitutional units being approximately 50:50) in a molar ratio of 99:1 was synthesized.

To a 200 mL separable flask there were added 1.780 g (3.357 mmol) of 2,7-bis(1,3,2-dioxaborolan-2-yl)-9,9-dioctylfluorene, 1.804 g (3.290 mmol) of 9,9-dioctyl-2,7-dibromofluorene, 0.028 g (0.067 mmol) of dibromoperylene as the isomer mixture synthesized in Synthesis Example 1, 0.50 g of methyltrioctylammonium chloride (trade name: Aliquat^{R} 336, product of Aldrich Co.) and 60 mL of toluene. A 2.4 mg portion of bistriphenylphosphinepalladium dichloride was added under a nitrogen atmosphere, and the mixture was heated. The solution was heated to 100°C while adding dropwise 9.2 mL of 17.5 wt% aqueous sodium carbonate, and the mixture was stirred for 5 hours. Next, 41.4 mg of phenylboric acid, 2.5 mg of bistriphenylphosphinepalladium dichloride and 9.2 mL of 17.5 wt% aqueous sodium carbonate were added, and the mixture was stirred at 100°C for 16.5 hours.

After removing the aqueous layer, 1.87 g of sodium N,N-diethyldithiocarbamate trihydrate and 37 mL of ion-exchanged water were added, and the mixture was stirred at 85°C for 2 hours. After separating the organic layer from the aqueous layer, the organic layer was rinsed with ion-exchanged water (2 times), 3 wt% aqueous acetic acid (2 times) and ion-exchanged water (2 times) in that order.

The organic layer was dropped into methanol to precipitate a polymer, and the precipitate was filtered and then dried to obtain a solid. The solid was dissolved in toluene and the solution was passed through a silica gel/alumina column that had been previously passed through with toluene, the eluate that passed through was dropped into methanol to precipitate a polymer, and the precipitate was filtered and then dried. The yield of the precipitate (polymer compound F) was 2.155 g. The number-average molecular weight and weight-average molecular weight of polymer compound F based on polystyrene were Mn = 4.7 × 10⁴ and Mw = 1.2 × 10⁵, respectively.

### <Comparative Example 3>

### [Fabrication of light emitting device with polymer compound B (device structure (h))]

An organic light emitting device was fabricated in the same manner as Example 5, except that a 1.1 wt% xylene solution of polymer compound B was used instead of the 1.5 wt% xylene solution of polymer compound C. When the brightness, luminous efficiency and chromaticity of the obtained organic light emitting device were measured in the same manner as Example 5, the brightness was 355 cd/m² and the luminous efficiency was 2.5 cd/A at an applied voltage of 6 V. The CIE chromaticity coordinates at a brightness of 1000 cd/m² were (0.384, 0.585), and yellow-green luminescence was displayed.

### <Comparative Example 4>

### [Fabrication of light emitting device with polymer compound F (device structure (h))]

An organic light emitting device was fabricated in the same manner as Example 5, except that a 1.6 wt% xylene solution of polymer compound F was used instead of the 1.5 wt% xylene solution of polymer compound C. When the brightness, luminous efficiency and chromaticity of the obtained organic light emitting device were measured in the same manner as Example 5, the brightness was 443 cd/m² and the luminous efficiency was 2.9 cd/A at an applied voltage of 6 V. The CIE chromaticity coordinates at a brightness of 1000 cd/m² were (0.294, 0.618), and yellow-green luminescence was displayed.

### <Example 8>

### [Fabrication of light emitting device with polymer compound C (device structure (e))]

A solution of poly(ethylenedioxythiophene)/polystyrenesulfonic acid (CLEVIOS P by H.C. Starck) was used for film formation by spin coating to approximately 65 nm on a glass panel which had an ITO film with a thickness of 45 nm formed thereon by sputtering, and the film was dried for 10 minutes at 200°C on a hot plate. The polymer compound C was dissolved in xylene (electronic industry (EL grade), by Kanto Kagaku Co., Ltd.) to a concentration of 1.5 wt%. The obtained xylene solution was used for film formation on the film to a thickness of about 80 nm by spin coating, and then the film was dried at 130°C for 10 minutes under a nitrogen atmosphere with an oxygen concentration and moisture concentration of no greater than 10 ppm (by weight), to form a light emitting layer. After pressure reduction to below 1.0 × 10⁻⁴ Pa, vapor deposition was conducted with barium to approximately 5 nm on the light emitting layer and then aluminum to approximately 720 nm on the barium layer, as a cathode. After vapor deposition, it was sealed with a glass panel to produce an organic light emitting device. When a voltage of between 0 V and 12 V was applied to the obtained organic light emitting device using an OLED TEST SYSTEM by Tokyo Systems Development Co., Ltd. to induce luminescence of the device, and the brightness, luminous efficiency and chromaticity were measured, the brightness was 6804 cd/m² and the luminous efficiency was 3.5 cd/A with an applied voltage of 6 V. The CIE chromaticity coordinates at a brightness of 1000 ed/m² were (0.348, 0.612), and yellow-green luminescence was displayed.

### <Example 9>

### [Fabrication of light emitting device with polymer compound D (device structure (e))]

An organic light emitting device was fabricated in the same manner as Example 8, except that a 1.4 wt% xylene solution of polymer compound D was used instead of the 1.5 wt% xylene solution of polymer compound C. When the brightness, luminous efficiency and chromaticity of the obtained organic light emitting device were measured in the same manner as Example 8, the brightness was 9343 cd/m² and the luminous efficiency was 5.5 cd/A at an applied voltage of 6 V. The CIE chromaticity coordinates at a brightness of 1000 cd/m² were (0.352, 0.609), and yellow-green luminescence was displayed.

### <Example 10>

### [Fabrication of light emitting device with polymer compound E (device structure (e))]

An organic light emitting device was fabricated in the same manner as Example 8, except that a 1.5 wt% xylene solution of polymer compound E was used instead of the 1.5 wt% xylene solution of polymer compound C. When the brightness, luminous efficiency and chromaticity of the obtained organic light emitting device were measured in the same manner as Example 8, the brightness was 893 cd/m² and the luminous efficiency was 8.9 cd/A at an applied voltage of 6 V. The CIE chromaticity coordinates at a brightness of 1000 cd/m² were (0.242, 0.618), and yellow-green luminescence was displayed.

### <Comparative Example 5>

### [Fabrication of light emitting device with polymer compound B (device structure (e))]

An organic light emitting device was fabricated in the same manner as Example 8, except that a 1.1 wt% xylene solution of polymer compound B was used instead of the 1.5 wt% xylene solution of polymer compound C. When the brightness, luminous efficiency and chromaticity of the obtained organic light emitting device were measured in the same manner as Example 8, the brightness was 712 cd/m² and the luminous efficiency was 0.5 cd/A at an applied voltage of 6 V. The CIE chromaticity coordinates at a brightness of 1000 cd/m² were (0.381, 0.585), and yellow-green luminescence was displayed.

### <Comparative Example 6>

### [Fabrication of light emitting device with polymer compound F (device structure (e))]

An organic light emitting device was fabricated in the same manner as Example 8, except that a 1.6 wt% xylene solution of polymer compound F was used instead of the 1.5 wt% xylene solution of polymer compound C. When the brightness, luminous efficiency and chromaticity of the obtained organic light emitting device were measured in the same manner as Example 8, the brightness was 737 cd/m² and the luminous efficiency was 1.6 cd/A at an applied voltage of 6 V. The CIE chromaticity coordinates at a brightness of 1000 cd/m² were (0.291, 0.617), and yellow-green luminescence was displayed.

### <Synthesis Example 4>

A polymer (polymer compound G) comprising a constitutional unit represented by formula (A-1) above and a constitutional unit represented by the following formula (A-5) in a molar ratio of 70:30 was synthesized.

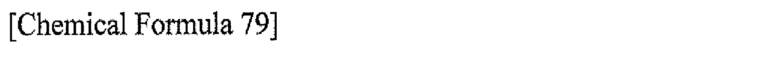

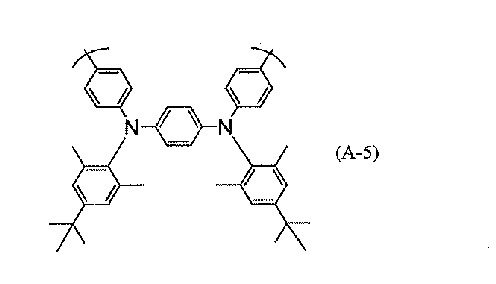

After charging 5.336 g (9.729 mmol) of 9,9-dioctyl-2,7-dibromofluorene, 3.080 g (4.170 mmol) of N,N'-bis(4-bromophenyl)-N,N'-bis(2,6-dimethyl-4-*tert*-butylphenyl)-1,4 -phenylenediamine, 5.861 g (37.527 mmol) of 2,2'-bipyridyl and 1000 ml of tetrahydrofuran (dehydrating solvent) into a reactor, the reaction system interior was exchanged with argon gas and the mixture was bubbled with argon gas for deaeration. Stirring was then initiated and the temperature was increased to 60°C. After adding 10.323 g (37.531 mmol) of bis(1,5-cyclooctadiene)nickel(0) to the mixture and increasing the temperature to 60°C, reaction was conducted at 60°C for 3.3 hours.

After the reaction, the solution was cooled to room temperature, a mixture of 25% ammonia water/methanol/ion-exchanged water was poured in, and the mixture was stirred. The produced precipitate was then filtered and recovered. After drying the precipitate, it was dissolved in toluene. The toluene solution was filtered and the insoluble portion was removed, and the toluene solution was subsequently passed through a column packed with alumina. The toluene solution that passed through was washed with 5.2 wt% hydrochloric acid, 4 wt% ammonia water and ion-exchanged water in that order. The toluene solution was dropped into methanol for reprecipitating purification, and the precipitate was filtered and then dried. The yield of the precipitate (polymer compound G) was 4.53 g. The number-average molecular weight and weight-average molecular weight of polymer compound G based on polystyrene were Mn = 8.7 × 10³ and Mw = 1.2 × 10⁵, respectively.

### <Example 11>

A polymer (polymer compound H) comprising a constitutional unit represented by formula (A-1) above, a constitutional unit represented by formula (A-2) above and a constitutional unit represented by formula (A-3) above (the abundance ratio (molar ratio) of the 2 different constitutional units being approximately 50:50) in a molar ratio of 94:5:1 was synthesized.

To a 200 mL separable flask there were added 2.350 g (3.657 mmol) of 2,7-bis(4,4,5,5-tetramethyl-1,3,2-dioxaborolan-2-yl)-9,9-dioctylfluorene , 1.765 g (3.219 mmol) of 9,9-dioctyl-2,7-dibromofluorene, 0.168 g (0.366 mmol) of N,N-bis(4-bromophenyl)-N-(4-*sec*-butylphenyl)-amine, 0.030 g (0.073 mmol) of the dibromoperylene synthesized in Synthesis Example 1 and 61 mL of toluene. The solution was heated under a nitrogen gas atmosphere, 2.6 mg of bistriphenylphosphinepalladium dichloride was added, and 12.4 mL of aqueous 20 wt% tetraethylammonium hydroxide was added dropwise at 100°C over a period of 60 minutes. The mixture was stirred at 100°C, 3.5 hours after starting dropwise addition of the base. To this mixture there were additionally added 45.1 mg of phenylboric acid, 2.7 mg of bistriphenylphosphinepalladium dichloride and 12.4 mL of aqueous 20 wt% tetraethylammonium hydroxide, and stirring was continued for 19 hours.

After removing the aqueous layer, 2.03 g of sodium N,N-diethyldithiocarbamate trihydrate and 41 mL of ion-exchanged water were added, and the mixture was stirred at 85°C for 3.5 hours. After separating the organic layer from the aqueous layer, the organic layer was rinsed with ion-exchanged water (2 times), 3 wt% aqueous acetic acid (2 times) and ion-exchanged water (2 times) in that order.

The organic layer was dropped into methanol to precipitate a polymer, and the precipitate was filtered and then dried to obtain a solid. The solid was dissolved in toluene and the solution was passed through a silica gel/alumina column that had been previously passed through with toluene, the eluate that passed through was dropped into methanol to precipitate a polymer, and the precipitate was filtered and then dried. The yield of the precipitate (polymer compound H) was 2.180 g. The number-average molecular weight and weight-average molecular weight of polymer compound H based on polystyrene were Mn = 2.2 × 10⁵ and Mw = 6.5 × 10⁵, respectively, and the glass transition temperature Tg was 79°C.

### <Example 12>

A polymer (polymer compound I) comprising a constitutional unit represented by formula (A-1) above, a constitutional unit represented by formula (A-3) above (the abundance ratio (molar ratio) of the 2 different constitutional units being approximately 50:50) and a constitutional unit represented by formula (A-5) above in a molar ratio of 94:1:5 was synthesized.

To a 200 mL separable flask there were added 2.267 g (3.529 mmol) of 2,7-bis(4,4,5,5-tetramethyl-1,3,2-dioxaborolan-2-yl)-9,9-dioctylfluorene , 1.703 g (3.105 mmol) of 9,9-dioctyl-2,7-dibromofluorene, 0.261 g (0.353 mmol) of N,N'-bis(4-bromophenyl)-N,N'-bis(2,6-dimethyl-4-tert-butylphenyl)-1,4 -phenylenediamine, 0.029 g (0.071 mmol) of dibromoperylene as the isomer mixture synthesized in Synthesis Example 1, and 61 mL of toluene. The solution was heated under a nitrogen gas atmosphere, 2.5 mg of bistriphenyl phosphine palladium dichloride was added, and 12 mL of aqueous 20 wt% tetraethylammonium hydroxide was added dropwise at 100°C over a period of 60 minutes. The mixture was stirred at 100°C, 4 hours after starting dropwise addition of the base. Next, there were further added 43.5 mg of phenylboric acid, 2.6 mg of bistriphenylphosphinepalladium dichloride and 12 mL of aqueous 20 wt% tetraethylammonium hydroxide, and stirring was continued for 19.5 hours.

After removing the aqueous layer, 1.96 g of sodium N,N-diethyldithiocarbamate trihydrate and 39 mL of ion-exchanged water were added, and the mixture was stirred at 85°C for 2.5 hours. After separating the organic layer from the aqueous layer, the organic layer was rinsed with ion-exchanged water (2 times), 3 wt% aqueous acetic acid (2 times) and ion-exchanged water (2 times) in that order.

The organic layer was dropped into methanol to precipitate a polymer, and the precipitate was filtered and then dried to obtain a solid. The solid was dissolved in toluene and the solution was passed through a silica gel/alumina column that had been previously passed through with toluene, the eluate that passed through was dropped into methanol to precipitate a polymer, and the precipitate was filtered and then dried. The yield of the precipitate (polymer compound I) was 2.578 g. The number-average molecular weight and weight-average molecular weight of polymer compound I based on polystyrene were Mn = 2.0 × 10⁵ and Mw = 6.4 × 10⁵, respectively, and the glass transition temperature Tg was 85°C.

### <Example 13>

A polymer (polymer compound J) comprising a constitutional unit represented by formula (A-1) above, a constitutional unit represented by formula (A-3) above (the abundance ratio (molar ratio) of the 2 different constitutional units being approximately 50:50) and a constitutional unit represented by the following formula (A-6) in a molar ratio of 94:1:5 was synthesized.

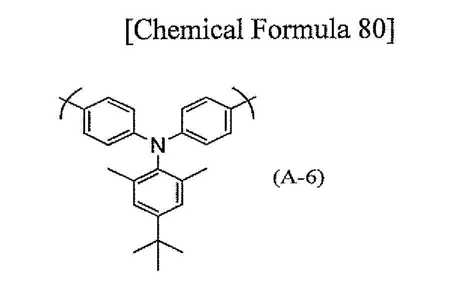

To a 200 mL separable flask there were added 2.342 g (3.644 mmol) of 2,7-bis(4,4,5,5-tetramethyl-1,3,2-dioxaborolan-2-yl)-9,9-dioctylfluorene , 1.759 g (3.207 mmol) of 9,9-dioctyl-2,7-dibromofluorene, 0.178 g (0.364 mmol) of N,N-bis(4-bromophenyl)-N-(2,6-dimethyl-4-*tert*-butylphenyl)-amine, 0.030 g (0.073 mmol) of dibromoperylene as the isomer mixture synthesized in Synthesis Example 1 and 61 mL of toluene. The solution was heated under a nitrogen gas atmosphere, 2.6 mg of bistriphenylphosphinepalladium dichloride was added, and 12.4 mL of aqueous 20 wt% tetraethylammonium hydroxide was added dropwise at 100°C over a period of 60 minutes. The mixture was stirred for at 100°C, 4.5 hours after starting dropwise addition of the base. Next, there were further added 44.9 mg of phenylboric acid, 2.6 mg of bistriphenylphosphinepalladium dichloride and 12.4 mL of aqueous 20 wt% tetraethylammonium hydroxide, and stirring was continued for 17.5 hours.

After removing the aqueous layer, 2.02 g of sodium N,N-diethyldithiocarbamate trihydrate and 40 mL of ion-exchanged water were added, and the mixture was stirred at 85°C for 2 hours. After separating the organic layer from the aqueous layer, the organic layer was rinsed with ion-exchanged water (2 times), 3 wt% aqueous acetic acid (2 times) and ion-exchanged water (2 times) in that order.

The organic layer was dropped into methanol to precipitate a polymer, and the precipitate was filtered and then dried to obtain a solid. The solid was dissolved in toluene and the solution was passed through a silica gel/alumina column that had been previously passed through with toluene, the eluate that passed through was dropped into methanol to precipitate a polymer, and the precipitate was filtered and then dried. The yield of the precipitate (polymer compound J) was 2.592 g. The number-average molecular weight and weight-average molecular weight of polymer compound J based on polystyrene were Mn = 2.2 × 10⁵ and Mw = 6.8 × 10⁵, respectively, and the glass transition temperature Tg was 83°C.

### <Example 14>

A polymer (polymer compound K) comprising a constitutional unit represented by formula (A-1) above, a constitutional unit represented by formula (A-2) above, a constitutional unit represented by formula (A-3) above (the abundance ratio (molar ratio) of the 2 different constitutional units being approximately 50:50), a constitutional unit represented by the following formula (A-7) and a constitutional unit represented by the following formula (A-8), in a molar ratio of 67:5:1:25:2, was synthesized.

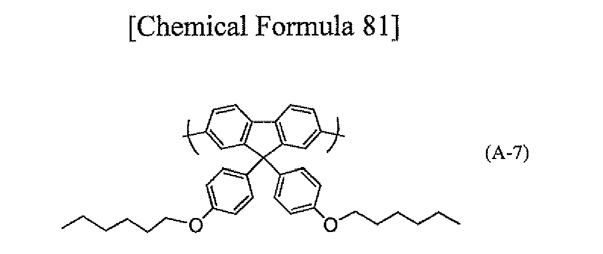

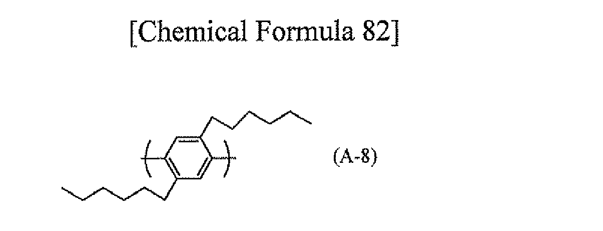

To a 200 mL separable flask there were added 1.803 g (3.399 mmol) of 2,7-bis(1,3,2-dioxaborolan-2-yl)-9,9-dioctylfluorene, 0.634 g (1.156 mmol) of 9,9-dioctyl-2,7-dibromofluorene, 1.150 g (1.699 mmol) of 9,9-bis(4-hexyloxyphenyl)-2,7-dibromofluorene, 0.156 g (0.340 mmol) of N,N-bis(4-bromophenyl)-N-(4-*sec*-butylphenyl)-amine, 0.055 g (0,136 mmol) of 1,4-dibromo-2,5-dihexylbenzene, 0.028 g (0.068 mmol) of dibromoperylene as the isomer mixture synthesized in Synthesis Example 1, 0.50 g of methyltrioctylammonium chloride (trade name: Aliquat^{R} 336, product of Aldrich Co.) and 65 mL of toluene. After further adding 1.1 mg of palladium acetate and 7.2 mg of tris(2-methoxyphenyl)phosphine under a nitrogen atmosphere, the mixture was heated. The solution was heated to 100°C while adding dropwise 9.3 mL of 17.5 wt% aqueous sodium carbonate, and the mixture was stirred for 4.5 hours. Next, 42.0 mg of phenylboric acid, 1.1 mg of palladium acetate, 7.1 mg of tris(2-methoxyphenyl)phosphine and 9.3 mL of 17.5 wt% aqueous sodium carbonate were added and the mixture was stirred at 100°C for 19 hours.

After removing the aqueous layer, 1.41 g of sodium N,N-diethyldithiocarbamate trihydrate and 28 mL of ion-exchanged water were added, and the mixture was stirred at 85°C for 2 hours. After separating the organic layer from the aqueous layer, the organic layer was rinsed with ion-exchanged water (2 times), 3 wt% aqueous acetic acid (2 times) and ion-exchanged water (2 times) in that order.

The organic layer was dropped into methanol to precipitate a polymer, and the precipitate was filtered and then dried to obtain a solid. The solid was dissolved in toluene and the solution was passed through a silica gel/alumina column that had been previously passed through with toluene, the eluate that passed through was dropped into methanol to precipitate a polymer, and the precipitate was filtered and then dried. The yield of the precipitate (polymer compound K) was 2.440 g. The number-average molecular weight and weight-average molecular weight of polymer compound K based on polystyrene were Mn =2.5 × 10⁵ and Mw =6.8 × 10⁵, respectively, and the glass transition temperature Tg was 103°C.

### <Example 15>

This is a synthesis example for a polymer (polymer compound L) comprising a constitutional unit represented by formula (A-1) above, a constitutional unit represented by formula (A-2) above and a constitutional unit represented by the following formula (A-9) (three-component mixture) in a molar ratio of 94.5:5:0.5.

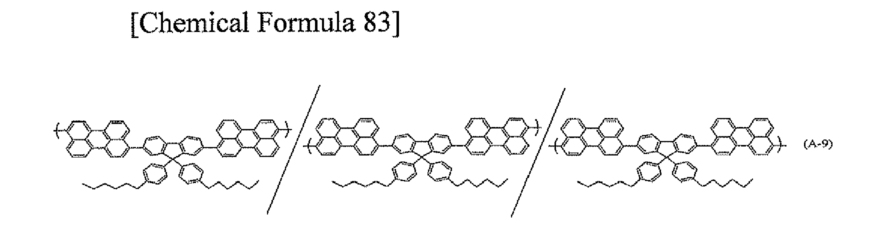

To a 200 mL separable flask there were added 2.324 g (3.616 mmol) of 2,7-bis(4,4,5,5-tetramethyl-1,3,2-dioxaborolan-2-yl)-9,9-dioctylfluorene , 1.765 g (3.218 mmol) of 9,9-dioctyl-2,7-dibromofluorene, 0.166 g (0.362 mmol) of N,N-bis(4-bromophenyl)-N-(4-*sec*-butylphenyl)-amine, 0.041 g (0.036 mmol) of compound MC as the three-component mixture synthesized in Example 1, and 61 mL of toluene. The solution was heated under a nitrogen gas atmosphere, and 2.5 mg of bistriphenylphosphinepalladium dichloride was added. Next, 12.3 mL of aqueous 20 wt% tetraethylammonium hydroxide was added dropwise at 100°C over a period of 60 minutes. The mixture was stirred for at 100°C, 4.5 hours after starting dropwise addition of the base. Next, there were further added 44.5 mg of phenylboric acid, 2.6 mg of bistriphenylphosphinepalladium dichloride and 12.3 mL of aqueous 20 wt% tetraethylammonium hydroxide, and stirring was continued for 19 hours.

After removing the aqueous layer, 2.01 g of sodium N,N-diethyldithiocarbamate trihydrate and 40 mL of ion-exchanged water were added, and the mixture was stirred at 85°C for 2.5 hours. After separating the organic layer from the aqueous layer, the organic layer was rinsed with ion-exchanged water (2 times), 3 wt% aqueous acetic acid (2 times) and ion-exchanged water (2 times) in that order.

The organic layer was dropped into methanol to precipitate a polymer, and the precipitate was filtered and then dried to obtain a solid. The solid was dissolved in toluene and the solution was passed through a silica gel/alumina column that had been previously passed through with toluene, the eluate that passed through was dropped into methanol to precipitate a polymer, and the precipitate was filtered and then dried. The yield of the precipitate (polymer compound L) was 2.604 g. The number-average molecular weight and weight-average molecular weight of polymer compound L based on polystyrene were Mn = 2.1 × 10⁵ and Mw = 6.7 × 10⁵, respectively, and the glass transition temperature Tg was 78°C.

### <Example 16>

### [Fabrication of light emitting device with polymer compound H (device structure (h))]

A solution of poly(ethylenedioxythiophene)/polystyrenesulfonic acid (CLEVIOS P by H.C. Starck) was used for film formation by spin coating to approximately 65 nm on a glass panel which had an ITO film with a thickness of 45 nm formed thereon by sputtering, and the film was dried for 10 minutes at 200°C on a hot plate. The polymer compound G was dissolved in xylene (electronic industry (EL grade), by Kanto Kagaku Co., Ltd.) to a concentration of 0.7 wt%. The obtained xylene solution was used for film formation of polymer compound G to a thickness of 20 nm on the aforementioned film by spin coating, and then the film was dried at 180°C for 60 minutes under a nitrogen atmosphere with an oxygen concentration and moisture concentration of no greater than 10 ppm (by weight). A 1.1 wt% xylene solution of polymer compound H was then prepared. The xylene solution was used for film formation on the polymer compound G film to a thickness of about 80 nm by spin coating, and then the film was dried at 130°C for 10 minutes under a nitrogen atmosphere with an oxygen concentration and moisture concentration of no greater than 10 ppm (by weight), to form a light emitting layer. After pressure reduction to below 1.0 × 10⁻⁴ Pa, vapor deposition was conducted with barium to approximately 5 nm on the light emitting layer and then aluminum to approximately 720 nm on the barium layer, as a cathode. After vapor deposition, it was sealed with a glass panel to produce an organic light emitting device. When a voltage of between 0 V and 12 V was applied to the obtained organic light emitting device using an OLED TEST SYSTEM by Tokyo Systems Development Co., Ltd. to induce luminescence of the device, and the brightness, luminous efficiency and chromaticity were measured, the brightness was 153 cd/m² and the luminous efficiency was 11.5 cd/A with an applied voltage of 6 V. At a brightness of 1000 cd/m², a luminous efficiency of 9.7 cd/A, a voltage of 8.1 V and CIE chromaticity coordinates of (0.259, 0.615) were exhibited, and green luminescence was displayed. The 70% brightness retention time was 110 hours, with an initial brightness of 3990 cd/m².

### <Example 17>

### [Fabrication of light emitting device with polymer compound I (device structure (h))]

An organic light emitting device was fabricated in the same manner as Example 16, except that a 1.1 wt% xylene solution of polymer compound I was used instead of the 1.1 wt% xylene solution of polymer compound H. When the brightness, luminous efficiency, voltage and chromaticity of the obtained organic light emitting device were measured in the same manner as Example 16, the brightness was 580 cd/m² and the luminous efficiency was 12.2 cd/A at an applied voltage of 6 V. At a brightness of 1000 cd/m², a luminous efficiency of 12.1 cd/A, a voltage of 6.6 V and CIE chromaticity coordinates of (0.247, 0.613) were exhibited, and green luminescence was displayed.

### <Example 18>

### [Fabrication of light emitting device with polymer compound J (device structure (h))]

An organic light emitting device was fabricated in the same manner as Example 16, except that a 1.0 wt% xylene solution of polymer compound J was used instead of the 1.1 wt% xylene solution of polymer compound H. When the brightness, luminous efficiency, voltage and chromaticity of the obtained organic light emitting device were measured in the same manner as Example 16, the brightness was 83 cd/M² and the luminous efficiency was 11.1 cd/A at an applied voltage of 6 V At a brightness of 1000 cd/m², a luminous efficiency of 8.8 cd/A, a voltage of 8.1 V and CIE chromaticity coordinates of (0.258, 0.615) were exhibited, and green luminescence was displayed.

### <Example 19>

### [Fabrication of light emitting device with polymer compound K (device structure (h))]

An organic light emitting device was fabricated in the same manner as Example 16, except that a 1.0 wt% xylene solution of polymer compound K was used instead of the 1.1 wt% xylene solution of polymer compound H. When the brightness, luminous efficiency, voltage and chromaticity of the obtained organic light emitting device were measured in the same manner as Example 16, the brightness was 98 cd/m² and the luminous efficiency was 11.2 cd/A at an applied voltage of 6 V At a brightness of 1000 cd/m², a luminous efficiency of 9.1 cd/A, a voltage of 8.9 V and CIE chromaticity coordinates of (0.248, 0.609) were exhibited, and green luminescence was displayed.

### <Example 20>

### [Fabrication of light emitting device with polymer compound L (device structure (h))]

An organic light emitting device was fabricated in the same manner as Example 16, except that a 1.1 wt% xylene solution of polymer compound L was used instead of the 1.1 wt% xylene solution of polymer compound H. When the brightness, luminous efficiency, voltage and chromaticity of the obtained organic light emitting device were measured in the same manner as Example 16, the brightness was 181 cd/m² and the luminous efficiency was 13.2 cd/A at an applied voltage of 6V. At a brightness of 1000 cd/m², a luminous efficiency of 11.5 cd/A, a voltage of 7.8 V and CIE chromaticity coordinates of (0.261, 0.619) were exhibited, and green luminescence was displayed. The 70% brightness retention time was 159 hours, with an initial brightness of 4000 cd/m².

As explained above, light emitting devices obtained using polymer compound C, polymer compound D, polymer compound E, polymer compound H, polymer compound I, polymer compound J, polymer compound K and polymer compound L all exhibited high luminous efficiency compared to optical devices obtained using polymer compound B and polymer compound F, which do not comprise at least one constitutional unit selected from the group consisting of constitutional units represented by formula (3) and constitutional units represented by formula (4). In other words, the polymer compounds of the invention have excellent properties as materials to be used in light emitting devices.

### Preference Signs List

1: Substrate, 2: organic semiconductor layer, 3: insulating layer, 4: gate electrode, 5: source electrode, 6: drain electrode, 20: substrate, 22: anode, 23: charge injection layer, 24: hole transporting layer, 25: light emitting layer, 26: electron transporting layer, 27: charge injection layer, 28: cathode, 30: substrate, 31: anode, 32: charge injection layer, 33: light emitting layer, 34: cathode, 35: protective layer, 100: organic film transistor, 120: organic film transistor, 200: light emitting device (device structure p), 210: light emitting device (device structure e), 220: light emitting device (device structure h), 300: surface light source.

## Claims

1. A polymer compound comprising:
a first constitutional unit represented by the following formula (1);
a second constitutional unit represented by the following formula (2); and
at least one constitutional unit selected from the group consisting of a third constitutional unit represented by the following formula (3) and a fourth constitutional unit represented by the following formula (4), 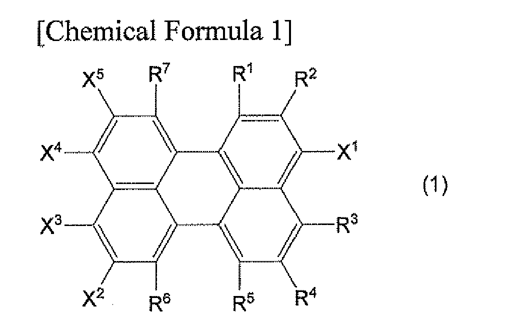 in formula (1),
R¹ R², R³, R⁴, R⁵, R⁶ and R⁷ each independently represent a hydrogen atom, an alkyl group, an aryl group, a monovalent aromatic heterocyclic group or a group represented by -O-R^{A},
X¹ represents a binding site to a constitutional unit composing the polymer compound, and
one of X², X³, X⁴ and X⁵ represents a binding site to a constitutional unit composing the polymer compound, while the other three each independently represent a hydrogen atom, an alkyl group, an aryl group, a monovalent aromatic heterocyclic group or a group represented by -O- R^{A};
R^{A} is an alkyl group, an aryl group, or a monovalent aromatic heterocyclic group, R¹, R², R³, R⁴, R⁵, R⁶, R⁷, X², X³, X⁴, X⁵ and R^{A} each may have a substituent, and when there are multiple R^{A} groups, the R^{A} groups may be the same or different; 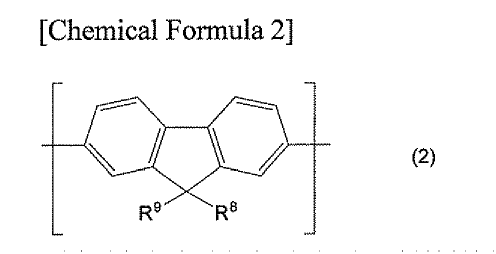 in formula (2), R⁸ and R⁹ each independently represent an alkyl group, an aryl group or a monovalent aromatic heterocyclic group, and these groups each may have a substituent; 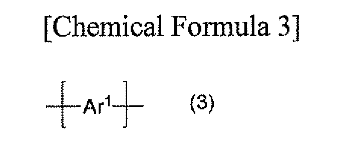 in formula (3):
Ar¹ represents an arylene group, a divalent aromatic heterocyclic group, or a divalent group in which are linked two or more identical or different groups selected from the group consisting of arylene groups and divalent aromatic heterocyclic groups;
Ar¹ may have one or more substituents selected from the group consisting of alkyl groups, aryl groups, monovalent aromatic heterocyclic groups, groups represented by -O-R^{A}, groups represented by -S-R^{A}, groups represented by -C(=O)-R^{A}, groups represented by -C(=O)-O-R^{A}, groups represented by -N(R^{A})₂*,* a cyano group and a fluorine atom,
R^{A} is as defined above, and when there are multiple R^{A} groups, the R^{A} groups may be the same or different; 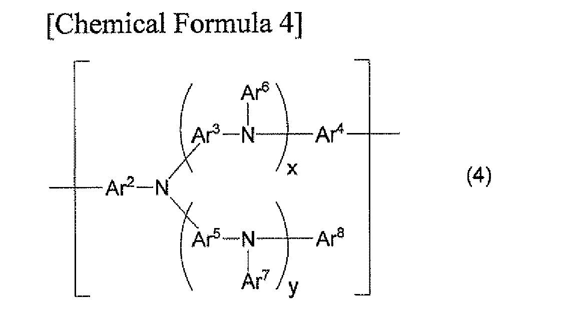 in formula (4):
x and y each independently represent 0 or 1,
Ar², Ar³, Ar⁴ and Ar⁵ each independently represent an arylene group, a divalent aromatic heterocyclic group, or a divalent group in which are linked two or more identical or different groups selected from the group consisting of arylene groups and divalent aromatic heterocyclic groups,
Ar⁶, Ar⁷ and Ar⁸ each independently represent an aryl group or a monovalent aromatic heterocyclic group, and
Ar², Ar³, Ar⁴, Ar⁵, Ar⁶, Ar⁷ and Ar⁸ each may have one or more substituents selected from the group consisting of alkyl groups, aryl groups, monovalent aromatic heterocyclic groups, groups represented by -O-R^{A}, groups represented by -S-R^{A}, groups represented by -C(=O)-R^{A}, groups represented by -C(=O)-O-R^{A}, groups represented by -N(RA)₂, a cyano group and a fluorine atom;
of the groups represented by Ar², Ar³, At⁴, Ar⁵, Ar⁶, Ar⁷ and Ar⁸, groups bonded to the same nitrogen atom may be bonded by a single bond, or by a group represented by -O-, -S-, -C(=O)-, -C(=O)-O-, -N(R^{A})-, -C(=O)-N(R^{A}) or -C(R^{A})(R^{A})-;
R^{A} is as defined above, and when there are multiple R^{A}, the R^{A} groups may be the same or different.

2. The polymer compound according to claim 1, wherein, in the first constitutional unit, X³ or X⁴ is the binding site to the constitutional unit composing the polymer compound.

3. The polymer compound according to claim 1 or 2, which comprises a constitutional sequence in which the first constitutional unit and the second constitutional unit are linked.

4. The polymer compound according to any one of claims 1 to 3, wherein the content of the first constitutional unit in the polymer compound is from 0.1 mol% to 20 mol% based on the total content of the first constitutional unit, the second constitutional unit, the third constitutional unit and the fourth constitutional unit.

5. The polymer compound according to any one of claims 1 to 4, wherein the total content of the first constitutional unit, the second constitutional unit, the third constitutional unit and the fourth constitutional unit in the polymer compound is 80 mass% or greater based on the total amount of the polymer compound.

6. The polymer compound according to any one of claims 1 to 5, wherein the polymer compound has a polystyrene-equivalent number-average molecular weight of from 1 × 10³ to 1 × 10⁸.

7. A method for producing the polymer compound according to any one of claims 1 to 6, comprising polymerizing at least three kinds of different monomers including a first monomer represented by the following formula (M-1) and a second monomer represented by the following formula (M-2), 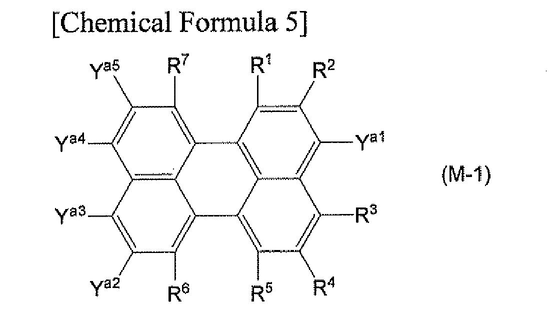 in formula (M-1):
R¹, R², R³, R⁴, R⁵, R⁶ and R⁷ each independently represent a hydrogen atom, an alkyl group, an aryl group, a monovalent aromatic heterocyclic group or a group represented by -O-R^{A},
Y^{a1} represents a first polymerizable group which is a group selected from the group consisting of the following substituent group A and the following substituent group B, and
one of Y^{a2}, Y^{a3}, Y^{a4} and Y^{a5} represents a second polymerizable group which is a group selected from the group consisting of the substituent group A and the substituent group B, while the other three each independently represent a hydrogen atom, an alkyl group, an aryl group, a monovalent aromatic heterocyclic group or a group represented by -O-R^{A};
R^{A} is an alkyl group, an aryl group or a monovalent aromatic heterocyclic group, R¹, R², R³, R⁴, R⁵, R⁶, R⁷, Y^{a2}, Y^{a3}, Y^{a4}, Y^{a5} and R^{A} each may have a substituent, and when there are multiple R^{A} groups, the R^{A} groups may be the same or different; 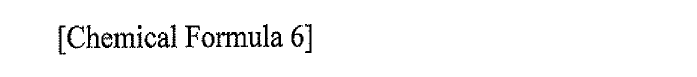 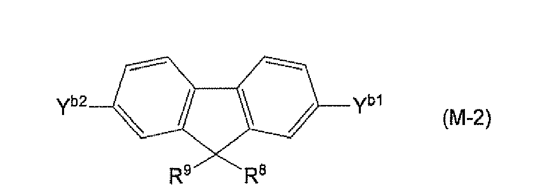 in formula (M-2), R⁸ and R⁹ each independently represent an alkyl group, an aryl group or a monovalent aromatic heterocyclic group, and these groups each may have a substituent,
Y^{b1} and Y^{b2} each independently represent a group selected from the group consisting of the substituent group A and the substituent group B,
when the first polymerizable group and the second polymerizable group in formula (M-1) are both groups selected from the substituent group A, at least one of Y^{b1} and Y^{b2} is a group selected from the substituent group B, and when the first polymerizable group and the second polymerizable group are both groups selected from the substituent group B, at least one of Y^{b1} and Y^{b2} is a group selected from the substituent group A,
(substituent group A)
a chlorine atom, a bromine atom, an iodine atom and groups represented by -O-S(=O)₂R²⁰, wherein R²⁰ represents an alkyl group, or an aryl group optionally substituted with an alkyl group, an alkoxy group, a nitro group, a fluorine atom or a cyano group,
(substituent group B)
groups represented by -B(OR²¹)_{2,} wherein R²¹ represents a hydrogen atom or an alkyl group, and the two R²¹ groups may be the same or different and may be bonded together to form a ring, groups represented by -BF₄Q¹, wherein Q¹ represents a monovalent cation of lithium, sodium, potassium, rubidium or cesium, groups represented by -Sn(R²²)₃, wherein R²² represents hydrogen or an alkyl group, and the three R²² groups may be the same or different and may be bonded together to form a ring, groups represented by -MgY¹, wherein Y¹ represents a chlorine atom, a bromine atom or an iodine atom, and groups represented by -ZnY², wherein Y² represents a chlorine atom, a bromine atom or an iodine atom.

8. A method for producing the polymer compound according to any one of claims 1 to 6, comprising polymerizing at least two kinds of monomers including a monomer represented by the following formula (M-5), 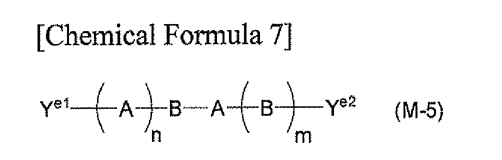 in formula (M-5), A represents a group represented by the following formula (m-1), B represents a group represented by the following formula (m-2), m and n each independently represent 0 or 1, and Y^{e1} and Y^{e2} each independently represent a group selected from the group consisting of the following substituent group A and the following substituent group B, 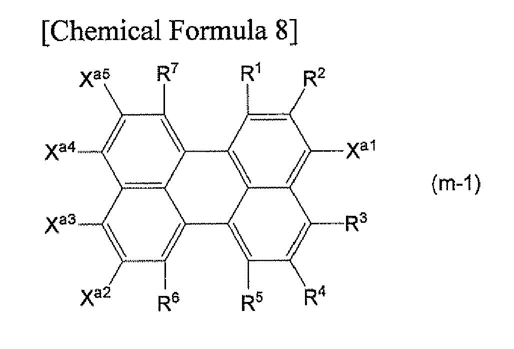 in formula (m-1),
R¹, R², R³, R⁴, R⁵, R⁶ and R⁷ each independently represent a hydrogen atom, an alkyl group, an aryl group, a monovalent aromatic heterocyclic group or a group represented by -O-R^{A},
X^{a1} represents a binding site to B, Y^{e1} or Y^{e2}, and
one of X^{a2}, X^{a3}, X^{a4} and X^{a5} represents a binding site to B, Y^{e1} or Y^{e2}, while the other three each independently represent a hydrogen atom, an alkyl group, an aryl group, a monovalent aromatic heterocyclic group or a group represented by -O-R^{A},
R^{A} is an alkyl group, an aryl group or a monovalent aromatic heterocyclic group, R¹, R², R³, R⁴, R⁵, R⁶, R⁷, X^{a2}, X^{a3}, X^{a4}, X^{a5} and R^{A} each may have a substituent, and when there are multiple R^{A} groups, the R^{A} groups may be the same or different; 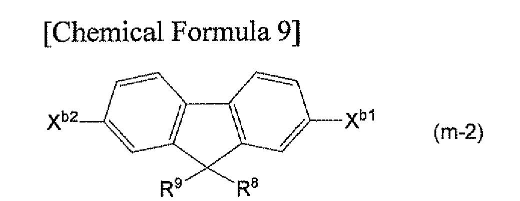 in formula (m-2), R⁸ and R⁹ each independently represent an alkyl group, an aryl group or a monovalent aromatic heterocyclic group, and these groups each may have a substituent, X^{b1} and X^{b2} each independently represent a binding site to A, Y^{e1} or Y^{e2},
(substituent group A)
a chlorine atom, a bromine atom, an iodine atom and groups represented by -O-S(=O)₂R²⁰, wherein R²⁰ represents an alkyl group, or an aryl group optionally substituted with an alkyl group, an alkoxy group, a nitro group, a fluorine atom or a cyano group,
(substituent group B)
groups represented by -B(OR²¹), wherein R²¹ represents a hydrogen atom or an alkyl group, and the two R²¹ groups may be the same or different and may be bonded together to form a ring, groups represented by -BF₄Q¹, wherein Q¹ represents a monovalent cation of lithium, sodium, potassium, rubidium or cesium, groups represented by -Sn(R²²)_{3,} wherein R² represents a hydrogen atom or an alkyl group, and the three R²² groups may be the same or different and may be bonded together to form a ring, groups represented by -MgY¹, wherein Y¹ represents chlorine, bromine or iodine, and groups represented by -ZnY², wherein Y² represents a chlorine atom, a bromine atom or an iodine atom.

9. A polymer composition comprising the polymer compound according to any one of claims 1 to 6, and at least one material selected from the group consisting of hole transporting materials, electron transporting materials and light emitting materials.

10. A solution comprising the polymer compound according to any one of claims 1 to 6.

11. A solution comprising the polymer composition according to claim 9.

12. An organic film comprising the polymer compound according to any one of claims 1 to 6.

13. An organic film comprising the polymer composition according to claim 9.

14. An organic semiconductor device comprising the organic film according to claim 12 or 13.

15. An organic light emitting device comprising the organic film according to claim 12 or 13.

16. A surface light source comprising the organic light emitting device according to claim 15.

17. A display device comprising the organic light emitting device according to claim 15.

18. A compound represented by the following formula (M-5), 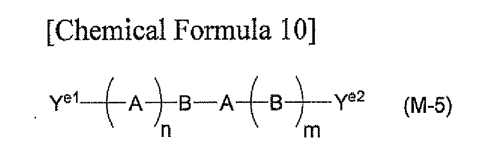 in formula (M-5), A represents a group represented by the following formula (m-1), B represents a group represented by the following formula (m-2), m and n each independently represent 0 or 1, and Y^{e1} and Y^{e2} each independently represent a group selected from the group consisting of the following substituent group A and the following substituent group B, 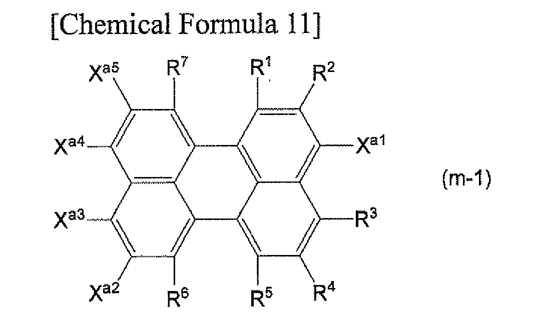 in formula (m-1),
R¹, R², R³, R⁴, R⁵, R⁶ and R⁷ each independently represent a hydrogen atom, an alkyl group, an aryl group, a monovalent aromatic heterocyclic group or a group represented by -O-R^{A},
X^{a1} represents a binding site to B, Y^{e1} or Y^{e2}, and
one of X^{a2}, X^{a3}, X^{a4} and X^{a5} represents a binding site to B, Y^{e1} or Y^{e2}, while the other three each independently represent a hydrogen atom, an alkyl group, an aryl group, a monovalent aromatic heterocyclic group or a group represented by -O-R^{A},
R^{A} is an alkyl group, an aryl group or monovalent aromatic heterocyclic group, R¹ R², R³, R⁴, R⁵, R⁶, R⁷, X^{a2}, X^{a3}, X^{a4}, X^{a5} and R^{A} each may have a substituent, and when there are multiple R^{A} groups, the R^{A} groups may be the same or different, 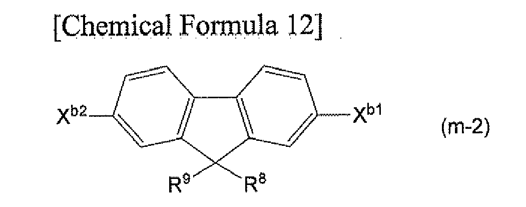 in formula (m-2), R⁸ and R⁹ each independently represent an alkyl group, an aryl group or a monovalent aromatic heterocyclic group, and these groups each may have a substituent, X^{b1} and X^{b2} each independently represent a binding site to A, Y^{e1} or Y^{e2},
(substituent group A)
a chlorine atom, a bromine atom, an iodine atom and groups represented by -O-S(=O)₂R²⁰, wherein R²⁰ represents an alkyl group, or an aryl group optionally substituted with an alkyl group, an alkoxy group, a nitro group, a fluorine atom or a cyano group,
(substituent group B)
groups represented by -B(OR²¹)₂, wherein R²¹ represents a hydrogen atom or an alkyl group, and the two R²¹ groups may be the same or different and may be bonded together to form a ring), groups represented by -BF₄Q¹, wherein Q¹ represents a monovalent cation of lithium, sodium, potassium, rubidium or cesium, groups represented by -Sn(R²²)₃, wherein R²² represents a hydrogen atom or an alkyl group, and the three R²² groups may be the same or different and may be bonded together to form a ring, groups represented by -MgY¹, wherein Y¹ represents a chlorine atom, a bromine atom or an iodine atom, and groups represented by -ZnY², wherein Y² represents a chlorine atom, a bromine atom or an iodine atom.
